# EUROPEAN PATENT SPECIFICATION

(11) **EP 3 492 982 B1**
(45) Date of publication and mention of the grant of the patent: **11.11.2020**
(21) Application number: 17836844.5
(22) Date of filing: 27.07.2017
(51) Int. Cl.: G03F 7/037, G03F 7/004, G03F 7/027, G03F 7/029, G03F 7/038

(54) **PHOTOSENSITIVE RESIN COMPOSITION, CURED FILM, LAMINATE, METHOD FOR PRODUCING CURED FILM, METHOD FOR PRODUCING LAMINATE, AND SEMICONDUCTOR DEVICE**
LICHTEMPFINDLICHE HARZZUSAMMENSETZUNG, GEHÄRTETE SCHICHT, LAMINAT, VERFAHREN ZUR HERSTELLUNG EINER GEHÄRTETEN SCHICHT, VERFAHREN ZUR HERSTELLUNG EINES LAMINATS UND HALBLEITERBAUELEMENT
COMPOSITION DE RÉSINE PHOTOSENSIBLE, FILM DURCI, STRATIFIÉ, PROCÉDÉ DE FABRICATION DE FILM DURCI, PROCÉDÉ DE FABRICATION DE STRATIFIÉ ET DISPOSITIF À SEMI-CONDUCTEUR

(30) Priority: 01.08.2016 JP 2016151553; 28.12.2016 JP 2016256607
(43) Date of publication of application: 05.06.2019
(73) Proprietor: FUJIFILM Corporation, Tokyo 106-8620 (JP)
(72) Inventor: IWAI Yu, Haibara-gun Shizuoka 421-0396 (JP); VANCLOOSTER Stefan, B-2070 Zwijndrecht (BE); JANSSEN Dimitri, B-2070 Zwijndrecht (BE); BAERT Kasper, B-2070 Zwijndrecht (BE)
(74) Representative: Hoffmann Eitle
(86) International application number: PCT/JP2017/027196
(87) International publication number: WO 2018/025738

(56) References cited:
- WO-A1-99/13381
- WO-A1-2015/199219
- WO-A1-2015/199219
- WO-A1-2017/002858
- WO-A1-2017/146152
- JP-A- S57 208 158
- JP-A- S60 121 740
- JP-A- 2000 112 124
- JP-A- 2004 091 572
- JP-A- 2006 201 670
- JP-A- 2011 191 749
- JP-A- 2016 027 357
- US-A1- 2013 168 829

## Description

### BACKGROUND OF THE INVENTION

### 1. Field of the Invention

The present invention relates to a photosensitive resin composition, a cured film, a laminate, a method for producing a cured film, a method for producing a laminate, and a semiconductor device.

### 2. Description of the Related Art

In the related art, a polyimide resin having excellent heat resistance in combination with electrical properties, mechanical properties, and the like is used for a protective film and an interlayer insulating film of a semiconductor element. However, in recent years, while high integration and miniaturization of semiconductor elements have been progressing, there has been a demand for thinning and miniaturization of sealed resin packages, and modes such as surface mounting using a lead-on-chip (LOC) or solder reflow method have been taken.

For manufacturing such semiconductor elements, a photosensitive polyimide resin composition in which photosensitivity is imparted to a polyimide resin itself has been used. This is because a pattern forming step can be simplified by using the photosensitive polyimide resin composition. For example, JP2008-083468A and JP2003-084435A disclose photosensitive resin compositions which contain a polyimide precursor having a predetermined structure, a photo-polymerization initiator, and a solvent.

JP2016-027357A describes a resin composition which allows a cyclization reaction of a heterocyclic ring-containing polymer precursor to be carried out at a low temperature. As photo-radical polymerization initiators, metallocenes are enumerated, and titanium compounds are also described.

WO 2015/199219 A1 relates to a thermal base generator that includes at least one selected from an acidic compound which generates a base in a case of being heated to 40°C or higher, and an ammonium salt containing an anion having a pKa1 of 0 to 4 and an ammonium cation. The acidic compound is preferably an ammonium salt and/or a compound represented by the following General Formula (1), in which A¹ represents a p-valent organic group, R¹ represents a monovalent organic group, L¹ represents an (m+1)-valent organic group, m represents an integer of 1 or more, and p represents an integer of 1 or more.

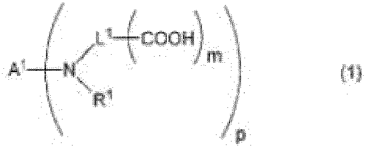

WO 99/13381 A1 relates to a negatively operating photoresist composition comprising: (a) a polyimide precursor containing repeating structural units of formula (I), the composition comprises in all as many structural units of formula (I), which have residues R, that the composition can be developed by means of aqueous-alkaline developers for photoresists, which are free of organic solvents.

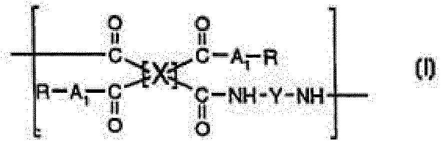

### SUMMARY OF THE INVENTION

Here, JP2008-083468A describes that the polyimide precursor (polyamide acid ester) described therein can be exposed to i-ray and a high imidization rate is imparted even in a case of being heated at 250°C. However, for imidization (ring closure), it is required that the ring closure can be made at a lower temperature.

On the other hand, JP2003-084435A describes that the negative tone photosensitive resin composition described therein is excellent in sensitivity, resolution, and heat resistance. However, it was shown that a cured film obtained by curing the negative tone photosensitive resin composition has a low glass transition temperature (Tg).

Furthermore, in JP2016-027357A, as photo-radical polymerization initiators, metallocene compounds are described and compounds containing titanium are also described. However, in a case of generating a base with a photo-base generator, the base generator itself needs to absorb light, and light does not reach an inner part, especially in a case where a thick film is formed, so that a crosslinking reaction tends to be insufficient. On the contrary, by using a thermal-base generator, it is possible to adopt a base generator which is not affected by an exposure wavelength. In addition, use of a titanium compound makes it possible to increase a Tg which tends to be decreased due to use of the thermal-base generator, and, in particular, such a use is advantageous for laminated re-distribution layer (RDL) applications (applications in which heating is repeatedly carried out for curing).

The present invention is made to solve such problems, and an object thereof is to provide a photosensitive resin composition which allows ring closure to be made with a high ring closure rate even at a low temperature and which causes a cured film obtained by curing the photosensitive resin composition to have a high Tg, and a cured film, a laminate, a method for producing the cured film, a method for producing the laminate, and a semiconductor device in which the photosensitive resin composition is used.

As a result of investigations made by the present inventors under the above-mentioned problems, it was found that the above problems can be solved by blending a heterocyclic ring-containing polymer precursor with an organic compound containing a Group 4 element. Specifically, the above problems have been solved by the following means <1>, and preferably <2> to <30>.
<1> A photosensitive resin composition, comprising:
   a heterocyclic ring-containing polymer precursor;
   a thermal-base generator;
   an organic compound containing a Group 4 element; and
   an oxime compound as a photo-radical polymerization initiator.
<2> The photosensitive resin composition according to <1>,
   in which the organic compound is an organic compound containing at least one selected from a titanium atom, a zirconium atom, or a hafnium atom,
   preferably the organic compound is an organic compound containing at least one selected from a titanium atom or a zirconium atom.
<3> The photosensitive resin composition according to any one of <1> or <2>,
   in which the heterocyclic ring-containing polymer precursor is a polyimide precursor or a polybenzoxazole precursor,
   preferably the heterocyclic ring-containing polymer precursor is a polyimide precursor.
<4> The photosensitive resin composition according to any one of <1> or <2>,
   in which the heterocyclic ring-containing polymer precursor contains a repeating unit represented by Formula (2), 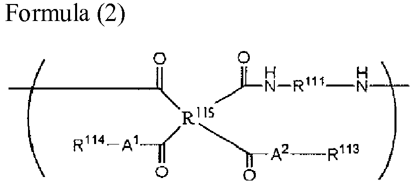 in Formula (2), A¹ and A² each independently represent an oxygen atom or NH, R¹¹¹ represents a divalent organic group, R¹¹⁵ represents a tetravalent organic group, and R¹¹³ and R¹¹⁴ each independently represent a hydrogen atom or a monovalent organic group.
<5> The photosensitive resin composition according to <4>,
   in which at least one of R¹¹³ or R¹¹⁴ in Formula (2) contains a radically polymerizable group.
<6> The photosensitive resin composition according to <4> or <5>,
   in which R¹¹⁵ in Formula (2) is a tetravalent organic group containing an aromatic ring.
<7> The photosensitive resin composition according to any one of <4> to <6>, in which R¹¹¹ in Formula (2) is represented by -Ar-L-Ar-, where Ar's each independently represent an aromatic group, and L is an aliphatic hydrocarbon group having 1 to 10 carbon atoms which may be substituted with a fluorine atom, -O-, -CO-, -S-, -SO₂-, or -NHCO-, or a group composed of a combination of two or more thereof.
<8> The photosensitive resin composition according to any one of <4> to <7>,
   in which R¹¹¹ in Formula (2) is a group represented by Formula (51) or Formula (61), 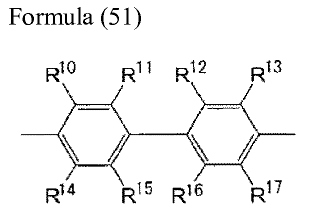 in Formula (51), R¹⁰ to R¹⁷ each independently represent a hydrogen atom, a fluorine atom, or a monovalent organic group, and at least one of R¹⁰, ..., or R¹⁷ represents a fluorine atom, a methyl group, a fluoromethyl group, a difluoromethyl group, or a trifluoromethyl group, 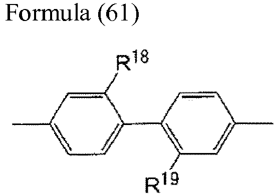 in Formula (61), R¹⁸ and R¹⁹ each independently represent a fluorine atom, a fluoromethyl group, a difluoromethyl group, or a trifluoromethyl group.
<9> The photosensitive resin composition according to any one of <1> to <8>,
   in which the thermal-base generator has an ammonium structure represented by Formula (101) or Formula (102), 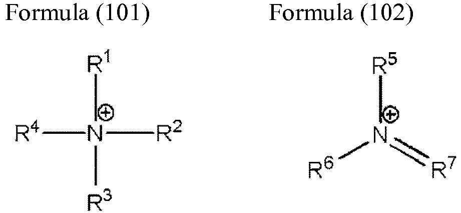 in Formulas (101) and (102), R¹ to R⁶ each independently represent a hydrogen atom or a hydrocarbon group, and R⁷ represents a hydrocarbon group; and R¹ and R², R³ and R⁴, R⁵ and R⁶, or R⁵ and R⁷ in Formulas (101) and (102) may be bonded to each other to form a ring.
<10> The photosensitive resin composition according to anyone of <1> to <9>,
   in which the organic compound is selected from a titanocene compound, a tetraalkoxytitanium compound, a titanium acylate compound, a titanium chelate compound, a zirconocene compound, and a hafnocene compound,
   preferably the organic compound is selected from a titanocene compound, a zirconocene compound, and a hafnocene compound,
   more preferably the organic compound is selected from a titanocene compound and a zirconocene compound.
<11> The photosensitive resin composition according to any one of <1> to <10>, further comprising at least one compound selected from the group consisting of a radically polymerizable compound and a solvent.
<12> Use of the photosensitive resin composition according to any one of <1> to <11> for negative tone development.
<13> Use of the photosensitive resin composition according to any one of <1> to <11> for forming an interlayer insulating film for a re-distribution layer.
<14> A cured film obtained by curing the photosensitive resin composition according to anyone of <1> to <11>.
<15> A laminate which has two or more layers of the cured film according to <14>.
<16> The laminate according to <15>, which has a metal layer between the cured films.
<17> A method for producing a cured film, comprising:
   using the photosensitive resin composition according to any one of <1> to <11>.
<18> The method for producing a cured film according to <17>, comprising:
   a photosensitive resin composition layer forming step of applying the photosensitive resin composition to a substrate to form a layered shape,
   an exposure step of exposing the photosensitive resin composition layer, and
   a step of subjecting the exposed photosensitive resin composition layer to a development treatment.
<19> The method for producing a cured film according to <18>,
   in which the development treatment is a negative tone development treatment.
<20> The method for producing a cured film according to <18> or <19>, further comprising a step of heating the developed photosensitive resin composition layer at a temperature of 50°C to 450°C, preferably 50°C to 250°C, after the development treatment step.
<21> The method for producing a cured film according to any one of <17> to <20>,
   in which the cured film has a film thickness of 1 to 30 µm.
<22> A method of producing a laminate, comprising:
   forming a cured film in accordance with the method for producing a cured film according to any one of <18> to <21>; and then
   further performing the photosensitive resin composition layer forming step, the exposure step, and the development treatment step, in this order, 2 to 5 times.
<23> A semiconductor device, comprising:
   the cured film according to <14>, or the laminate according to <15> or <16>.

According to the present invention, it is possible to provide a photosensitive resin composition which allows ring closure to be made with a high ring closure rate even at a low temperature and which causes a cured film obtained by curing the photosensitive resin composition to have a high glass transition temperature (Tg), and a cured film, a laminate, a method for producing the cured film, a method for producing the laminate, and a semiconductor device in which the photosensitive resin composition is used.

### BRIEF DESCRIPTION OF THE DRAWING

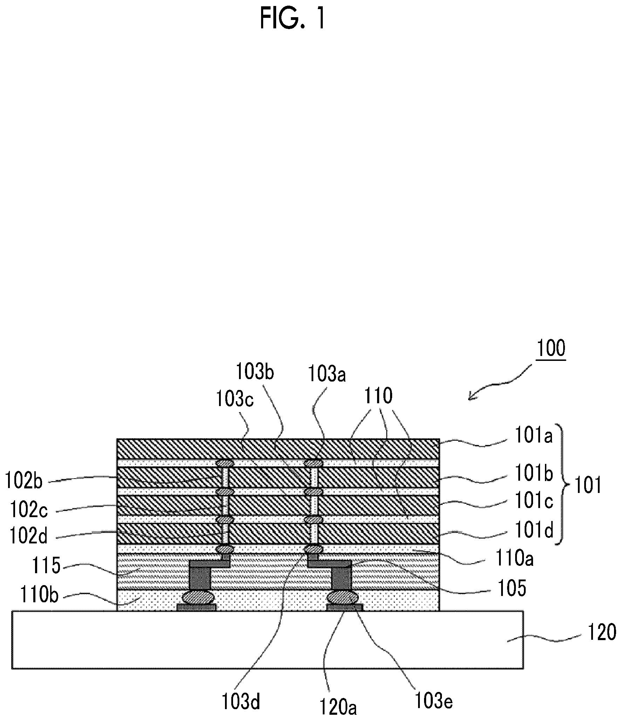

Fig. 1 is a schematic diagram showing a configuration of an embodiment of a semiconductor device.

### DESCRIPTION OF THE PREFERRED EMBODIMENTS

The following description of constituent elements in the present invention may be made based on representative embodiments of the present invention. However, the present invention is not limited to such embodiments.

In describing a group (atomic group) in the present specification, a description having no indication about substitution and non-substitution includes a description having a substituent as well as a description having no substituent. For example, "alkyl group" includes not only an alkyl group (unsubstituted alkyl group) having no substituent but also an alkyl group (substituted alkyl group) having a substituent.

In the present specification, unless otherwise specified, "exposure" includes not only exposure using light but also lithography with particle beams such as electron beams and ion beams. In addition, as light used for exposure, generally, actinic rays or radiations such as a bright line spectrum of a mercury lamp, far ultraviolet rays typified by excimer laser, extreme ultraviolet rays (EUV light), X-rays, and electron beams are mentioned.

In the present specification, a numerical range expressed using "to" means a range including numerical values described before and after the preposition "to" as a lower limit value and an upper limit value.

In the present specification, "(meth)acrylate" represents either or both of "acrylate" and "methacrylate", "(meth)acryl" means either or both of "acryl" and "methacryl", and "(meth)acryloyl" represents either or both of "acryloyl" and "methacryloyl".

In the present specification, the term "step" not only includes an independent step, but also steps in a case where an intended action of the step is achieved even though it is not possible to make a clear distinction from the other step.

In the present specification, a concentration of solid contents is a mass percentage of other components excluding a solvent with respect to a total mass of a composition. In addition, the concentration of solid contents refers to a concentration at 25°C unless otherwise stated.

In the present specification, unless otherwise stated, weight-average molecular weight (Mw) and number-average molecular weight (Mn) are defined as polystyrene equivalent values according to gel permeation chromatography (GPC measurement). In the present specification, the weight-average molecular weight (Mw) and the number-average molecular weight (Mn) can be obtained, for example, by using HLC-8220GPC (manufactured by Tosoh Corporation) and using, as a column, GUARD COLUMN HZ-L, TSKgel Super HZM-M, TSK gel Super HZ4000, TSK gel Super HZ3000, TSK gel Super HZ2000 (manufactured by Tosoh Corporation). Unless otherwise stated, measurement is performed using tetrahydrofuran (THF) as an eluent. In addition, unless otherwise stated, detection is made using a detector having an ultraviolet ray (UV ray) wavelength of 254 nm.

### <Photosensitive resin composition>

The photosensitive resin composition of the present invention (hereinafter referred to as "composition of the present invention" in some cases) is characterized by containing a heterocyclic ring-containing polymer precursor, a thermal-base generator, and an organic compound containing a Group 4 element. By using the thermal-base generator and the organic compound containing a Group 4 element in combination, it becomes possible to allow ring closure for the heterocyclic ring-containing polymer precursor to be made with a high ring closure rate at a low temperature (for example, 200°C), and it becomes possible to form a cured film (resin layer) having a high Tg. Furthermore, since the thermal-base generator hardly consumes an exposure energy, exposure latitude can also be improved.

In particular, at the time of using a photo-base generator, in a case where a photosensitive resin composition is made into a thick layer, light does not reach a surface opposite to a surface irradiated with light, or in a case where an exposure wavelength does not coincide with an absorption maximum wavelength of the photo-base generator or like, a crosslinking reaction tends to be insufficient. In the present invention, by using a thermal-base generator, it is possible to cause a crosslinking reaction to proceed sufficiently irrespective of a thickness of a photosensitive resin composition layer and an exposure wavelength. In addition, in a case where a thermal-base generator is used, a glass transition temperature of the obtained cured film tends to be decreased. However, in the present invention, by using an organic compound containing a Group 4 element, it is possible to maintain a high Tg of the obtained cured film. Therefore, even in a case of being used for laminated RDL applications in which a thermal curing is repeatedly carried out, it is possible to appropriately form the laminated RDL.

Hereinafter, these components will be described in detail.

### «Heterocyclic ring-containing polymer precursor»

The photosensitive resin composition of the present invention contains at least one type of heterocyclic ring-containing polymer precursor. As the heterocyclic ring-containing polymer precursor, a polyimide precursor or a polybenzoxazole precursor is preferably contained, and a polyimide precursor is more preferably contained.

### <<<Polyimide precursor>>>

A type and the like of the polyimide precursor used in the present invention are not particularly specified, and it is preferable to contain a repeating unit represented by Formula (2).

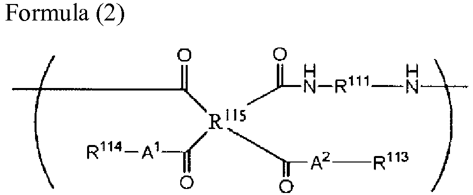

In Formula (2), A¹ and A² each independently represent an oxygen atom or NH, R¹¹¹ represents a divalent organic group, R¹¹⁵ represents a tetravalent organic group, and R¹¹³ and R¹¹⁴ each independently represent a hydrogen atom or a monovalent organic group.

In Formula (2), A¹ and A² are preferably an oxygen atom or NH, and more preferably an oxygen atom.

R¹¹¹ in Formula (2) represents a divalent organic group. AS the divalent organic group, a linear or branched aliphatic group, a cyclic aliphatic group, and a group containing an aromatic group are exemplified. The divalent organic group is preferably a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group composed of a combination thereof, and is more preferably a group composed of an aromatic group having 6 to 20 carbon atoms.

R¹¹¹ is preferably derived from diamine. As the diamine used for producing the polyimide precursor, linear or branched aliphatic, cyclic aliphatic, or aromatic diamine, or the like is mentioned. For the diamine, only one type may be used, or two or more types may be used.

Specifically, diamine containing a linear or branched aliphatic group having 2 to 20 carbon atoms, a cyclic aliphatic group having 3 to 20 carbon atoms, an aromatic group having 6 to 20 carbon atoms, or a group composed of a combination thereof is preferable, and diamine containing a group composed of an aromatic group having 6 to 20 carbon atoms is more preferable. Examples of the aromatic group include the following.

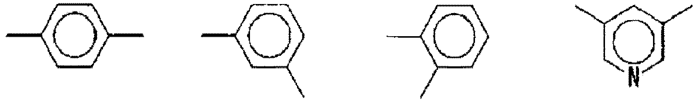

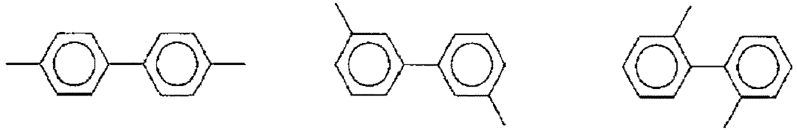

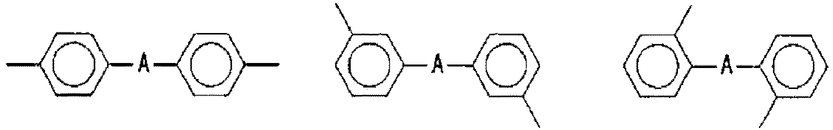

In the formulas, A is preferably a single bond, or a group selected from an aliphatic hydrocarbon group having 1 to 10 carbon atoms which may be substituted with a fluorine atom, -O-, -C(=O)-, -S-, -S(=O)₂-, -NHCO-, and a combination thereof, more preferably a single bond, or a group selected from an alkylene group having 1 to 3 carbon atoms which may be substituted with a fluorine atom, -O-, -C(=O)-, -S-, and -SO₂-, and even more preferably a divalent group selected from the group consisting of -CH₂-, -O-, -S-, -SO₂-, -C(CF₃)₂-, and -C(CH₃)₂-.

As the diamine, specifically, at least one diamine selected from 1,2-diaminoethane, 1,2-diaminopropane, 1,3-diaminopropane, 1,4-diaminobutane, and 1,6-diaminohexane; 1,2- or 1,3-diaminocyclopentane, 1,2-, 1,3-, or 1,4-diaminocyclohexane, 1,2-, 1,3-, or 1,4-bis(aminomethyl)cyclohexane, bis-(4-aminocyclohexyl)methane, bis-(3-aminocyclohexyl)methane, 4,4'-diamino-3,3'-dimethylcyclohexylmethane, and isophorone diamine; meta- and paraphenylene diamine, diaminotoluene, 4,4'- and 3,3'-diaminobiphenyl, 4,4'-diaminodiphenyl ether, 3,3-diaminodiphenyl ether, 4,4'- and 3,3'-diaminodiphenylmethane, 4,4'- and 3,3'-diaminodiphenyl sulfone, 4,4'- and 3,3'-diaminodiphenyl sulfide, 4,4'- and 3,3'-diaminobenzophenone, 3,3'-dimethyl-4,4'-diaminobiphenyl, 2,2'-dimethyl-4,4'-diaminobiphenyl, 3,3'-dimethoxy-4,4'-diaminobiphenyl, 2,2-bis(4-aminophenyl)propane, 2,2-bis(4-aminophenyl)hexafluoropropane, 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl) hexafluoropropane, bis(3-amino-4-hydroxyphenyl)sulfone, bis(4-amino-3-hydroxyphenyl)sulfone, 4,4'-diaminoparaterphenyl, 4,4-bis[4-aminophenoxy]biphenyl, bis[4-(4-aminophenoxy)phenyl]sulfone, bis[4-(3-aminophenoxy)phenyl]sulfone, bis[4-(2-aminophenoxy)phenyl]sulfone, 1,4-bis(4-aminophenoxy)benzene, 9,10-bis(4-aminophenyl)anthracene, 3,3'-dimethyl-4,4'-diaminodiphenyl sulfone, 1,3-bis(4-aminophenoxy)benzene, 1,3-bis(3-aminophenoxy)benzene, 1,3-bis(4-aminophenoxy)benzene, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy)phenyl]propane, 2,2-bis[4-(4-aminophenoxy)phenyl]hexafluoropropane, 9,9-bis(4-aminophenyl)-10-hydroanthracene, 3,3',4,4'-tetraaminobiphenyl, 3,3',4,4'-tetraaminodiphenyl ether, 1,4-diaminoanthraquinone, 1,5-diaminoanthraquinone, 3,3-dihydroxy-4,4'-diaminobiphenyl, 9,9'-bis(4-aminophenyl)fluorene, 4,4'-dimethyl-3,3'-diaminodiphenyl sulfone, 3,3',5,5'-tetramethyl-4,4'-diaminodiphenylmethane, 2,4- and 2,5-diaminocumene, 2,5-dimethyl-paraphenylene diamine, acetoguanamine, 2,3,5,6-tetramethyl-paraphenylene diamine, 2,4,6-trimethyl-metaphenylene diamine, bis(3-aminopropyl)tetramethyldisiloxane, 2,7-diaminofluorene, 2,5-diaminopyridine, 1,2-bis(4-aminophenyl)ethane, diaminobenzanilide, esters of diaminobenzoic acid, 1,5-diaminonaphthalene, diaminobenzotrifluoride, 1,3-bis(4-aminophenyl)hexafluoropropane, 1,4-bis(4-aminophenyl)octafluorobutane, 1,5-bis(4-aminophenyl)decafluoropentane, 1,7-bis(4-aminophenyl)tetradecafluoroheptane, 2,2-bis[4-(3-aminophenoxy)phenyl]hexafluoropropane, 2,2-bis[4-(2-aminophenoxy)phenyl]hexafluoropropane, 2,2-bis[4-(4-aminophenoxy)-3,5-dimethylphenyl]hexafluoropropane, 2,2-bis[4-(4-amino phenoxy)-3,5 -bis(trifluoromethyl)phenyl] hexafluoropropane, parabis(4-amino-2-trifluoromethylphenoxy)benzene, 4,4'-bis(4-amino-2-trifluoromethylphenoxy)biphenyl, 4,4'-bis(4-amino-3-trifluoromethylphenoxy)biphenyl, 4,4'-bis(4-amino-2-trifluoromethylphenoxy)diphenyl sulfone, 4,4'-bis(3-amino-5-trifluoromethylphenoxy)diphenyl sulfone, 2,2-bis[4-(4-amino-3-trifluoromethylphenoxy)phenyl]hexafluoropropane, 3,3',5,5'-tetramethyl-4,4'-diaminobiphenyl, 4,4'-diamino-2,2'-bis(trifluoromethyl)biphenyl, 2,2',5,5',6,6'-hexafluorotolidine, and 4,4'-diaminoquaterphenyl is mentioned.

In addition, diamines (DA-1) to (DA-18) as shown below are also preferable.

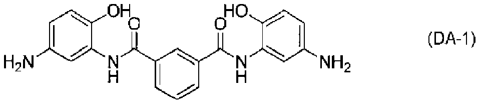

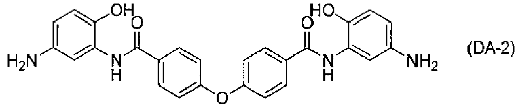

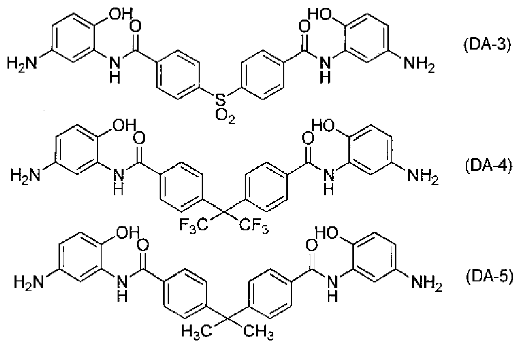

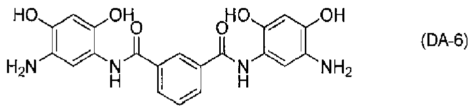

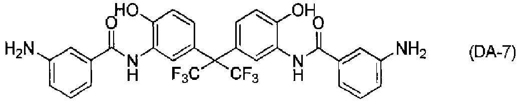

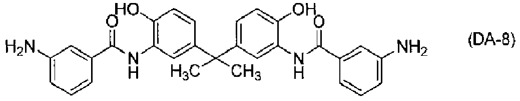

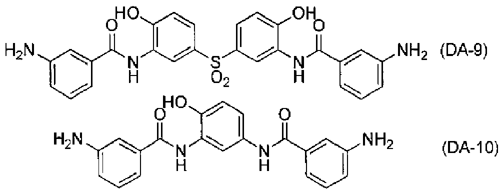

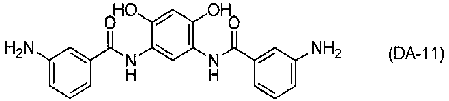

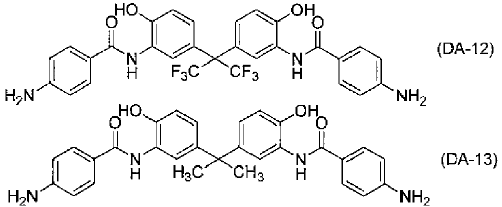

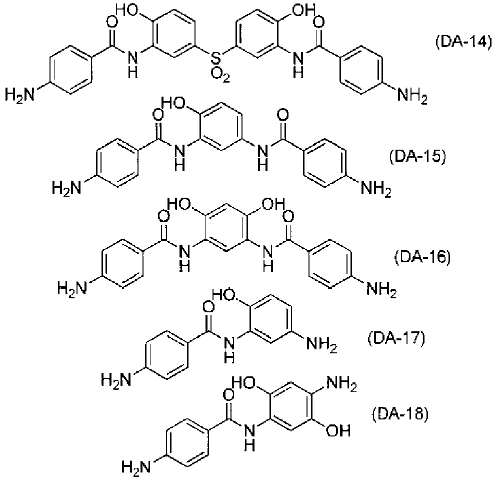

In addition, as preferable examples of the diamine, diamines having at least two alkylene glycol units in a main chain are also mentioned. Diamines containing two or more in total of either or both of ethylene glycol chain and propylene glycol chain in one molecule are preferable, and diamines containing no aromatic ring are more preferable. As specific examples thereof, JEFFAMINE (registered trademark) KH-511, JEFFAMINE (registered trademark) ED-600, JEFFAMINE (registered trademark) ED-900, JEFFAMINE (registered trademark) ED-2003, JEFFAMINE (registered trademark) EDR-148, JEFFAMINE (registered trademark) EDR-176, D-200, D-400, D-2000, D-4000 (all trade names, manufactured by Huntsman Corporation), 1-(2-(2-(2-aminopropoxy)ethoxy)propoxy)propane-2-amino, and 1-(1-(1-(2-aminopropoxy)propan-2-yl)oxy)propane-2-amine are mentioned, but not limited thereto.

Structures of JEFFAMINE (registered trademark) KH-511, JEFFAMINE (registered trademark) ED-600, JEFFAMINE (registered trademark) ED-900, JEFFAMINE (registered trademark) ED-2003, JEFFAMINE (registered trademark) EDR-148, and JEFFAMINE (registered trademark) EDR-176 are shown below.

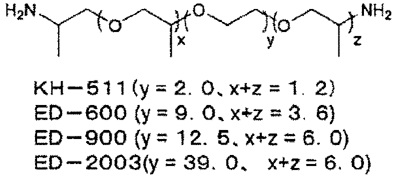

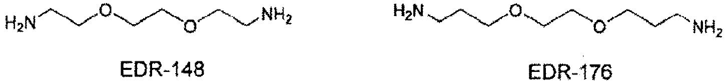

In the above, x, y, z are average values.

From the viewpoint of flexibility of the resulting cured film, R¹¹¹ is preferably represented by -Ar-L-Ar-, where Ar's each independently represent an aromatic group, and L represents an aliphatic hydrocarbon group having 1 to 10 carbon atoms which may be substituted with a fluorine atom, -O-, -CO-, -S-, -SO₂-, or -NHCO-, or a group composed of a combination of two or more thereof. Ar is preferably a phenylene group, and L is more preferably an aliphatic hydrocarbon group having 1 or 2 carbon atoms which may be substituted with a fluorine atom, -O-, -CO-, -S-, or -SO₂-. The aliphatic hydrocarbon group herein is preferably an alkylene group.

From the viewpoint of i-ray transmittance, R¹¹¹ is preferably a divalent organic group represented by Formula (51) or Formula (61). In particular, from the viewpoint of i-ray transmittance and ease of availability, a divalent organic group represented by Formula (61) is more preferable.

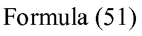

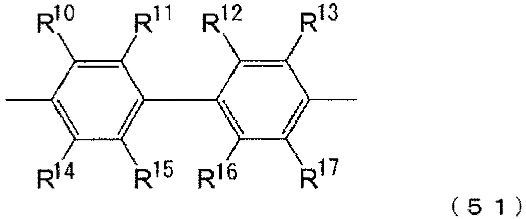

In Formula (51), R¹⁰ to R¹⁷ each independently represent a hydrogen atom, a fluorine atom, or a monovalent organic group, and at least one of R¹⁰, ..., or R¹⁷ represents a fluorine atom, a methyl group, a fluoromethyl group, a difluoromethyl group, or a trifluoromethyl group.

As the monovalent organic group in R¹⁰ to R¹⁷, an unsubstituted alkyl group having 1 to 10 (preferably 1 to 6) carbon atoms, a fluorinated alkyl group having 1 to 10 (preferably 1 to 6) carbon atoms, and the like are mentioned.

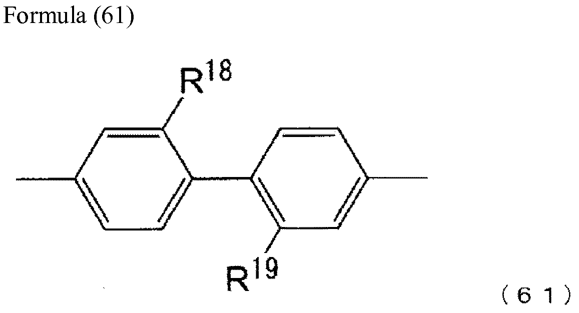

In Formula (61), R¹⁸ and R¹⁹ are each independently a fluorine atom, a fluoromethyl group, a difluoromethyl group, or a trifluoromethyl group.

As a diamine compound that forms a structure of Formula (51) or (61), dimethyl-4,4'-diaminobiphenyl, 2,2'-bis(trifluoromethyl)-4,4'-diaminobiphenyl, 2,2'-bis(fluoro)-4,4'-diaminobiphenyl, 4,4'-diaminooctafluorobiphenyl, and the like are mentioned. One type of these may be used, or two or more types thereof may be used in combination.

R¹¹⁵ in Formula (2) represents a tetravalent organic group. As the tetravalent organic group, a tetravalent organic group containing an aromatic ring is preferable, and a group represented by Formula (5) or Formula (6) is more preferable.

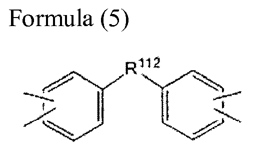

In Formula (5), R¹¹² is preferably a single bond, or a group selected from an aliphatic hydrocarbon group having 1 to 10 carbon atoms which may be substituted with a fluorine atom, -O-, -CO-, -S-, -SO₂-, -NHCO-, and a combination thereof, more preferably a single bond, or a group selected from an alkylene group having 1 to 3 carbon atoms which may be substituted with a fluorine atom, -O-, -CO-, -S-, and -SO₂-, and even more preferably a divalent group selected from -CH₂-, -C(CF₃)₂-, -C(CH₃)₂-, -O-, -CO-, -S-, and -SO₂-.

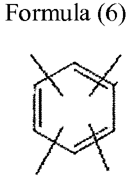

As the tetravalent organic group represented by R¹¹⁵ in Formula (2), specifically, a tetracarboxylic acid residue that remains after removing an acid dianhydride group from tetracarboxylic acid dianhydride is mentioned. For the tetracarboxylic acid dianhydride, only one type may be used, or two or more types may be used. The tetracarboxylic acid dianhydride is preferably a compound represented by Formula (O).

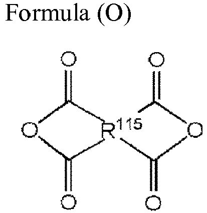

In Formula (O), R¹¹⁵ represents a tetravalent organic group. R¹¹⁵ has the same meaning as R¹¹⁵ in Formula (2).

As specific examples of the tetracarboxylic acid dianhydride, at least one selected from pyromellitic acid, pyromellitic acid dianhydride (PMDA), 3,3',4,4'-biphenyltetracarboxylic acid dianhydride, 3,3',4,4'-diphenylsulfide tetracarboxylic acid dianhydride, 3,3',4,4'-diphenylsulfone tetracarboxylic acid dianhydride, 3,3',4,4'-benzophenone tetracarboxylic acid dianhydride, 3,3',4,4'-diphenylmethane tetracarboxylic acid dianhydride, 2,2',3,3'-diphenylmethane tetracarboxylic acid dianhydride, 2,3,3',4'-biphenyltetracarboxylic acid dianhydride, 2,3,3',4'-benzophenone tetracarboxylic acid dianhydride, 4,4'-oxydiphthalic acid dianhydride, 2,3,6,7-naphthalene tetracarboxylic acid dianhydride, 1,4,5,7-naphthalene tetracarboxylic acid dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl) hexafluoropropane dianhydride, 1,3-diphenylhexafluoropropane-3,3,4,4-tetracarboxylic acid dianhydride, 1,4,5,6-naphthalene tetracarboxylic acid dianhydride, 2,2',3,3'-diphenyl tetracarboxylic acid dianhydride, 3,4,9,10-perylene tetracarboxylic acid dianhydride, 1,2,4,5-naphthalene tetracarboxylic acid dianhydride, 1,4,5,8-naphthalene tetracarboxylic acid dianhydride, 1,8,9,10-phenanthrene tetracarboxylic acid dianhydride, 1,1 -bis(2,3-dicarboxyphenyl)ethane dianhydride, 1,1-bis(3,4-dicarboxyphenyl)ethane dianhydride, 1,2,3,4-benzene tetracarboxylic acid dianhydride, or alkyl derivatives having 1 to 6 carbon atoms and/or alkoxy derivatives having 1 to 6 carbon atoms thereof are exemplified.

In addition, tetracarboxylic acid dianhydrides (DAA-1) to (DAA-5) as shown below are also mentioned as preferable examples.

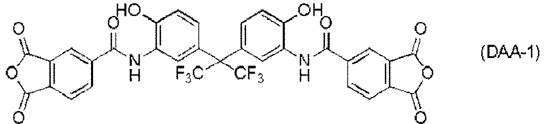

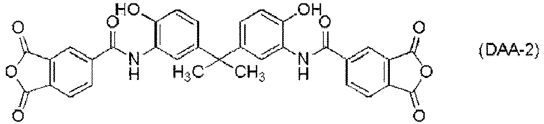

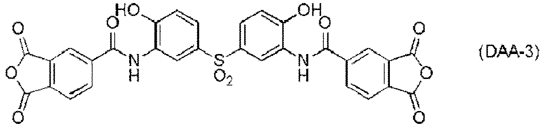

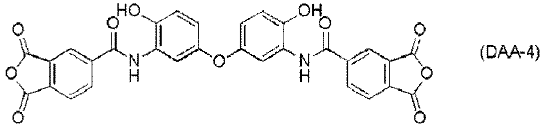

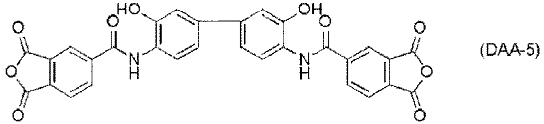

R¹¹³ and R¹¹⁴ each independently represent a hydrogen atom or a monovalent organic group. It is preferable that at least one of R¹¹³ or R¹¹⁴ contains a radically polymerizable group, and it is more preferable that both of R¹¹³ and R¹¹⁴ contain a radically polymerizable group. The radically polymerizable group is a group capable of undergoing a crosslinking reaction by an action of a radical, and preferable examples thereof include a group having an ethylenically unsaturated bond.

As the group having an ethylenically unsaturated bond, a vinyl group, a (meth)allyl group, a group represented by Formula (III), and the like are mentioned.

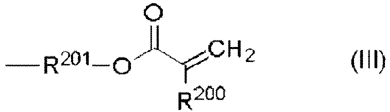

In Formula (III), R²⁰⁰ represents a hydrogen atom or a methyl group, with a methyl group being more preferable.

In Formula (III), R²⁰¹ represents an alkylene group having 2 to 12 carbon atoms, -CH₂CH(OH)CH₂-, or a polyoxyalkylene group having 4 to 30 carbon atoms.

Suitable examples of R²⁰¹ include an ethylene group, a propylene group, a trimethylene group, a tetramethylene group, a 1,2-butanediyl group, a 1,3-butanediyl group, a pentamethylene group, a hexamethylene group, an octamethylene group, a dodecamethylene group, and -CH₂CH(OH)CH₂-, with an ethylene group, a propylene group, a trimethylene group, and -CH₂CH(OH)CH₂- being more preferable.

Particularly preferably, R²⁰⁰ is a methyl group, and R²⁰¹ is an ethylene group.

As the monovalent organic group represented by R¹¹³ or R¹¹⁴, a substituent that improves solubility of a developer is preferably used.

From the viewpoint of solubility in an aqueous developer, R¹¹³ or R¹¹⁴ may be a hydrogen atom or a monovalent organic group. As the monovalent organic group, an aromatic group, an aralkyl group, and the like which have 1, 2, or 3 acidic groups, preferably 1 acidic group, bonded to carbon atoms constituting an aryl group are mentioned. Specifically, an aromatic group having 6 to 20 carbon atoms which has an acidic group and an aralkyl group having 7 to 25 carbon atoms which has an acidic group are mentioned. More specifically, a phenyl group having an acidic group and a benzyl group having an acidic group are mentioned. The acidic group is preferably an OH group.

R¹¹³ or R¹¹⁴ is more preferably a hydrogen atom, 2-hydroxybenzyl, 3-hydroxybenzyl, and 4-hydroxybenzyl from the viewpoint of solubility in an aqueous developer.

From the viewpoint of solubility in an organic solvent, R¹¹³ or R¹¹⁴ is preferably a monovalent organic group. The monovalent organic group preferably contains a linear or branched alkyl group, a cyclic alkyl group, or an aromatic group, and more preferably an alkyl group substituted with an aromatic group.

The alkyl group preferably has 1 to 30 carbon atoms. The alkyl group may be linear, branched, or cyclic. As the linear or branched alkyl group, for example, a methyl group, an ethyl group, a propyl group, a butyl group, a pentyl group, a hexyl group, a heptyl group, an octyl group, a nonyl group, a decyl group, a dodecyl group, a tetradecyl group, an octadecyl group, an isopropyl group, an isobutyl group, a sec-butyl group, a t-butyl group, a 1-ethylpentyl group, and a 2-ethylhexyl group are mentioned. The cyclic alkyl group may be a monocyclic cyclic alkyl group or a polycyclic cyclic alkyl group. As the monocyclic cyclic alkyl group, for example, a cyclopropyl group, a cyclobutyl group, a cyclopentyl group, a cyclohexyl group, a cycloheptyl group, and a cyclooctyl group are mentioned. As the polycyclic cyclic alkyl group, for example, an adamantyl group, a norbornyl group, a bornyl group, a camphenyl group, a decahydronaphthyl group, a tricyclodecanyl group, a tetracyclodecanyl group, a camphoroyl group, a dicyclohexyl group, and a pinenyl group are mentioned. Among these, a cyclohexyl group is most preferable from the viewpoint of compatibility with high sensitivity. In addition, the alkyl group substituted with an aromatic group is preferably a linear alkyl group substituted with an aromatic group as described later.

As the aromatic group, specifically, a substituted or unsubstituted benzene ring, a naphthalene ring, a pentalene ring, an indene ring, an azulene ring, a heptalene ring, an indacene ring, a perylene ring, a pentacene ring, an acenaphthene ring, a phenanthrene ring, an anthracene ring, a naphthacene ring, a chrysene ring, a triphenylene ring, a fluorene ring, a biphenyl ring, a pyrrole ring, a furan ring, a thiophene ring, an imidazole ring, an oxazole ring, a thiazole ring, a pyridine ring, a pyrazine ring, a pyrimidine ring, a pyridazine ring, an indolizine ring, an indole ring, a benzofuran ring, a benzothiophene ring, an isobenzofuran ring, a quinolizine ring, a quinoline ring, a phthalazine ring, a naphthyridine ring, a quinoxaline ring, a quinoxazoline ring, an isoquinoline ring, a carbazole ring, a phenanthridine ring, an acridine ring, a phenanthroline ring, a thianthrene ring, a chromene ring, a xanthene ring, a phenoxathiin ring, a phenothiazine ring, or a phenazine ring is mentioned. A benzene ring is most preferable.

In Formula (2), in a case where R¹¹³ is a hydrogen atom, or in a case where R¹¹⁴ is a hydrogen atom, the polyimide precursor may form a counter salt with a tertiary amine compound having an ethylenically unsaturated bond. As an example of such a tertiary amine compound having an ethylenically unsaturated bond, N,N-dimethylaminopropyl methacrylate is mentioned.

In addition, it is also preferable that the polyimide precursor has a fluorine atom in a structural unit. A content of fluorine atoms in the polyimide precursor is preferably 10% by mass or higher, and more preferably 20% by mass or lower.

In addition, for the purpose of improving adhesiveness to a substrate, an aliphatic group having a siloxane structure may be copolymerized. Specifically, as the diamine component, bis(3-aminopropyl)tetramethyldisiloxane, bis(paraaminophenyl)octamethyl pentasiloxane, and the like are mentioned.

The repeating unit represented by Formula (2) is preferably a repeating unit represented by Formula (2-A). That is, at least one of the polyimide precursors used in the present invention is preferably a precursor having the repeating unit represented by Formula (2-A). By adopting such a structure, it is possible to further widen a width of exposure latitude.

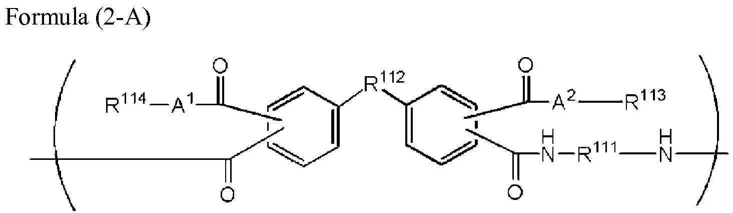

In Formula (2-A), A¹ and A² each represent an oxygen atom, R¹¹¹ and R112 each independently represent a divalent organic group, and R¹¹³ and R¹¹⁴ each independently represent a hydrogen atom or a monovalent organic group, and at least one of R¹¹³ or R¹¹⁴ is a group containing a polymerizable group, and is preferably a polymerizable group being preferable.

A¹, A², R¹¹¹, R¹¹³, and R¹¹⁴ each independently have the same meaning as A¹, A², R¹¹¹, R¹¹³, and R¹¹⁴ in Formula (2), and preferable ranges thereof are also the same.

R¹¹² has the same meaning as R¹¹² in Formula (5), and a preferable range thereof is also the same.

The polyimide precursor may have one type of the repeating structural units represented by Formula (2), and may have two or more types thereof. In addition, the polyimide precursor may contain a structural isomer of the repeating unit represented by Formula (2). In addition, the polyimide precursor may also contain another type of repeating structural unit in addition to the repeating unit of Formula (2).

As one embodiment of the polyimide precursor in the present invention, polyimide precursors in which the repeating unit represented by Formula (2) accounts for 50% by mol or higher, even 70% by mol or higher, and in particular 90% by mol or higher in an entirety of the repeating units are exemplified.

A weight-average molecular weight (Mw) of the polyimide precursor is preferably 2,000 to 500,000, more preferably 5,000 to 100,000, and even more preferably 10,000 to 50,000. In addition, a number average molecular weight (Mn) thereof is preferably 800 to 250,000, more preferably 2,000 to 50,000, and even more preferably 4,000 to 25,000.

A degree of dispersion of the polyimide precursor is preferably 1.5 to 2.5.

The polyimide precursor is obtained by reacting dicarboxylic acid or a dicarboxylic acid derivative with diamine. Preferably, the polyimide precursor is obtained by halogenating dicarboxylic acid or a dicarboxylic acid derivative with a halogenating agent, and then causing the resultant to be reacted with diamine.

In a method for producing the polyimide precursor, it is preferable to use an organic solvent at the time of reaction. For the organic solvent, one type may be used, or two or more types may be used.

The organic solvent can be appropriately determined according to raw materials, and pyridine, diethylene glycol dimethyl ether (diglyme), N-methylpyrrolidone, and N-ethylpyrrolidone are exemplified.

At the time of producing the polyimide precursor, in order to further improve storage stability, it is preferable to perform sealing with a terminal sealing agent such as acid dianhydride, monocarboxylic acid, a mono-acid chloride compound, and a mono-active ester compound. Among these, it is more preferable to use monoamine. As preferable compounds of the monoamine, aniline, 2-ethynylaniline, 3-ethynylaniline, 4-ethynylaniline, 5-amino-8-hydroxyquinoline, 1-hydroxy-7-aminonaphthalene, 1-hydroxy-6-aminonaphthalene, 1-hydroxy-5-aminonaphthalene, 1 -hydro xy-4-aminonaphthalene, 2-hydroxy-7-aminonaphthalene, 2-hydroxy-6-aminonaphthalene, 2-hydroxy-5-aminonaphthalene, 1 -carboxy-7-aminonaphthalene, 1 -carboxy-6-aminonaphthalene, 1 -carboxy-5 -amino naphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzene sulfonic acid, 3-aminobenzene sulfonic acid, 4-aminobenzene sulfonic acid, 3-amino-4,6-dihydroxypyrimidine, 2-aminophenol, 3-aminophenol, 4-aminophenol, 2-aminothiophenol, 3-aminothiophenol, 4-aminothiophenol, and the like are mentioned. Two or more types of these may be used, or a plurality of different terminal groups may be introduced by applying a plurality of terminal sealing agents for reaction.

At the time of producing the polyimide precursor, a step of precipitating a solid may be included. Specifically, it is possible to precipitate a solid by causing the polyimide precursor in a reaction solution to be sedimented in water and causing the sedimented polyimide precursor to be dissolved in a solvent such as tetrahydrofuran in which the polyimide precursor is soluble.

Thereafter, the polyimide precursor can be dried to obtain a powdery polyimide precursor.

### <<<Polybenzoxazole precursor>>>

The polybenzoxazole precursor used in the present invention preferably contains a repeating unit represented by Formula (3).

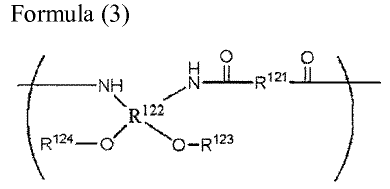

In Formula (3), R¹²¹ represents a divalent organic group, R¹²² represents a tetravalent organic group, and R¹²³ and R¹²⁴ each independently represent a hydrogen atom or a monovalent organic group.

In Formula (3), R¹²¹ represents a divalent organic group. The divalent organic group is preferably a group containing at least one of an aliphatic group or an aromatic group. The aliphatic group is preferably a linear aliphatic group.

In Formula (3), R¹²² represents a tetravalent organic group. The tetravalent organic group has the same meaning as R¹¹⁵ in Formula (2), and a preferable range thereof is also the same.

The polybenzoxazole precursor may contain another type of repeating structural unit, in addition to the repeating unit of Formula (3).

From the viewpoint that occurrence of warping due to ring closure can be suppressed, it is preferable to contain a diamine residue represented by Formula (SL) as the other type of repeating structural unit.

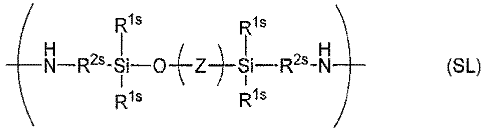

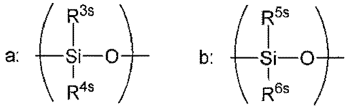

In Formula (SL), Z has an a structure and a b structure, R^{1s} is a hydrogen atom or a hydrocarbon group having 1 to 10 carbon atoms, R^{2s} is a hydrocarbon group having 1 to 10 carbon atoms, and at least one of R^{3s}, R^{4s}, R^{5s}, or R^{6s} is an aromatic group and the rest, which may be the same as or different from each other, is a hydrogen atom or an organic group having 1 to 30 carbon atoms. Polymerization of the a structure and the b structure may be either block polymerization or random polymerization. % by mol of the Z moiety is 5% to 95% by mol in the a structure, and is 95% to 5% by mol in the b structure, in which a + b is 100% by mol.

In Formula (SL), as a preferable Z, a b structure in which R^{5s} and R^{6s} are phenyl groups is mentioned. In addition, a molecular weight of a structure represented by Formula (SL) is preferably 400 to 4,000, and more preferably 500 to 3,000. The molecular weight can be obtained by gel permeation chromatography which is commonly used. In a case where the molecular weight is set to be within the above-mentioned range, it is possible to decrease a modulus of elasticity of the polybenzoxazole precursor after dehydration ring closure, and to achieve both effects of suppressing warping and of improving solubility.

In a case where a diamine residue represented by Formula (SL) is contained as the other type of repeating structural unit, from the viewpoint of improving alkaline solubility, it is preferable to further contain a tetracarboxylic acid residue that remains after removing an acid dianhydride group from tetracarboxylic acid dianhydride, as a repeating structural unit. As examples of such a tetracarboxylic acid residue, examples of R¹¹⁵ in Formula (2) are mentioned.

A weight-average molecular weight (Mw) of the polybenzoxazole precursor is preferably 2,000 to 500,000, more preferably 5,000 to 100,000, and even more preferably 10,000 to 50,000. In addition, a number-average molecular weight (Mn) thereof is preferably 800 to 250,000, more preferably 2,000 to 50,000, and even more preferably 4,000 to 25,000.

A degree of dispersion of the polybenzoxazole precursor is preferably 1.5 to 2.5.

A content of the heterocyclic ring-containing polymer precursor in the composition of the present invention is preferably 20% to 100% by mass, more preferably 50% to 99% by mass, even more preferably 60% to 98% by mass, and particularly preferably 70% to 95% by mass, with respect to a total solid content of the composition.

For the heterocyclic ring-containing polymer precursor, only one type may be contained, or two or more types may be contained. In a case where two or more types are contained, a total amount thereof is preferably within the above-mentioned range.

### «Thermal-base generator»

The composition of the present invention contains a thermal-base generator. By using the thermal-base generator, it is possible to suppress exposure energy consumption and to expand exposure latitude, and it is also possible to generate base species that promote a ring closure reaction of the heterocyclic ring-containing polymer precursor during a heating step of performing the ring closure reaction. Thus, a ring closure rate tends to be further improved.

As the thermal-base generator, a type and the like thereof are not particularly specified, and the thermal-base generator preferably includes a thermal-base generator that contains at least one selected from an acidic compound which generates a base in a case of being heated to 40°C or higher, or an ammonium salt which has an anion having pKa1 of 0 to 4 and an ammonium cation. Here, pKa1 represents logarithm (-Log₁₀Ka) of a reciprocal of a dissociation constant (Ka) of a first proton of an acid, and details thereof will be described later.

The acidic compound (A1) and the ammonium salt (A2) generate a base in a case of being heated. Thus, the base generated from these compounds makes it possible to promote a cyclization reaction of the heterocyclic ring-containing polymer precursor, and makes it possible to cause cyclization of the heterocyclic ring-containing polymer precursor to be carried out at a low temperature. In addition, even in a case where these compounds are caused to coexist with a polyimide precursor or the like which is cyclized by a base and cured, cyclization of the heterocyclic ring-containing polymer precursor hardly proceeds unless heated, so that a composition having excellent storage stability can be prepared.

In the present specification, the acidic compound means a compound having a pH value of less than 7 as measured at 20°C using a pH (power of hydrogen) meter for a solution obtained in such a manner that 1 g of the compound is collected in a container, 50 mL of a mixed liquid of ion-exchanged water and tetrahydrofuran (mass ratio is water/tetrahydrofuran = 1/4) is added thereto, and the mixture is stirred at room temperature for 1 hour.

In the present embodiment, a base generation temperature of the acidic compound (A1) and the ammonium salt (A2) is preferably 40°C or higher, and more preferably 120°C to 200°C. An upper limit of the base generation temperature is preferably 190°C or lower, more preferably 180°C or lower, and even more preferably 165°C or lower. A lower limit of the base generation temperature is preferably 130°C or higher, and more preferably 135°C or higher.

In a case where the base generation temperature of the acidic compound (A1) and the ammonium salt (A2) is 120°C or higher, a base is hardly generated during storage, so that a composition which is excellent in stability can be prepared. In a case where the base generation temperature of the acidic compound (A1) and the ammonium salt (A2) is 200°C or lower, a cyclization temperature of the heterocyclic ring-containing polymer precursor can be decreased. For example, the base generation temperature may be measured, for example, using differential scanning calorimetry by heating a compound to 250°C at a rate of 5°C/minute in a pressure-resistant capsule, reading a peak temperature of an exothermic peak having the lowest temperature, and taking the peak temperature as a base generation temperature.

In the present embodiment, a base generated by the thermal-base generator is preferably a secondary amine or a tertiary amine, and more preferably a tertiary amine. Since the tertiary amine has high basicity, a cyclization temperature of the polyimide precursor, the polybenzoxazole precursor, and the like can be further decreased. In addition, a boiling point of the base generated by the thermal-base generator is preferably 80°C or higher, more preferably 100°C or higher, and even more preferably 140°C or higher. In addition, a molecular weight of the generated base is preferably 80 to 2,000. A lower limit thereof is more preferably 100 or higher. An upper limit thereof is more preferably 500 or lower. A value of the molecular weight is a theoretical value obtained from a structural formula.

In the present embodiment, the acidic compound (A1) preferably contains at least one selected from an ammonium salt or a compound having an ammonium structure represented by Formula (101) or (102).

In the present embodiment, the ammonium salt (A2) is preferably an acidic compound. The ammonium salt (A2) may be a compound containing an acidic compound which generates a base in a case of being heated to 40°C or higher (preferably 120°C to 200°C), or may be a compound other than the acidic compound which generates a base in a case of being heated to 40°C or higher (preferably 120°C to 200°C).

In the present embodiment, the ammonium salt means a salt of an ammonium cation represented by Formula (101) or Formula (102) with an anion. The anion may be bonded via a covalent bond to any portion of the ammonium cation, or may also be present outside a molecule of the ammonium cation. The anion is preferably present outside a molecule of the ammonium cation. The expression of the anion being present outside the molecule of the ammonium cation refers to a case where the ammonium cation and the anion are not bonded via a covalent bond. Hereinafter, an anion outside a molecule of a cation moiety is also referred to as a counter anion.

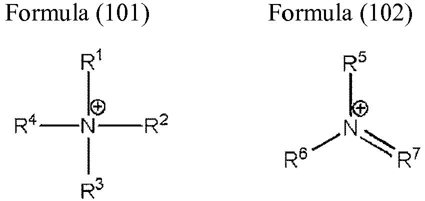

In Formulas (101) and (102), R¹ to R⁶ each independently represent a hydrogen atom or a hydrocarbon group, and R⁷ represents a hydrocarbon group. R¹ and R², R³ and R⁴, R⁵ and R⁶, or R⁵ and R⁷ in Formulas (101) and (102) may be bonded to each other to form a ring.

The ammonium cation is preferably represented by any one of Formulas (Y1-1) to (Y1-5).

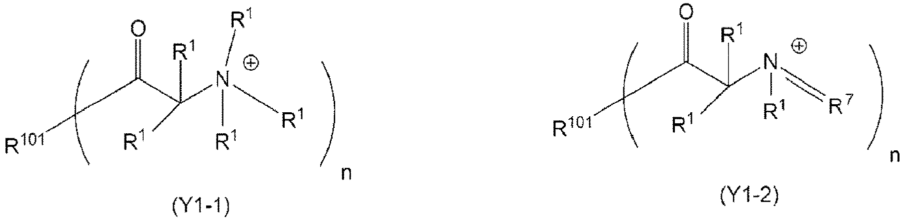

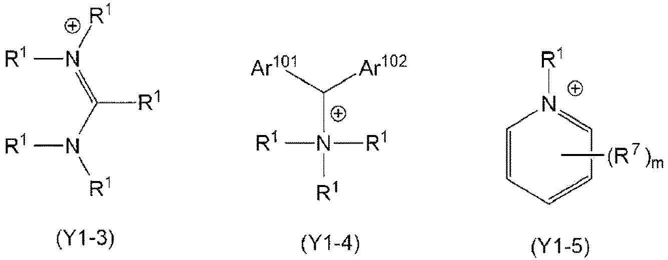

In Formulas (Y1-1) to (Y1-5), R¹⁰¹ represents an n-valent organic group, and R¹ and R⁷ have the same meanings as R¹ and R⁷ in Formula (101) or Formula (102).

In Formulas (Y1-1) to (Y1-4), Ar¹⁰¹ and Ar¹⁰² each independently represent an aryl group, n represents an integer of 1 or higher, and m represents an integer of 0 to 5.

In the present embodiment, the ammonium salt preferably has an anion having pKa1 of 0 to 4 and an ammonium cation. An upper limit of the pKa1 of the anion is more preferably 3.5 or lower, and even more preferably 3.2 or lower. A lower limit thereof is preferably 0.5 or higher, and more preferably 1.0 or higher. In a case where the pKa1 of the anion is within the above-mentioned range, the heterocyclic ring-containing polymer precursor can be cyclized at a lower temperature, and stability of the composition can also be improved. In a case where the pKa1 is 4 or lower, good stability of the thermal-base generator can be exhibited and generation of a base can be suppressed in the absence of heating, so that the composition exhibits good stability. In a case where the pKa1 is 0 or higher, the generated base is hardly neutralized, and cyclization efficiency of the heterocyclic ring-containing polymer precursor or the like is good.

A type of the anion is preferably one selected from a carboxylate anion, a phenol anion, a phosphate anion, and a sulfate anion, and a carboxylate anion is more preferable for the reason that both salt stability and thermal decomposability are achieved. That is, the ammonium salt is more preferably a salt of an ammonium cation with a carboxylate anion.

The carboxylate anion is preferably an anion of a divalent or higher carboxylic acid having two or more carboxyl groups, and more preferably an anion of a divalent carboxylic acid. According to the present embodiment, it is possible to use a thermal-base generator which can further improve stability, curability, and developability of the composition. In particular, by using an anion of a divalent carboxylic acid, stability, curability, and developability of the composition can be further improved.

In the present embodiment, the carboxylate anion is preferably an anion of a carboxylic acid having pKa1 of 4 or lower. The pKa1 is more preferably 3.5 or lower, and even more preferably 3.2 or lower. According to this embodiment, stability of the composition can be further improved.

Here, the pKa1 represents logarithm of a reciprocal of a dissociation constant of a first proton of an acid and reference can be made to the values described in Determination of Organic Structures by Physical Methods (written by Brown, H. C., McDaniel, D. H., Hafliger, O., Nachod, F. C.; edited by Braude, E. A., Nachod, F. C.; and Academic Press, New York, 1955), or Data for Biochemical Research (written by Dawson, R. M. C. et al.; and Oxford, Clarendon Press, 1959). For compounds which are not described in these documents, values calculated from structural formulas using a software ACD/pKa (manufactured by ACD/Labs) are used.

The carboxylate anion is preferably represented by Formula (XI).

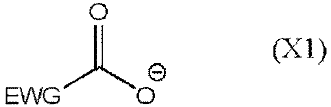

In Formula (XI), EWG represents an electron withdrawing group.

In the present embodiment, the electron withdrawing group means a group in which a Hammett's substituent constant σm shows a positive value. Here, the σm is described in detail in the review by TSUNO Yuho, Journal of the Society of Synthetic Organic Chemistry, Japan, Vol. 23, No. 8 (1965), pp. 631 to 642. The electron withdrawing group in the present embodiment is not limited to the substituents described in the document.

As examples of a substituent having a positive value of σm, a CF₃ group (σm = 0.43), a CF₃CO group (σm = 0.63), an HC≡C group (σm = 0.21), a CH2=CH group (σm = 0.06), an Ac group (σm = 0.38), a MeOCO group (σm = 0.37), a MeCOCH=CH group (σm = 0.21), a PhCO group (σm = 0.34), and H₂NCOCH₂ group (σm = 0.06) are mentioned. Me represents a methyl group, Ac represents an acetyl group, and Ph represents a phenyl group (hereinafter the same applies).

EWG is preferably a group represented by Formulas (EWG-1) to (EWG-6).

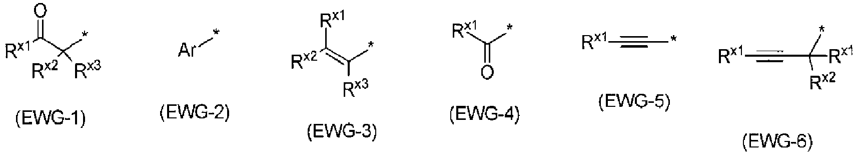

In Formulas (EWG-1) to (EWG-6), R^{x1} to R^{x3} each independently represent a hydrogen atom, an alkyl group, an alkenyl group, an aryl group, a hydroxyl group, or a carboxyl group, and Ar represents an aromatic group.

In the present embodiment, the carboxylate anion is preferably represented by Formula (XA).

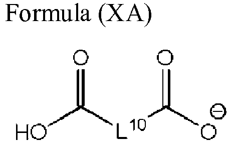

In Formula (XA), L¹⁰ represents a single bond, or a divalent linking group selected from an alkylene group, an alkenylene group, an aromatic group, -NR^{X}-, and a combination thereof, and R^{X} represents a hydrogen atom, an alkyl group, an alkenyl group, or an aryl group.

As specific examples of the carboxylate anion, a maleate anion, a phthalate anion, an N-phenyliminodiacetate anion, and an oxalate anion are mentioned.

As specific examples of the thermal-base generator, the following compounds can be mentioned.

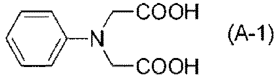

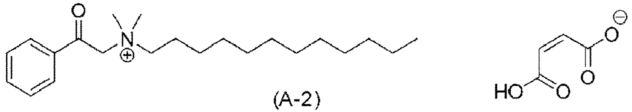

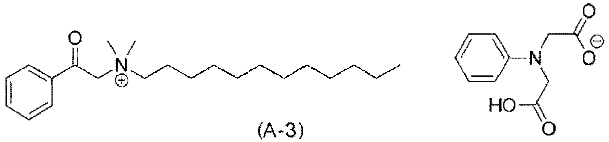

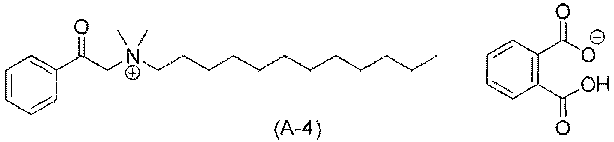

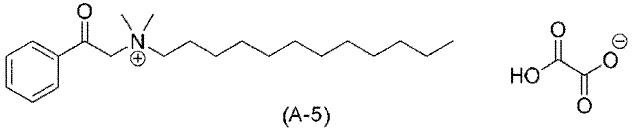

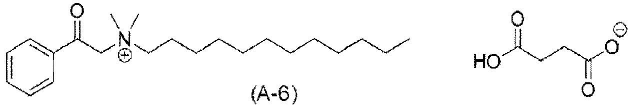

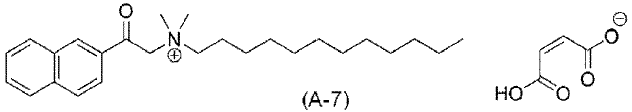

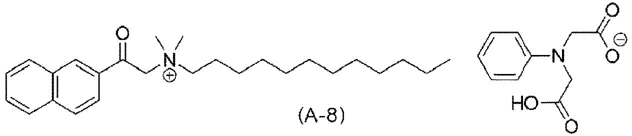

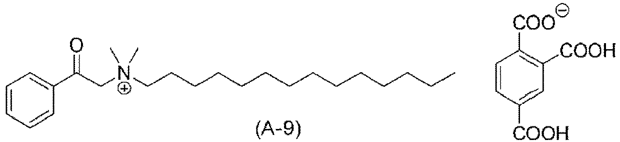

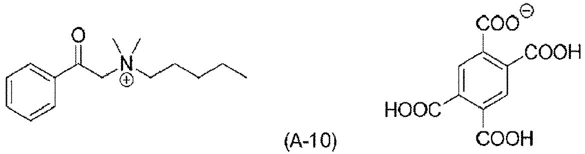

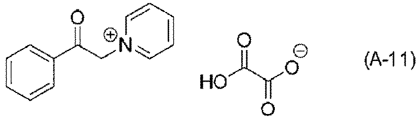

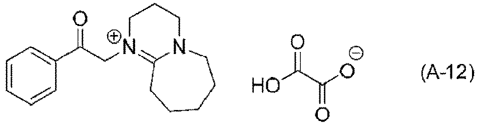

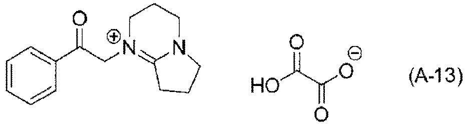

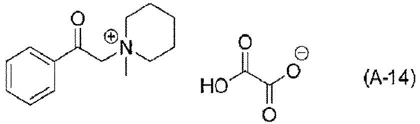

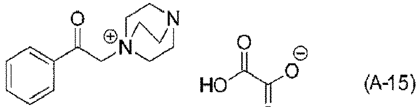

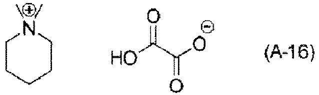

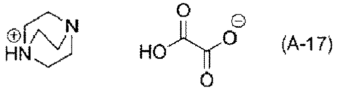

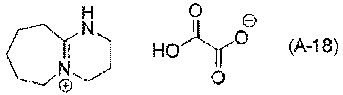

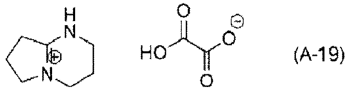

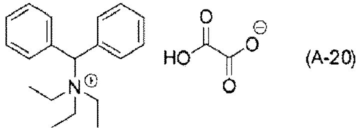

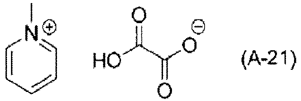

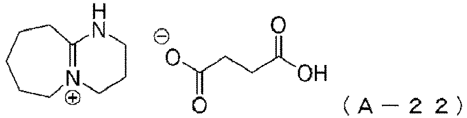

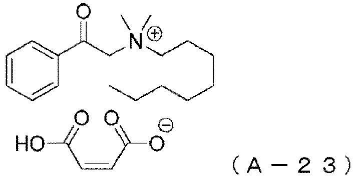

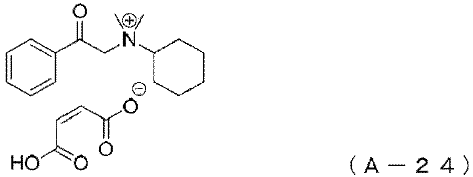

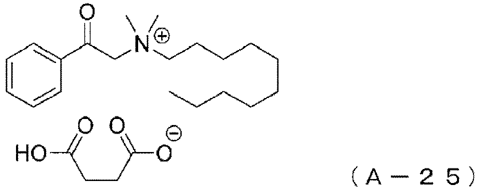

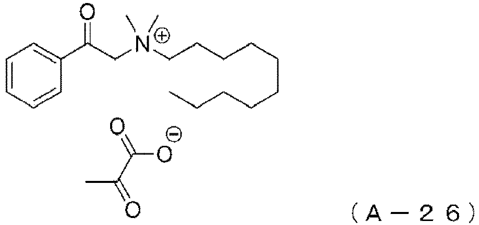

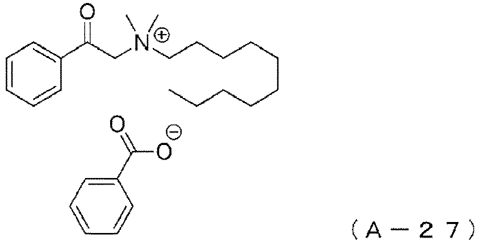

In a case where the composition of the present invention contains the thermal-base generator, a content of the thermal-base generator is preferably 0.1% to 50% by mass with respect to a total solid content of the composition of the present invention. A lower limit thereof is more preferably 0.5% by mass or higher, more preferably 0.85% by mass or higher, and even more preferably 1% by mass or higher. An upper limit thereof is more preferably 30% by mass or lower, more preferably 20% by mass or lower, and even more preferably 10% by mass or lower. The upper limit may be 5% by mass or lower, or 4% by mass or lower.

For the thermal-base generator, one type or two or more types may be used. In a case where two or more types are used, a total amount is preferably within the above-mentioned range.

### «Organic compound containing Group 4 element»

The composition of the present invention contains an organic compound (hereinafter referred to as "organotitanium compound or the like" in some cases) containing a Group 4 element.

The organic compound containing a Group 4 element is preferably an organic compound containing at least one selected from a titanium atom, a zirconium atom, or a hafnium atom, and more preferably an organic compound containing at least one selected from a titanium atom or a zirconium atom. In addition, the organic compound containing at least one selected from a titanium atom or a zirconium atom is preferably a compound containing an organic group and a titanium atom or a zirconium atom, with the number of the titanium atom and the zirconium atom in one molecule being preferably one in total. The organic group is not particularly specified, and is preferably a hydrocarbon group, or a group composed of a combination of a hydrocarbon group and a hetero atom. The hetero atom is preferably an oxygen atom, a sulfur atom, or a nitrogen atom.

In the present invention, at least one of the organic groups is preferably a cyclic group, and more preferably at least two thereof are cyclic groups. The cyclic group is preferably selected from a 5-membered cyclic group and a 6-membered cyclic group, and more preferably selected from a 5-membered cyclic group. As the 5-membered cyclic group, a cyclopentadienyl group is preferable. In addition, the organotitanium compound or the like used in the present invention preferably contains 2 to 4 cyclic groups in one molecule.

The organotitanium compound or the like in the present invention is preferably represented by Formula (P).

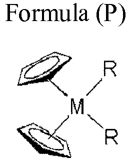

In Formula (P), M is a Group 4 element, and R's are each independently a substituent.

The substituent is preferably selected from an aromatic group, an alkyl group, a halogen atom, and an alkylsulfonyloxy group.

As the Group 4 element represented by M, a titanium atom, a zirconium atom, and a hafnium atom are preferable, and a titanium atom and a zirconium atom are more preferable.

As the aromatic group, a phenyl group, a 1-naphthyl group, a 2-naphthyl group, and the like are mentioned. As the alkyl group, a methyl group, an ethyl group, a propyl group, an octyl group, an isopropyl group, a t-butyl group, an isopentyl group, a 2-ethylhexyl group, a 2-methylhexyl group, a cyclopentyl group, and the like are mentioned.

As the halogen atom, F, Cl, Br, and I are mentioned.

As an alkyl chain constituting the alkylsulfonyloxy group, a methyl chain, an ethyl chain, a propyl chain, an octyl chain, an isopropyl chain, a t-butyl chain, an isopentyl chain, a 2-ethylhexyl chain, a 2-methylhexyl chain, a cyclopentyl chain, and the like are mentioned.

The above substituent may further have a substituent. As examples of the substituent, a halogen atom (F, Cl, Br, I), a hydroxyl group, a carboxyl group, an amino group, a cyano group, an aryl group, an alkoxy group, an aryloxy group, an acyl group, an alkoxycarbonyl group, an aryloxylcarbonyl group, an acyloxy group, a monoalkylamino group, a dialkylamino group, a monoarylamino group, a diarylamino group, and the like are mentioned.

The organic compound containing a Group 4 element used in the present invention is preferably selected from a titanocene compound, a tetraalkoxytitanium compound, a titanium acylate compound, a titanium chelate compound, a zirconocene compound, and a hafhocene compound, more preferably selected from a titanocene compound, a zirconocene compound, and a hafnocene compound, and even more preferably selected from a titanocene compound and a zirconocene compound.

A molecular weight of the organotitanium compound or the like is preferably 50 to 2,000, and more preferably 100 to 1,000.

As specific examples of the organotitanium compound or the like, tetraisopropoxytitanium, tetrakis(2-ethylhexyloxy)titanium, diisopropoxybis(ethylacetoacetate)titanium, diisopropoxybis(acetylacetonato)titanium, and the following compounds are exemplified.

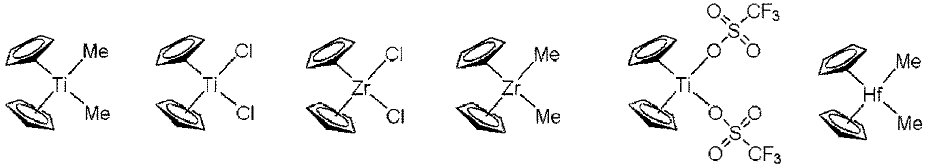

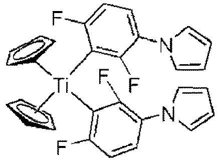

In addition, among the organotitanium compounds or the like, the following compounds can be used as an organic compound containing a titanium atom:
di-cyclopentadienyl-Ti-di-chloride, di-cyclopentadienyl-Ti-bis-phenyl, di-cyclopentadienyl-Ti-bis-2,3,4,5,6-pentafluorophenyl-1-yl, di-cyclopentadienyl-Ti-bis-2,3,5,6-tetrafluorophenyl-1-yl, di-cyclopentadienyl-Ti-bis-2,4,6-trifluorophenyl-1 -yl, di-cyclopentadienyl-Ti-2,6-difluorophenyl-1-yl, di-cyclopentadienyl-Ti-bis-2,4-difluorophenyl-1-yl, di-methylcyclopentadienyl-Ti-bis-2,3,4,5,6-pentafluorophenyl-1-yl, di-methylcyclopentadienyl-Ti-bis-2,3,5,6-tetrafluorophenyl-1-yl, di-methylcyclopentadienyl-Ti-bis-2,4-difluorophenyl-1-yl, bis(cyclopentadienyl)bis(2,6-difluoro-3-(pyrr-1-yl)phenyl)titanium, bis(cyclopentadienyl)bis[2,6-difluoro-3-(methylsulfoneamido)phenyl]titanium, bis(cyclopentadienyl)bis[2,6-difluoro-3-(N-butylbiaroyl-amino)phenyl]titanium, bis(cyclopentadienyl)bis[2,6-difluoro-3-(N-ethylacetylamino)phenyl]titanium, bis(cyclopentadienyl)bis[2,6-difluoro-3-(N-methylacetylamino)phenyl]titanium, bis(cyclopentadienyl)bis[2,6-difluoro-3-(N-ethylpropionylamino)phenyl]titanium, bis(cyclopentadienyl)bis[2,6-difluoro-3-(N-ethyl-(2,2-dimethylbutanoyl)amino)phenyl]titaniu m, bis(cyclopentadienyl)bis[2,6-difluoro-3-(N-butyl-(2,2-dimethylbutanoyl)amino)phenyl]titaniu m, bis(cyclopentadienyl)bis[2,6-difluoro-3-(N-pentyl-(2,2-dimethylbutanoyl)amino)phenyl]titani um, bis(cyclopentadienyl)bis[2,6-difluoro-3-(N-hexyl)-(2,2-dimethylbutanoyl)phenyl]titanium, bis(cyclopentadienyl)bis[2,6-difluoro-3-(N-methylbutyrylamino)phenyl]titanium, bis(cyclopentadienyl)bis[2,6-difluoro-3-(N-methylpentanoylamino)phenyl]titanium, bis(cyclopentadienyl)bis[2,6-difluoro-3-(N-ethylcyclohexylcarbonylamino)phenyl]titanium, bis(cyclopentadienyl)bis[2,6-difluoro-3-(N-ethylisobutyrylamino)phenyl]titanium, bis(cyclopentadienyl)bis[2,6-difluoro-3-(N-ethylacetylamino)phenyl]titanium,
bis(cyclopentadienyl)bis[2,6-difluoro-3-(2,2,5,5-tetramethyl-1,2,5-azadipyrolidin-1-yl)phenyl] titanium, bis(cyclopentadienyl)bis[2,6-difluoro-3-(octylsulfoneamido)phenyl]titanium, bis(cyclopentadienyl)bis[2,6-difluoro-3-(4-tolylsulfonamido)phenyl]titanium, bis(cyclopentadienyl)[2,6-difluoro-3-(4-dodecylphenylsulfonylamido)phenyl]titanium, bis(cyclopentadienyl)bis[2,6-difluoro-3-(4-(1-pentylheptyl)phenylsulfonylamido)phenyl]titani um, bis(cyclopentadienyl)bis[2,6-difluoro-3-(ethylsulfonylamido)phenyl]titanium, bis(cyclopentadienyl)bis[2,6-difluoro-3-((4-bromophenyl)-sulfonylamido)phenyl]titanium, bis(cyclopentadienyl)bis[2,6-difluoro-3-(2-naphthylsulfonylamido)phenyl]titanium, bis(cyclopentadienyl)bis[2,6-difluoro-3-(hexadecylsulfonylamido)phenyl]titanium, bis(cyclopentadienyl)bis[2,6-difluoro-3-(N-methyl-(4-dodecylphenyl)sulfonylamido)phenyl]tit anium, bis(cyclopentadienyl)bis[2,6-difluoro-3-(N-methyl-4-(1-pentylheptyl)phenyl)sulfonylamido)]ti tanium, bis(cyclopentadienyl)bis[2,6-difluoro-3-(N-hexyl-(4-tolyl)-sulfonylamido)phenyl]titanium, bis(cyclopentadienyl)bis[2,6-difluoro-3-(pyrrolidine-2,5-dion-1-yl)phenyl]titanium, bis(cyclopentadienyl)bis[2,6-difluoro-3-(3,4-dimethyl-3-pyrrolidine-2,5-dion-1-yl)phenyl]titan ium, bis(cyclopentadienyl)bis(2,6-difluoro-3-(phthalimido)phenyl]titanium, bis(cyclopentadienyl)bis[2,6-difluoro-3-(isobutoxycarbonylamino)phenyl]titanium, bis(cyclopentadienyl)bis[2,6-difluoro-3-(ethoxycarbonylamino)phenyl]titanium, bis(cyclopentadienyl)bis[2,6-difluoro-3-((2-chloroethoxy)-carbonylamino)phenyl]titanium, bis(cyclopentadienyl)bis[2,6-difluoro-3-(phenoxycarbonylamino)phenyl]titanium, bis(cyclopentadienyl)bis[2,6-difluoro-3-(3-phenylthioureido)phenyl]titanium, bis(cyclopentadienyl)bis[2,6-difluoro-3-(3-butylthioureido)phenyl]titanium, bis(cyclopentadienyl)bis[2,6-difluoro-3-(3-phenylureido)phenyl]titanium, bis(cyclopentadienyl)bis[2,6-difluoro-3-(3-butylureido)phenyl]titanium, bis(cyclopentadienyl)bis[2,6-difluoro-3-(N,N-diacetylamino)phenyl]titanium, bis(cyclopentadienyl)bis[2,6-difluoro-3-(3,3-dimethylureido)phenyl]titanium, bis(cyclopentadienyl)bis[2,6-difluoro-3-(acetylamino)phenyl]titanium, bis(cyclopentadienyl)bis[2,6-difluoro-3-(butyrylamino)phenyl]titanium, bis(cyclopentadienyl)bis2,6-difluoro-3-(decanoylamino)phenyl]titanium, bis(cyclopentadienyl)bis[2,6-difluoro-3-(octadecanoylamino)phenyl]titanium,
bis(cyclopentadienyl)bis[2,6-difluoro-3-(isobutyrylamino)phenyl]titanium, bis(cyclopentadienyl)bis[2,6-difluoro-3-(2-ethylhexanoylamino)phenyl]titanium, bis(cyclopentadienyl)bis[2,6-difluoro-3-(2-methylbutanoylamino)phenyl]titanium, bis(cyclopentadienyl)bis[2,6-difluoro-3-(pivaloylamino)phenyl]titanium, bis(cyclopentadienyl)bis[2,6-difluoro-3-(2,2-dimethylbutanoylamino)phenyl]titanium, bis(cyclopentadienyl)bis[2,6-difluoro-3-(2-ethyl-2-methylheptanoylamino)phenyl]titanium, bis(cyclopentadienyl)bis[2,6-difluoro-3-(cyclohexylcarbonylamino)phenyl]titanium, bis(cyclopentadienyl)bis[2,6-difluoro-3-(2,2-dimethyl-3-chloropropanoylamino)phenyl]titaniu m, bis(cyclopentadienyl)bis[2,6-difluoro-3-(3-phenylpropanoylamino)phenyl]titanium, bis(cyclopentadienyl)bis[2,6-difluoro-3-(2-chloromethyl-2-methyl-3-chloropropanoylamino)p henyl]titanium, bis(cyclopentadienyl)bis[2,6-difluoro-3-(3,4-xyloylamino)phenyl]titanium, bis(cyclopentadienyl)bis[2,6-difluoro-3-(4-ethylbenzoylamino)phenyl]titanium, bis(cyclopentadienyl)bis[2,6-difluoro-3-(2,4,6-mesitylcarbonylamino)phenyl]titanium, bis(cyclopentadienyl)bis[2,6-difluoro-3-(benzoylamino)phenyl]titanium, bis(cyclopentadienyl)bis[2,6-difluoro-3-(N-(3-phenylpropyl)benzoylamino)phenyl]titanium, bis(cyclopentadienyl)bis[2,6-difluoro-3-(N-(3-ethylheptyl)-2,2-dimethylpentanoylamino)phen yl]titanium, bis(cyclopentadienyl)bis[2,6-difluoro-3-(N-isobutyl-(4-tolyl)amino)phenyl]titanium, bis(cyclopentadienyl)bis[2,6-difluoro-3-(N-isobutylbenzoylamino)phenyl]titanium, bis(cyclopentadienyl)bis[2,6-difluoro-3-(N-cyclohexylmethylpivaloylamino)phenyl]titanium, bis(cyclopentadienyl)bis[2,6-difluoro-3-(N-(oxolan-2-ylmethyl)benzoylamino)phenyl]titanium, bis(cyclopentadienyl)bis[2,6-difluoro-3-(N-(3-ethylheptyl)-2,2-dimethylbutanoylamino)pheny l]titanium, bis(cyclopentadienyl)bis[2,6-difluoro-3-(N-(3-phenylpropyl-(4-toluyl)amino)phenyl]titanium, bis(cyclopentadienyl)bis[2,6-difluoro-3-(N-(oxoran-2-ylmethyl)-(4-toluyl)amino)phenyl]titani um, bis(cyclopentadienyl)bis[2,6-difluoro-3-(N-(4-toluylmethyl)benzoylamino)phenyl]titanium, bis(cyclopentadienyl)bis[2,6-difluoro-3-(N-(4-toluylmethyl)-(4-toluyl)amino)phenyl]titanium, bis(cyclopentadienyl)bis[2,6-difluoro-3-(N-butylbenzoylamino)phenyl]titanium,
bis(cyclopentadienyl)bis[2,6-difluoro-3-(N-butyl-(4-toluyl)amino)phenyl]titanium, bis(cyclopentadienyl)bis[2,6-difluoro-3-(N-hexyl-(4-toluyl)amino)phenyl]titanium, bis(cyclopentadienyl)bis[2,6-difluoro-3-(N-(2,4-dimethylpentyl)-2,2-dimethylbutanoylamino) phenyl]titanium, bis(cyclopentadienyl)bis[2,6-difluoro-3-(2,4-dimethylpentyl)-2,2-dimethylpentanoylamino)ph enyl]titanium, bis(cyclopentadienyl)bis[2,6-difluoro-3-((4-toluyl)amino)phenyl]titanium, bis(cyclopentadienyl)bis[2,6-difluoro-3-(2,2-dimethylpentanoylamino)phenyl]titanium, bis(cyclopentadienyl)bis[2,6-difluoro-3-(2,2-dimethyl-3-ethoxypropanoylamino)phenyl]titaniu m, bis(cyclopentadienyl)bis[2,6-difluoro-3-(2,2-dimethyl-3-allyloxypropanoylamino)phenyl]titan ium, bis(cyclopentadienyl)bis[2,6-difluoro-3-(N-allylacetylamino)phenyl]titanium, bis(cyclopentadienyl)bis[2,6-difluoro-3-(2-ethylbutanoylamino)phenyl]titanium, bis(cyclopentadienyl)bis[2,6-difluoro-3-(N-cyclohexylmethylbenzoylamino)phenyl]titanium, bis(cyclopentadienyl)bis[2,6-difluoro-3-(N-cyclohexylmethyl-(4-toluyl)amino)phenyl]titaniu m, bis(cyclopentadienyl)bis[2,6-difluoro-3-(N-(2-ethylhexyl)benzoylamino)phenyl]titanium, bis(cyclopentadienyl)bis[2,6-difluoro-3-(N-isopropylbenzoylamino)phenyl]titanium, bis(cyclopentadienyl)bis[2,6-difluoro-3-(N-(3-phenylpropyl)-2,2-dimethylpentanoyl)amino)ph enyl]titanium, bis(cyclopentadienyl)bis[2,6-difluoro-3-(N-hexylbenzoylamino)phenyl]titanium, bis(cyclopentadienyl)bis[2,6-difluoro-3-(N-cyclohexylmethyl-2,2-dimethylpentanoyl)amino)p henyl]titanium, bis(cyclopentadienyl)bis[2,6-difluoro-3-(N-butylbenzoylamino)phenyl]titanium, bis(cyclopentadienyl)bis[2,6-difluoro-3-(N-(2-ethylhexyl)-2,2-dimethylpentanoyl)amino)phen yl]titanium, bis(cyclopentadienyl)bis[2,6-difluoro-3-(N-hexyl-2,2-dimethylpentanoylamino)phenyl]titaniu m, bis(cyclopentadienyl)bis[2,6-difluoro-3-(N-isopropyl-2,2-dimethylpentanoylamino)phenyl]tita nium, bis(cyclopentadienyl)bis[2,6-difluoro-3-(N-(3-phenylpropyl)pivaloylamino)phenyl]titanium, bis(cyclopentadienyl)bis[2,6-difluoro-3-(N-butyl-2,2-dimethylpentanoylamino)phenyl]titaniu m, bis(cyclopentadienyl)bis[2,6-difluoro-3-(N-(2-methoxyethyl)benzoylamino)phenyl]titanium, bis(cyclopentadienyl)bis[2,6-difluoro-3-(N-benzylbenzoylamino)phenyl]titanium, bis(cyclopentadienyl)bis[2,6-difluoro-3-(N-benzyl-(4-toluyl)amino)phenyl]titanium,
Bis(cyclopentadienyl)bis[2,6-difluoro-3-(N-(2-methoxyethyl)-(4-toluyl)amino)phenyl]titaniu m, bis(cyclopentadienyl)bis[2,6-difluoro-3-(N-(4-methylphenylmethyl)-2,2-dimethylpentanoylam ino)phenyl]titanium, bis(cyclopentadienyl)bis[2,6-difluoro-3-(N-(2-methoxyethyl)-2,2-dimethylpentanoylamino)ph enyl]titanium, bis(cyclopentadienyl)bis[2,6-difluoro-3-(N-cyclohexylmethyl-(2-ethyl-2-methylheptanoyl)ami no)phenyl]titanium, bis(cyclopentadienyl)bis[2,6-difluoro-3-(N-butyl-(4-chlorobenzoyl)amino)phenyl]titanium, bis(cyclopentadienyl)bis[2,6-difluoro-3-(N-hexyl-(2-ethyl-2-methylbutanoyl)amino)phenyl]tit anium, bis(cyclopentadienyl)bis[2,6-difluoro-3-(N-cyclohexyl-2,2-dimethylpentanoyl)amino)phenyl]t itanium, bis(cyclopentadienyl)bis[2,6-difluoro-3-(N-(oxoran-2-ylmethyl)-2,2-dimethylpentanoyl)amino )phenyl]titanium, bis(cyclopentadienyl)bis[2,6-difluoro-3-(N-cyclohexyl-(4-chlorobenzoyl)amino)phenyl]titaniu m, bis(cyclopentadienyl)bis[2,6-difluoro-3-(N-cyclohexyl-(2-chlorobenzoyl)amino)phenyl]titaniu m, bis(cyclopentadienyl)bis[2,6-difluoro-3-(3,3-dimethyl-2-azetidinon-1-yl)phenyl]titanium, bis(cyclopentadienyl)bis[2,6-difluoro-3-isocyanatophenyl]titanium, bis(cyclopentadienyl)bis[2,6-difluoro-3-(N-ethyl-(4-tolylsulfonyl)amino)phenyl]titanium, bis(cyclopentadienyl)bis[2,6-difluoro-3-(N-hexyl-(4-tolylsulfonyl)amino)phenyl]titanium, bis(cyclopentadienyl)bis[2,6-difluoro-3-(N-butyl-(4-tolylsulfonyl)amino)phenyl]titanium, bis(cyclopentadienyl)bis[2,6-difluoro-3-(N-isobutyl-(4-tolylsulfonyl)amino)phenyl]titanium, bis(cyclopentadienyl)bis[2,6-difluoro-3-(N-butyl-(2,2-dimethyl-3-chloropropanoyl)amino)phe nyl]titanium, bis(cyclopentadienyl)bis[2,6-difluoro-3-(N-(3-phenylpropanoyl)-2,2-dimethyl-3-chloropropan oyl)amino)phenyl]titanium, bis(cyclopentadienyl)bis[2,6-difluoro-3-(N-cyclohexylmethyl-(2,2-dimethyl-3-chloropropanoy l)amino)phenyl]titanium, bis(cyclopentadienyl)bis[2,6-difluoro-3-(N-isobutyl-(2,2-dimethyl-3-chloropropanoyl)phenyl]t itanium, bis(cyclopentadienyl)bis[2,6-difluoro-3-(N-butyl-(2-chloromethyl-2-methyl-3-chloropropanoy l)amino)phenyl]titanium, bis(cyclopentadienyl)bis[2,6-difluoro-3-(butylthiocarbonylamino)phenyl]titanium, bis(cyclopentadienyl)bis[2,6-difluoro-3-(phenylthiocarbonylamino)phenyl]titanium, bis(cyclopentadienyl)bis[2,6-difluoro-3-isocyanatophenyl]titanium, bis(cyclopentadienyl)bis[2,6-difluoro-3-(N-ethyl-(4-tolylsulfonyl)amino)phenyl]titanium, bis(cyclopentadienyl)bis[2,6-difluoro-3-(N-hexyl-(4-tolylsulfonyl)amino)phenyl]titanium, bis(cyclopentadienyl)bis[2,6-difluoro-3-(N-butyl-(4-tolylsulfonyl)amino)phenyl]titanium, bis(cyclopentadienyl)bis[2,6-difluoro-3-(N-isobutyl-(4-tolylsulfonyl)amino)phenyl]titanium, bis(cyclopentadienyl)bis[2,6-difluoro-3-(N-butyl-(2,2-dimethyl-3-chloropropanoyl)amino)phe nyl]titanium,
bis(cyclopentadienyl)bis[2,6-difluoro-3-(N-(3-phenylpropanoyl)-2,2-dimethyl-3-chloropropan oyl)amino)phenyl]titanium, bis(cyclopentadienyl)bis[2,6-difluoro-3-(N-cyclohexylmethyl-(2,2-dimethyl-3-chloropropanoy l)amino)phenyl]titanium, bis(cyclopentadienyl)bis[2,6-difluoro-3-(N-isobutyl-(2,2-dimethyl-3-chloropropanoyl)phenyl]t itanium, bis(cyclopentadienyl)bis[2,6-difluoro-3-(N-butyl-(2-chloromethyl-2-methyl-3-chloropropanoy l)amino)phenyl]titanium, bis(cyclopentadienyl)bis[2,6-difluoro-3-(butylthiocarbonylamino)phenyl]titanium, bis(cyclopentadienyl)bis[2,6-difluoro-3-(phenylthiocarbonylamino)phenyl]titanium, bis(methylcyclopentadienyl)bis[2,6-difluoro-3-(N-hexyl-2,2-dimethylbutanoyl)amino)phenyl]t itanium, bis(methylcyclopentadienyl)bis[2,6-difluoro-3-(N-hexyl-2,2-dimethylpentanoylamino)phenyl] titanium, bis(methylcyclopentadienyl)bis[2,6-difluoro-3-(N-ethylacetylamino)phenyl]titanium, bis(methylcyclopentadienyl)bis[2,6-difluoro-3-(N-ethylpropionylamino)phenyl]titanium, bis(trimethylcyclopentadienyl)bis[2,6-difluoro-3-(N-butyl-2,2-dimethylpropanoylamino)phen yl]titanium, bis(cyclopentadienyl)bis[2,6-difluoro-3-(N-(2-methoxyethyl)-trimethylsilylamino)phenyl]titan ium, bis(cyclopentadienyl)bis[2,6-difluoro-3-(N-butylhexyldimethylsilylamino)phenyl]titanium, bis(cyclopentadienyl)bis[2,6-difluoro-3-(N-ethyl-(1,1,2,-trimethylpropyl)dimethylsilylamino)p henyl]titanium, bis(cyclopentadienyl)bis[2,6-difluoro-3-(3-ethoxymethyl-3-methyl-2-azethiodinon-1-yl)pheny l]titanium, bis(cyclopentadienyl)bis[2,6-difluoro-3-(3-allyloxymethyl-3-methyl-2-azethidmon-1-yl)pheny l]titanium, bis(cyclopentadienyl)bis[2,6-difluoro-3-(3-chloromethyl-3-methyl-2-azetidmon-1-yl)phenyl]ti tanium, bis(cyclopentadienyl)bis[2,6-difluoro-3-(N-benzyl-2,2-dimethylpropanoylamino)phenyl]titani um, bis(cyclopentadienyl)bis[2,6-difluoro-3-(5,5-dimethyl-2-pyrrolidinon-1-yl)phenyl]titanium, bis(cyclopentadienyl)bis[2,6-difluoro-3-(6,6-diphenyl-2-piperidinon-1-yl)phenyl]titanium, bis(cyclopentadienyl)bis[2,6-difluoro-3-(N-(2,3-dihydro-1,2-benzothiazol-3-on(1,1-dioxido)-2 -yl)phenyl]titanium, bis(cyclopentadienyl)bis[2,6-difluoro-3-(N-hexyl-(4-chlorobenzoyl)amino)phenyl]titanium,
bis(cyclopentadienyl)bis[2,6-difluoro-3-(N-hexyl-(2-chlorobenzoyl)amino)phenyl]titanium, bis(cyclopentadienyl)bis[2,6-difluoro-3-(N-isopropyl-(4-chlorobenzoyl)amino)phenyl]titaniu m, bis(cyclopentadienyl)bis[2,6-difluoro-3-(N-(4-methylphenylmethyl)-(4-chlorobenzoyl)amino) phenyl]titanium, bis(cyclopentadienyl)bis[2,6-difluoro-3-(N-(4-methylphenylmethyl)-(2-chlorobenzoyl)amino) phenyl]titanium, bis(cyclopentadienyl)bis[2,6-difluoro-3-(N-butyl-(4-chlorobenzoyl)amino)phenyl]titanium, bis(cyclopentadienyl)bis[2,6-difluoro-3-(N-benzyl-2,2-dimethylpentanoylamino)phenyl]titani um, bis(cyclopentadienyl)bis[2,6-difluoro-3-(N-(2-ethylhexyl)-4-tolyl-sulfonyl)amino)phenyl]titan ium, bis(cyclopentadienyl)bis[2,6-difluoro-3-(N-(3-oxaheptyl)benzoylamino)phenyl]titanium, bis(cyclopentadienyl)bis[2,6-difluoro-3-(N-(3,6-dioxadecyl)benzoylamino)phenyl]titanium, bis(cyclopentadienyl)bis[2,6-difluoro-3-(trifluoromethylsulfonyl)amino)phenyl]titanium, bis(cyclopentadienyl)bis[2,6-difluoro-3-(trifluoroacetylamino)phenyl]titanium, bis(cyclopentadienyl)bis[2,6-difluoro-3-(2-chlorobenzoyl)amino)phenyl]titanium, bis(cyclopentadienyl)bis[2,6-difluoro-3-(4-chlorobenzoyl)amino)phenyl]titanium, bis(cyclopentadienyl)bis[2,6-difluoro-3-(N-(3,6-dioxadecyl)-2,2-dimethylpentanoylamino)phenyl]titanium, bis(cyclopentadienyl)bis[2,6-difluoro-3-(N-(3,7-dimethyl-7-methoxyoctyl)benzoylamino)phen yl]titanium, bis(cyclopentadienyl)bis[2,6-difluoro-3-(N-cyclohexylbenzoylamino)phenyl]titanium, and the like.

In addition, among the organotitanium compounds or the like, the following compounds can also be used as the organic compound containing a zirconium atom or the compound containing a hafnium atom: (cyclopentadienyl)trimethyl zirconium, (cyclopentadienyl)triphenyl zirconium, (cyclopentadienyl)tribenzyl zirconium, (cyclopentadienyl)trichloro zirconium, (cyclopentadienyl)trimethoxy zirconium, (cyclopentadienyl)dimethyl(methoxy) zirconium, (cyclopentadienyl)methyldichloro zirconium, (methylcyclopentadienyl)trimethyl zirconium, (methylcyclopentadienyl)triphenyl zirconium, (methylcyclopentadienyl)tribenzyl zirconium, (methylcyclopentadienyl)trichloro zirconium, (methylcyclopentadienyl)dimethyl(methoxy) zirconium, (dimethylcyclopentadienyl)trimethyl zirconium, (trimethylcyclopentadienyl)trimethyl zirconium, (trimethylsilylcyclopentadienyl)trimethyl zirconium, (tetramethylcyclopentadiethyl)trimethyl zirconium, (pentamethylcyclopentadienyl)trimethyl zirconium, (pentamethylcyclopentadienyl)triphenyl zirconium, (pentamethylcyclopentadienyl)tribenzyl zirconium, (pentamethylcyclopentadienyl)trichloro zirconium, (pentamethylcyclopentadienyl)trimethoxy zirconium, (pentamethylcyclopentadienyl) dimethyl(methoxy) zirconium, (cyclopentadienyl)triethyl zirconium, (cyclopentadienyl)tripropyl zirconium, (cyclopentadienyl)trineopentyl zirconium, (cyclopentadienyl)tri(diphenylmethyl) zirconium, (cyclopentadienyl)dimethylhydrido zirconium, (cyclopentadienyl)triethoxy zirconium, (cyclopentadienyl)triisopropoxy zirconium, (cyclopentadienyl)triphenoxy zirconium, (cyclopentadienyl)dimethylisopropoxy zirconium, (cyclopentadienyl)diphenylisopropoxy zirconium, (cyclopentadienyl)dimethoxychloro zirconium, (cyclopentadienyl)methoxydichloro zirconium, (cyclopentadienyl)diphenoxychloro zirconium, (cyclopentadienyl)phenoxydichloro zirconium, (cyclopentadienyl)tri(phenyldimethylsilyl) zirconium, (n-butylcyclopentadienyl)dimethyl n-butoxy zirconium, (benzylcyclopentadienyl)di m-tolyl methyl zirconium, (trifluoromethylcyclopentadienyl)tribenzyl zirconium, (diphenylcyclopentadienyl)dinorbornylmethyl zirconium, (tetraethylcyclopentadienyl)tribenzyl zirconium, (pentamethylsilylcyclopentadienyl)tribenzyl zirconium, (pentamethylcyclopentadienyl)trineopentyl zirconium, (pentamethylcyclopentadienyl)methyldichloro zirconium, (pentamethylcyclopentadienyl)triethoxy zirconium, (pentamethylcyclopentadienyl)triphenoxy zirconium, (pentamethylcyclopentadienyl)methoxydichloro zirconium, (pentamethylcyclopentadienyl)diphenoxychloro zirconium, (pentamethylcyclopentadienyl)phenoxydichloro zirconium, (indenyl)trimethyl zirconium, (indenyl)tribenzyl zirconium, (indenyl)trichloro zirconium, (indenyl)trimethoxy zirconium,
(indenyl)triethoxy zirconium, bis(cyclopentadienyl)dimethyl zirconium, bis(cyclopentadienyl)diphenyl zirconium, bis(cyclopentadienyl)diethyl zirconium, bis(cyclopentadienyl)dibenzyl zirconium, bis(cyclopentadienyl)dimethoxy zirconium, bis(cyclopentadienyl)dichloro zirconium, bis(cyclopentadienyl)dihydrido zirconium, bis(cyclopentadienyl)chlorohydrido zirconium, bis(methylcyclopentadienyl)dimethyl zirconium, bis(methylcyclopentadienyl)dibenzyl zirconium, bis(methylcyclopentadienyl)dichloro zirconium, bis(pentamethylcyclopentadienyl)dimethyl zirconium, bis(pentamethylcyclopentadienyl)dibenzyl zirconium, bis(pentamethylcyclopentadienyl)dichloro zirconium, bis(pentamethylcyclopentadienyl)chloromethyl zirconium, bis(pentamethylcyclopentadienyl)hydridomethyl zirconium, (cyclopentadienyl) (pentamethylcyclopentadienyl)dimethyl zirconium, bis(cyclopentadienyl)dineopentyl zirconium, bis(cyclopentadienyl)di m-tolyl zirconium, bis(cyclopentadienyl)di p-tolyl zirconium, bis(cyclopentadienyl)bis(diphenylmethyl) zirconium, bis(cyclopentadienyl)dibromo zirconium, bis(cyclopentadienyl)methylchloro zirconium, bis(cyclopentadienyl)ethylchloro zirconium, bis(cyclopentadienyl)cyclohexylchloro zirconium, bis(cyclopentadienyl)phenylchloro zirconium, bis(cyclopentadienyl)benzylchloro zirconium, bis(cyclopentadienyl)hydridomethyl zirconium, bis(cyclopentadienyl)methoxychloro zirconium,
bis(cyclopentadienyl)ethoxychloro zirconium, bis(cyclopentadienyl)(trimethylsilyl)methyl zirconium, bis(cyclopentadienyl)bis(trimethylsilyl) zirconium, bis(cyclopentadienyl)(triphenylsilyl)methyl zirconium, bis(cyclopentadienyl)(tris(dimethylsilyl)silyl)methyl zirconium, bis(cyclopentadienyl) (trimethylsilyl)(trimethylsilylmethyl) zirconium, bis(methylcyclopentadienyl)diphenyl zirconium, bis(ethylcyclopentadienyl)dimethyl zirconium, bis(ethylcyclopentadienyl)dichloro zirconium, bis(propylcyclopentadienyl)dimethyl zirconium, bis(propylcyclopentadienyl)dichloro zirconium, bis(n-butylcyclopentadienyl)dichloro zirconium, bis(t-butylcyclopentadienyl)bis(trimethylsilyl) zirconium, bis(hexylcyclopentadienyl)dichloro zirconium, bis(cyclohexylcyclopentadienyl)dimethyl zirconium, bis(dimethylcyclopentadienyl)dimethyl zirconium, bis(dimethylcyclopentadienyl)dichloro zirconium, bis(dimethylcyclopentadienyl)ethoxychloro zirconium, bis(ethylmethylcyclopentadiethyl)dichloro zirconium, bis(propylmethylcyclopentadienyl)dichloro zirconium, bis(butylmethylcyclopentadienyl)dichloro zirconium, bis(trimethylcyclopentadienyl)dichloro zirconium, bis(tetramethylcyclopentadienyl)dichloro zirconium, bis(cyclohexylmethylcyclopentadienyl)dibenzyl zirconium, bis(trimethylsilylcyclopentadienyl)dimethyl zirconium, bis(trimethylsilylcyclopentadienyl) dichloro zirconium, bis(trimethylgermylcyclopentadienyl)dimethyl zirconium, bis(trimethylgermylcyclopentadienyl)diphenyl zirconium, bis(trimethylstannylcyclopentadienyl)dimethyl zirconium, bis(trimethylstannylcyclopentadienyl)dibenzyl zirconium, bis(trifluoromethylcyclopentadienyl)dimethyl zirconium, bis(trifluoromethylcyclopentadienyl)dinorbornyl zirconium, bis(indenyl)dibenzyl zirconium, bis(indenyl)dichloro zirconium, bis(indenyl)dibromo zirconium, bis(tetrahydroindenyl)dichloro zirconium, bis(fluorenyl)dichloro zirconium, (propylcyclopentadienyl)(cyclopentadienyl)dimethyl zirconium, (cyclohexylmethylcyclopentadienyl)(cyclopentadienyl)dibenzyl zirconium, (pentatrimethylsilylcyclopentadienyl)(cyclopentadienyl)dimethyl zirconium, (trifluoromethylcyclopentadienyl)(cyclopentadienyl)dimethyl zirconium, ethylene bis(indenyl)dimethyl zirconium, ethylene bis(indenyl)dichloro zirconium, ethylene bis(tetrahydroindenyl)dimethyl zirconium, ethylene bis(tetrahydroindenyl)dichloro zirconium, dimethylsilylene bis(cyclopentadienyl)dimethyl zirconium, dimethylsilylene bis(cyclopentadienyl)dichloro zirconium, isopropylidene (cyclopentadienyl)(9-fluorenyl)dimethyl zirconium, isopropylidene (cyclopentadienyl)(9-fluorenyl)dichloro zirconium, [phenyl(methyl)methylene] (9- fluorenyl)(cyclopentadienyl)dimethyl zirconium, diphenylmethylene(cyclopentadienyl)(9-fluorenyl)dimethyl zirconium, ethylene (9-fluorenyl)(cyclopentadienyl)dimethyl zirconium, cyclohexylidene(9-fluorenyl) (cyclopentadienyl)dimethyl zirconium, cyclopentylidene (9-fluorenyl)(cyclopentadienyl)dimethyl zirconium, cyclobutylidene (9-fluorenyl)(cyclopentadienyl)dimethyl zirconium, dimethylsilylene (9-fluorenyl)(cyclopentadienyl)dimethyl zirconium, dimethylsilylenebis(2,3,5-trimethylcyclopentadienyl)dimethyl zirconium, dimethylsilylenebis(2,3,5-trimethylcyclopentadienyl)dichloro zirconium, dimethylsilylenebis(indenyl)dichloro zirconium, methylenebis(cyclopentadienyl)dimethyl zirconium, methylenebis(cyclopentadienyl)di(trimethylsilyl) zirconium,
methylene (cyclopentadienyl)(tetramethylcyclopentadienyl)dimethyl zirconium, methylene (cyclopentadienyl)(fluorenyl)dimethyl zirconium, ethylenebis(cyclopentadienyl)dimethyl zirconium, ethylenebis(cyclopentadienyl)dibenzyl zirconium, ethylenebis(cyclopentadienyl)dihydrido zirconium, ethylenebis(indenyl)diphenyl zirconium, ethylenebis(indenyl)methylchloro zirconium, ethylenebis(tetrahydroindenyl)dibenzyl zirconium, isopropylidene(cyclopentadienyl)(methylcyclopentadienyl)dichloro zirconium, isopropylidene (cyclopentadienyl)(octahydrofluorenyl)dihydrido zirconium, dimethylsilylenebis(cyclopentadienyl)dineopentyl zirconium, dimethylsilylenebis(cyclopentadienyl)dihydrido zirconium, dimethylsilylenebis(methylcyclopentadienyl)dichloro zirconium, dimethylsilylenebis(dimethylcyclopentadienyl)dichloro zirconium, dimethylsilylenebis(tetrahydroindenyl)dichloro zirconium, dimethylsilylene(cyclopentadienyl)(fluorenyl)dichloro zirconium, dimethylsilylene(cyclopentadienyl)(fluorenyl)dihydrido zirconium, dimethylsilylene(methylcyclopentadienyl)(fluorenyl)dihydrido zirconium, dimethylsilylenebis(3-trimethylsilylcyclopentadientyl)dihydrido zirconium, dimethylsilylenebis(indenyl)dimethyl zirconium, diphenylsilylenebis(indenyl)dichloro zirconium, phenylmethylsilylenebis(indenyl)dichloro zirconium, compounds obtained by substituting zirconium atoms in these compounds with hafnium atoms, and the like.

A content of the organotitanium compound or the like is preferably 0.1% to 30% by mass with respect to a total solid content of the composition of the present invention. A lower limit thereof is more preferably 1.0% by mass or higher, even more preferably 1.5% by mass or higher, and particularly preferably 3.0% by mass or higher. An upper limit thereof is more preferably 25% by mass or lower.

For the organotitanium compound or the like, one type or two or more types can be used. In a case where two or more types are used, a total amount is preferably within the above-mentioned range.

In addition, in the composition of the present invention, a mass ratio of a content of the organotitanium compound or the like to a content of the thermal-base generator is preferably 100:1 to 1:100, more preferably 90:10 to 10:90, and even more preferably 40:60 to 20:80. By setting the mass ration to be within such a range, it is possible to achieve a higher ring closure rate at a low temperature and a higher glass transition temperature for the heterocyclic ring-containing polymer precursor.

### <<Radical polymerization initiator>>

The composition of the present invention contains a photo-radical polymerization initiator is preferable.

There may be a case where an organotitanium compound or the like in the present invention has a radical polymerization initiating ability. In such a case, in the present invention, the organotitanium compound or the like is treated as an organotitanium compound or the like.

In addition, in a case where an organotitanium compound or the like having a radical polymerization initiating ability is used in the composition of the present invention, it is also preferable that the composition of the present invention contains substantially no radical polymerization initiator. "Containing substantially no radical polymerization initiator" means that a content of the radical polymerization initiator is 5% by mass or lower of a content of the organotitanium compound or the like contained in the composition of the present invention, with 3% by mass being preferable, 1% by mass or lower being more preferable, and 0.1% by mass being even more preferable.

In addition, in a case where an organotitanium compound or the like having no radical polymerization initiating ability is used in the composition of the present invention, it is preferable to use the organotitanium compound or the like in combination with the radical polymerization initiator.

Here, "having radical polymerization initiating ability" means being capable of generating free radicals that can initiate radical polymerization. For example, with respect to a resin composition that contains a radically polymerizable monomer, a binder polymer, and an organotitanium compound or the like, at the time of being irradiated with light at a wavelength range in which the organotitanium compound or the like absorbs light and the radically polymerizable monomer does not absorb light, it can be confirmed whether or not disappearance of the radically polymerizable monomer occurs. In order to confirm whether the disappearance occurs, an appropriate method can be selected depending on types of the radically polymerizable monomer and the binder polymer, and confirmation can be generally made by infrared spectroscopy measurement (IR measurement) or high performance liquid chromatography (HPLC measurement).

### <<<Photo-radical polymerization initiator>>>

The photo-radical polymerization initiator that is used in the present invention is an oxime compound. A photo-radical polymerization initiator having photosensitivity to rays ranging from an ultraviolet ray region to a visible region is preferable. In addition, the photo-radical polymerization initiator may be an activator which produces an active radical by some action with a photo-excited sensitizer.

The photo-radical polymerization initiator preferably contains at least one compound having a molar extinction coefficient of at least about 50 within a range of about 300 to 800 nm (preferably 330 to 500 nm). The molar extinction coefficient of the compound can be measured using a known method. For example, it is preferable to perform measurement at a concentration of 0.01 g/L using an ethyl acetate solvent with an ultraviolet-visible spectrophotometer (Cary-5 spectrophotometer manufactured by Varian).

Due to the fact that the composition of the present invention contains the photo-radical polymerization initiator, in a case where the composition of the present invention is applied to a substrate such as a semiconductor wafer to form a photosensitive resin composition layer, and then irradiated with light to cause curing to occur due to radicals, so that solubility in a light-irradiated portion can be decreased. Therefore, there is an advantage that for example, by exposing the photosensitive resin composition layer through a photomask having a pattern for masking only an electrode portion, a region having different solubility can be conveniently manufactured according to a pattern of the electrode.

As the photo-radical polymerization initiator, an oxime compound such as an oxime derivative is mentioned. With regard to details thereof, reference can be made to the description of paragraphs 0165 to 0182 of JP2016-027357A.

As the photo-radical polymerization initiator, an oxime compound is used. By using the oxime compound, exposure latitude can be more effectively improved. The oxime compound is particularly preferable because the oxime compound has wide exposure latitude (exposure margin) and also works as a photo-base generator.

As specific examples of the oxime compound, the compounds described in JP2001-233842A, the compounds described in JP2000-080068A, and the compounds described in JP2006-342166A can be used.

As examples of preferable oxime compounds, compounds having the following structures, 3-benzooxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-(4-toluenesulfonyloxy)iminobutan-2-one, 2-ethoxycarbonyloxyimino-1-phenylpropan-1-one, and the like are mentioned.

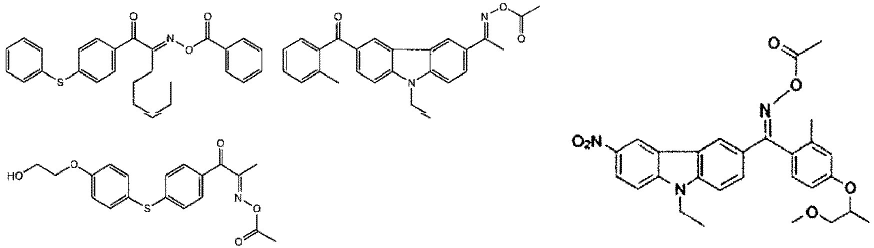

As commercially available products, IRGACURE OXE 01, IRGACURE OXE 02, IRGACURE OXE 03, IRGACURE OXE 04 (all manufactured by BASF), ADEKA OPTOMER N-1919 (manufactured by ADEKA Corporation, Photo-radical polymerization initiator 2 described in JP2012-014052A) are also suitably used. In addition, TR-PBG-304 (manufactured by Changzhou Tronly New Electronic Materials Co., Ltd.), ADEKA ARKLS NCI-831, and ADEKA ARKLS NCI-930 (manufactured by ADEKA Corporation) can also be used. In addition, DFI-091 (manufactured by Daito Chemix Co., Ltd.) can be used.

Furthermore, it is also possible to use an oxime compound having a fluorine atom. As specific examples of such an oxime compound, the compounds described in JP2010-262028A, Compounds 24 and 36 to 40 described in paragraph 0345 of JP2014-500852A, Compound (C-3) described in paragraph 0101 of JP2013-164471A are mentioned.

As the most preferable oxime compounds, oxime compounds having a specific substituent disclosed in JP2007-269779A, oxime compounds having a thioaryl group disclosed in JP2009-191061A, and the like are mentioned, the contents of which are incorporated herein.

From the viewpoint of exposure sensitivity, the photo-radical polymerization initiator is an oxime compound.

### <<<Thermal-radical polymerization initiator>>>

The thermal-radical polymerization initiator is a compound which generates radicals by heat energy and initiates or promotes a polymerization reaction of a compound having polymerization properties. By adding the thermal-radical polymerization initiator, a polymerization reaction of the heterocyclic ring-containing polymer precursor can proceed together with cyclization of the heterocyclic ring-containing polymer precursor. Thus, a higher degree of heat resistance can be achieved.

As the thermal-radical polymerization initiator, specifically, the compounds described in paragraphs 0074 to 0118 of JP2008-063554A are mentioned.

A content of the radical polymerization initiator is preferably 0.1% to 30% by mass, more preferably 0.1% to 20% by mass, and even more preferably 5% to 15% by mass, with respect to a total solid content of the composition of the present invention. For the radical polymerization initiator, one type may be contained, or two or more types may be contained. In a case where two or more types of radical polymerization initiators are contained, a total thereof is preferably within the above-mentioned range.

### «Solvent»

The composition of the present invention preferably contains a solvent. As the solvent, a known solvent can be optionally used. The solvent is preferably an organic solvent. As the organic solvent, compounds such as esters, ethers, ketones, aromatic hydrocarbons, sulfoxides, and amides are mentioned.

As the esters, for example, ethyl acetate, n-butyl acetate, isobutyl acetate, isoamyl formate, isoamyl acetate, butyl propionate, isopropyl butyrate, ethyl butyrate, butyl butyrate, methyl lactate, ethyl lactate, γ-butyrolactone, ε-caprolactone, δ-valerolactone, alkyl alkyloxyacetate (for example, methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (for example, methyl 3-alkyloxypropionate, and ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (for example, methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methylpropionate and ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, and ethyl 2-oxobutanoate are suitably mentioned.

As the ethers, for example, diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, and propylene glycol monopropyl ether acetate are suitably mentioned.

As the ketones, for example, methyl ethyl ketone, cyclohexanone, cyclopentanone, 2-heptanone, and 3-heptanone are suitably mentioned.

As the aromatic hydrocarbons, for example, toluene, xylene, anisole, and limonene are suitably mentioned.

As the sulfoxides, for example, dimethyl sulfoxide is suitably mentioned.

As the amides, N-methyl-2-pyrrolidone, N-ethyl-2-pyrrolidone, N,N-dimethylacetamide, N,N-dimethylformamide, and the like are suitably mentioned.

From the viewpoint of improving properties of a coated surface or the like, it is also preferable to mix two or more types of solvents. Among these, a mixed solution composed of two or more selected from methyl 3-ethoxypropionate, ethyl 3-ethoxypropionate, ethylcellosolve acetate, ethyl lactate, diethylene glycol dimethyl ether, butyl acetate, methyl 3-methoxypropionate, 2-heptanone, cyclohexanone, cyclopentanone, γ-butyrolactone, dimethyl sulfoxide, ethyl carbitol acetate, butyl carbitol acetate, propylene glycol methyl ether, and propylene glycol methyl ether acetate is preferable. A combination of dimethyl sulfoxide and γ-butyrolactone is particularly preferable.

From the viewpoint of coatability, a content of the solvent is preferably such that a total concentration of solid contents of the composition of the present invention is 5% to 80% by mass, with 5% to 70% by mass being more preferable, and 10% to 60% by mass being particularly preferable. The content of the solvent may be adjusted depending on a desired thickness and a coating method. For example, in a case where the coating method is spin coating or slit coating, the content of the solvent which causes the concentration of solid contents within the above-mentioned range is preferable. In a case of spray coating, the solvent has an amount which causes preferably 0.1% by mass to 50% by mass, and more preferably 1.0% by mass to 25% by mass. By adjusting the amount of solvent depending on the coating method, it is possible to uniformly form a photosensitive resin composition layer having a desired thickness.

For the solvent, one type may be contained, or two or more types may be contained. In a case where two or more types of solvents are contained, a total thereof is preferably within the above-mentioned range.

### «Radically polymerizable compound»

The composition of the present invention preferably contains a radically polymerizable compound (hereinafter also referred to as "polymerizable monomer"). By adopting such a constitution, a cured film which is excellent in heat resistance can be formed.

As the polymerizable monomer, a compound having a radically polymerizable group can be used. As the radically polymerizable group, a group having an ethylenically unsaturated bond such as a styryl group, a vinyl group, a (meth)acryloyl group, and an allyl group is mentioned. The radically polymerizable group is preferably a (meth)acryloyl group.

The polymerizable monomer may have one radically polymerizable group or two or more radically polymerizable groups. The polymerizable monomer preferably has two or more radically polymerizable groups, and more preferably three or more radically polymerizable groups. An upper limit thereof is preferably 15 or lower, more preferably 10 or lower, and even more preferably 8 or lower.

A molecular weight of the polymerizable monomer is preferably 2,000 or lower, more preferably 1,500 or lower, and even more preferably 900 or lower. A lower limit of the molecular weight of the polymerizable monomer is preferably 100 or higher.

From the viewpoint of developability, the composition of the present invention preferably contains at least one bi- or higher-functional polymerizable monomer containing two or more polymerizable groups, and more preferably contains at least one tri- or higher-functional polymerizable monomer. In addition, the polymerizable monomer may be a mixture of a bifunctional polymerizable monomer and a tri- or higher-functional polymerizable monomer. The number of functional groups in the polymerizable monomer means the number of radically polymerizable groups in one molecule.

Specific examples of the polymerizable monomer include unsaturated carboxylic acids (for example, acrylic acid, methacrylic acid, itaconic acid, crotonic acid, isocrotonic acid, maleic acid), and esters and amides thereof, and are preferably esters of saturated carboxylic acids with polyhydric alcohol compounds, and amides of unsaturated carboxylic acids with polyamine compounds. In addition, addition reaction products of unsaturated carboxylic acid esters or amides having a nucleophilic substituent such as a hydroxyl group, an amino group, and a mercapto group, with monofunctional or polyfunctional isocyanates or epoxies, dehydration condensation reaction products thereof with monofunctional or polyfunctional carboxylic acids, and the like are also suitably used. In addition, addition reaction products of unsaturated carboxylic acid esters or amides having an electrophilic substituent such as an isocyanate group and an epoxy group, with monofunctional or polyfunctional alcohols, amines, or thiols, and substitution reaction products of unsaturated carboxylic acid esters or amides having a leaving substituent such as a halogen group and a tosyloxy group with monofunctional or polyfunctional alcohols, amines, or thiols are also suitable. In addition, as another example, it is also possible to use a group of compounds in which the unsaturated carboxylic acid is substituted with an unsaturated phosphonic acid, a vinylbenzene derivative such as styrene, vinyl ether, allyl ether, or the like. As specific examples, reference can be made to the description of paragraphs 0113 to 0122 of JP2016-027357A.

In addition, the polymerizable monomer is also preferably a compound having a boiling point of 100°C or higher under atmospheric pressure. As examples thereof, compounds obtained by adding ethylene oxide or propylene oxide to a polyfunctional alcohol such as polyethylene glycol di(meth)acrylate, trimethylolethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol (meth)acrylate, trimethylolpropane tri(acryloyloxypropyl)ether, tri(acryloyloxyethyl)isocyanurate, glycerin, and trimethylolethane, and then being subjected to (meth)acrylation, the urethane (meth)acrylates as described in JP1973-041708B (JP-S48-041708B), JP1975-6034B (JP-S50-6034B), and JP1976-037193A (JP-S51-037193A), polyester acrylates described in JP1973-064183A (JP-S48-064183A), JP1974-043191B (JP-S49-043191B), and JP1977-030490B (JP-S52-030490B), polyfunctional acrylates or methacrylates such as epoxy acrylates which are reaction products of epoxy resins and (meth)acrylic acids, and mixtures thereof can be mentioned. In addition, the compounds described in paragraphs 0254 to 0257 of JP2008-292970A are also suitable. In addition, polyfunctional (meth)acrylates obtained by reacting polyfunctional carboxylic acids with compounds having a cyclic ether group such as glycidyl (meth)acrylate and an ethylenically unsaturated group can be mentioned.

In addition, as other preferable polymerizable monomers, compounds having two or more groups containing a fluorene ring and an ethylenically unsaturated bond which are described in JP2010-160418A, JP2010-129825A, and Japanese Patent No. 4364216, and cardo resins can also be used.

Furthermore, as other examples, the specific unsaturated compounds described in JP1971-043946B (JP-S46-043946B), JP1989-040337B (JP-H1-040337B), and JP1989-040336B (JP-H1-040336B), the vinylphosphonic acid-based compounds described in JP1990-025493A (JP-H2-025493A), and the like can also be mentioned. In addition, the compounds containing a perfluoroalkyl group described in JP1986-022048A (JP-S61-022048A) can also be used. Furthermore, the compounds introduced as photo-polymerizable monomers and oligomers in the Journal of Adhesion Society of Japan, Vol. 20, No. 7, pp. 300 to 308 (1984) can also be used.

In addition to the above, the compounds described in paragraphs 0048 to 0051 of JP2015-034964A can also be preferably used.

In addition, the compounds which are described in JP1998-062986A (JP-H10-062986A) as Formulas (1) and (2) as well as specific examples thereof and are obtained by adding ethylene oxide or propylene oxide to a polyfunctional alcohol and then being subjected to (meth)acrylation can be used as the polymerizable monomer.

Furthermore, the compounds described in paragraphs 0104 to 0131 of JP2015-187211A can also be used as the polymerizable monomer.

As the polymerizable monomer, dipentaerythritol triacrylate (commercially available as KAYARAD D-330; manufactured by Nippon Kayaku Co., Ltd.), dipentaerythritol tetraacrylate (commercially available as KAYARAD D-320; Nippon Kayaku Co., Ltd., A-TMMT: manufactured by Shin-Nakamura Chemical Co., Ltd.), dipentaerythritol penta (meth)acrylate (commercially available as KAYARAD D-310; manufactured by Nippon Kayaku Co., Ltd.), dipentaerythritol hexa (meth)acrylate (commercially available as KAYARAD DPHA; by Nippon Kayaku Co., Ltd., A-DPH; manufactured by Shin-Nakamura Chemical Co., Ltd.), and structures in which (meth)acryloyl groups thereof are bonded via ethylene glycol or propylene glycol residues are preferable. Oligomer types thereof can also be used.

As commercially available products of the polymerizable monomer, for example, SR-494 which is a tetrafunctional acrylate having four ethyleneoxy chains, manufactured by Sartomer, SR-209 which is a bifunctional methacrylate having four ethyleneoxy chains, manufactured by Sartomer, DPCA-60 which is a hexafunctional acrylate having six pentyleneoxy chains, manufactured by Nippon Kayaku Co., Ltd., TPA-330 which is a trifunctional acrylate having three isobutylene oxy chains, urethane oligomers UAS-10, UAB-140 (manufactured by Sanyo-Kokusaku Pulp Co., Ltd.), NK Ester M-40G, NK Ester 4G, NK Ester M-9300, NK Ester A-9300, UA-7200 (manufactured by Shin-Nakamura Chemical Co., Ltd.), DPHA-40H (manufactured by Nippon Kayaku Co., Ltd.), UA-306H, UA-306T, UA-306I, AH-600, T-600, AI-600 (manufactured by Kyoeisha Chemical Co., Ltd.), Brenmer PME400 (manufactured by NOF Corporation), and the like are mentioned.

As the polymerizable monomer, the urethane acrylates as described in JP1973-041708B (JP-S48-041708B), JP1976-037193A (JP-S51-037193A), JP1990-032293B (JP-H2-032293B), and JP1990-016765B (JP-H2-016765B), and the urethane compounds having an ethylene oxide-based skeleton described in JP1983-049860B (JP-S58-049860B), JP1981-049860B (JP-S56-017654B), JP1987-039417B (JP-S62-039417B), and JP1987-039418B (JP-S62-039418B) are also suitable. Furthermore, as the polymerizable monomer, the compounds having an amino structure or a sulfide structure in a molecule as described in JP1988-277653A (JP-S63-277653A), JP1988-260909A (JP-S63-260909A), and JP1989-105238A (JP-H1-105238A) can also be used.

The polymerizable monomer may be a polymerizable monomer having an acid group such as a carboxyl group, a sulfo group, and a phosphoric acid group. The polymerizable monomer having an acid group is preferably ester of an aliphatic polyhydroxy compound and an unsaturated carboxylic acid, and more preferably a polymerizable monomer obtained by reacting an unreacted hydroxyl group of an aliphatic polyhydroxy compound with a non-aromatic carboxylic acid anhydride so as to have an acid group. Particularly preferably, the polymerizable monomer is a polymerizable monomer having an acid group obtained by reacting an unreacted hydroxyl group of an aliphatic polyhydroxy compound with a non-aromatic carboxylic acid anhydride so as to have an acid group, in which the aliphatic polyhydroxy compound is pentaerythritol and/or dipentaerythritol. As commercially available products thereof, for example, M-510 and M-520 as polybasic acid-modified acrylic oligomers which are manufactured by Toagosei Co., Ltd are mentioned.

For the polymerizable monomer having an acid group, one type may be used alone, or two or more types may be used in admixture. In addition, if necessary, a polymerizable monomer having no acid group and a polymerizable monomer having an acid group may be used in combination.

An acid value of the polymerizable monomer having an acid group is preferably 0.1 to 40 mg KOH/g, and particularly preferably 5 to 30 mg KOH/g. In a case where the acid value of the polymerizable monomer is within the above-mentioned range, excellent production and handling properties are exhibited, and furthermore, excellent developability is exhibited. In addition, good polymerization properties are exhibited.

From the viewpoints of good polymerization properties and heat resistance, a content of the polymerizable monomer is preferably 1% to 50% by mass with respect to a total solid content of the composition of the present invention. A lower limit thereof is more preferably 5% by mass or higher. An upper limit thereof is more preferably 30% by mass or lower. For the polymerizable monomer, one type may be used alone, or two or more types may be used in admixture.

In addition, a mass ratio (heterocyclic ring-containing polymer precursor/polymerizable monomer) of the heterocyclic ring-containing polymer precursor to the polymerizable monomer is preferably 98/2 to 10/90, more preferably 95/5 to 30/70, and most preferably 90/10 to 50/50. In a case where the mass ratio of the heterocyclic ring-containing polymer precursor to the polymerizable monomer is within the above-mentioned range, a cured film which is excellent in polymerization properties and heat resistance can be formed.

In the composition of the present invention, from the viewpoint of suppressing warping due to control of a modulus of elasticity of a cured film, a monofunctional polymerizable monomer can be preferably used. As the monofunctional polymerizable monomer, (meth)acrylic acid derivatives such as n-butyl (meth)acrylate, 2-ethylhexyl (meth)acrylate, 2-hydroxyethyl (meth)acrylate, butoxyethyl (meth)acrylate, carbitol (meth)acrylate, cyclohexyl (meth)acrylate, benzyl (meth)acrylate, phenoxyethyl (meth)acrylate, N-methylol (meth)acrylamide, glycidyl (meth)acrylate, polyethylene glycol mono (meth)acrylate, and polypropylene glycol mono (meth)acrylate, N-vinyl compounds such as N-vinylpyrrolidone and N-vinylcaprolactam, allyl compounds such as allyl glycidyl ether, diallyl phthalate, and triallyl trimellitate, and the like are preferably used. As the monofunctional polymerizable monomer, a compound having a boiling point of 100°C or higher under atmospheric pressure is also preferable in order to suppress volatilization before exposure.

### <<Other polymerizable compounds>>

The composition of the present invention may further contain other polymerizable compounds than the heterocyclic ring-containing polymer precursor and the radically polymerizable compound as described above. As the other polymerizable compounds, a compound having a hydroxymethyl group, an alkoxymethyl group, or an acyloxymethyl group; an epoxy compound; an oxetane compound; and a benzoxazine compound are mentioned.

### (Compound having hydroxymethyl group, alkoxymethyl group, or acyloxymethyl group)

The compound having a hydroxymethyl group, an alkoxymethyl group, or an acyloxymethyl group is preferably a compound represented by Formula (AM1).

R⁴(̵CH₂-R⁵)ₜ (AM1)

(In the formula, t represents an integer of 1 to 20, R⁴ represents a t-valent organic group having 1 to 200 carbon atoms, R⁵ represents a group represented by -OR⁶ or -OCO-R⁷, R⁶ represents a hydrogen atom or an organic group having 1 to 10 carbon atoms, and R⁷ represents an organic group having 1 to 10 carbon atoms.)

A content of the compound represented by Formula (AM1) is preferably 5 to 40 parts by mass with respect to 100 parts by mass of the heterocyclic ring-containing polymer precursor. The content is more preferably 10 to 35 parts by mass. In addition, in the entire amount of the other polymerizable compounds, it is preferable that a compound represented by Formula (AM4) is contained in an amount of 10% to 90% by mass and a compound represented by Formula (AM5) is contained in an amount of 10% to 90% by mass.

R⁴(̵CH₂-R⁵)₂ (AM4)

(In the formula, R⁴ represents a divalent organic group having 1 to 200 carbon atoms, R⁵ represents a group represented by -OR⁶ or -OCO-R⁷, R⁶ represents a hydrogen atom or an organic group having 1 to 10 carbon atoms, and R⁷ represents an organic group having 1 to 10 carbon atoms.)

R⁴(̵CH₂-R⁵)ᵤ (AM5)

(In the formula, u represents an integer of 3 to 8, R⁴ represents a u-valent organic group having 1 to 200 carbon atoms, R⁵ represents a group represented by -OR⁶ or -OCO-R⁷, R⁶ represents a hydrogen atom or an organic group having 1 to 10 carbon atoms, and R⁷ represents an organic group having 1 to 10 carbon atoms.)

By using the compound having a hydroxymethyl group or the like as described above, it is possible to more effectively suppress occurrence of cracks in a case where the composition of the present invention is applied onto a substrate having roughness. In addition, it is possible to form a cured film which is excellent in pattern processability and has high heat resistance such that a 5% mass reduction temperature is 350°C or higher, and more preferably 380°C or higher. As specific examples of the compound represented by Formula (AM4), 46DMOC, 46DMOEP (all trade names, manufactured by Asahi Organic Chemicals Industry Co., Ltd.), DML-MBPC, DML-MBOC, DML-OCHP, DML-PCHP, DML-PC, DML-PTBP, DML-34X, DML-EP, DML-POP, Dimethylol BisOC-P, DML-PFP, DML-PSBP, DML-MTris PC (manufactured by Honshu Chemical Industry Co., Ltd.), NIKALAC MX-290 (trade name, manufactured by Sanwa Chemical Co., Ltd.), 2,6-dimethoxymethyl-4-t-butylphenol, 2,6-dimethoxymethyl-p-cresol, 2,6-diacetoxymethyl-p-cresol, and the like are mentioned.

In addition, as specific examples of the compound represented by Formula (AM5), TriML-P, TriML-35XL, TML-HQ, TML-BP, TML-pp-BPF, TML-BPA, TMOM-BP, HML-TPPHBA, HML-TPHAP, HMOM-TPPHBA, HMOM-TPHAP (all trade name, manufactured by Honshu Chemical Industry Co., Ltd.), TM-BIP-A (trade name, manufactured by Asahi Organic Materials Industry Co., Ltd.), NIKALAC MX-280, NIKALAC MX-270, and NIKALAC MW-100LM (all trade names, manufactured by Sanwa Chemical Co., Ltd.) are mentioned.

### (Epoxy compound (compound having epoxy group))

The epoxy compound is preferably a compound having two or more epoxy groups in one molecule. Since the epoxy group undergoes a crosslinking reaction at 200°C or lower and a dehydration reaction derived from crosslinking does not occur, film shrinkage hardly occurs. Therefore, containing an epoxy compound is effective for low-temperature curing of the composition and suppression of warping thereof.

The epoxy compound preferably contains a polyethylene oxide group. As a result, it is possible to further decrease a modulus of elasticity and to suppress warping. In addition, flexibility of a film is increased, and thus it is possible to obtain a cured film which is also excellent in elongation and the like can be obtained. The polyethylene oxide group means a group in which the number of repeating units of ethylene oxide is 2 or higher, with the number of repeating units being preferably 2 to 15.

As examples of the epoxy compound, bisphenol A type epoxy resin; bisphenol F type epoxy resin; alkylene glycol type epoxy resin such as propylene glycol diglycidyl ether; polyalkylene glycol type epoxy resin such as polypropylene glycol diglycidyl ether; epoxy group-containing silicone such as polymethyl(glycidyloxypropyl) siloxane, and the like can be mentioned, but not limited thereto. Specifically, EPICLON (registered trademark) 850-S, EPICLON (registered trademark) HP-4032, EPICLON (registered trademark) HP-7200, EPICLON (registered trademark) HP-820, EPICLON (registered trademark) HP-4700, EPICLON (registered trademark) EXA-4710, EPICLON (registered trademark) HP-4770, EPICLON (registered trademark) EXA-859CRP, EPICLON (registered trademark) EXA-1514, EPICLON (registered trademark) EXA-4880, EPICLON (registered trademark) EXA-4850-150, EPICLON (registered trademark) EXA-4850-1000, EPICLON (registered trademark) EXA-4816, EPICLON (registered trademark) EXA-4822 (trade names, manufactured by Dainippon Ink and Chemicals, Inc.), RIKARESIN (registered trademark) BEO-60E (trade name, manufactured by New Japan Chemical Co., Ltd.), EP-4003S, EP-4000S (all trade names, manufactured by ADEKA CORPORATION), and the like are mentioned. Among these, an epoxy resin containing a polyethylene oxide group is preferable from the viewpoint of suppression of warping and excellent heat resistance. For example, EPICLON (registered trademark) EXA-4880, EPICLON (registered trademark) EXA-4822, and RIKARESIN (registered trademark) BEO-60E are preferable due to containing a polyethylene oxide group.

A content of the epoxy compound is preferably 5 to 50 parts by mass, more preferably 10 to 50 parts by mass, and even more preferably 10 to 40 parts by mass, with respect to 100 parts by mass of the heterocyclic ring-containing polymer precursor. In a case where the content of the epoxy compound is 5 parts by mass or higher, warping of the obtained cured film can be further suppressed. In a case where the content is 50 parts by mass or lower, pattern embedment caused by reflow during curing can be further suppressed.

### (Oxetane compound (compound having an oxetanyl group))

As the oxetane compound, a compound having two or more oxetane rings in one molecule, 3 -ethyl-3 -hydroxymethyloxetane, 1,4-bis{[(3-ethyl-3-oxetanyl)methoxy]methyl}benzene, 3-ethyl-3-(2-ethylhexylmethyl)oxetane, 1,4-benzenedicarboxylic acid-bis[(3-ethyl-3-oxetanyl)methyl]ester, and the like can be mentioned. As specific examples thereof, ARON OXETANE series (for example, OXT-121, OXT-221, OXT-191, OXT-223) manufactured by Toagosei Co., Ltd. can be suitably used. These may be used alone, or two or more types thereof may be used in admixture.

A content of the oxetane compound is preferably 5 to 50 parts by mass, more preferably 10 to 50 parts by mass, and even more preferably 10 to 40 parts by mass, with respect to 100 parts by mass of the heterocyclic ring-containing polymer precursor.

### (Benzoxazine compound (compound having benzoxazolyl group))

Due to a crosslinking reaction derived from a ring-opening addition reaction, the benzoxazine compound does not result in degassing during curing, and results in decreased thermal contraction so that occurrence of warping is suppressed, which is preferable.

As preferred examples of the benzoxazine compound, B-a type benzoxazine, B-m type benzoxazine (all trade names, manufactured by Shikoku Chemicals Corporation), a benzoxazine adduct of polyhydroxystyrene resin, and a phenol novolak type dihydrobenzo oxazine compound are mentioned. These may be used alone, or two or more types thereof may be used in admixture.

A content of the benzoxazine compound is preferably 5 to 50 parts by mass, more preferably 10 to 50 parts by mass, and even more preferably 10 to 40 parts by mass, with respect to 100 parts by mass of the heterocyclic ring-containing polymer precursor.

### <<Migration suppressing agent>>

The photosensitive resin composition preferably further contains a migration suppressing agent. By containing the migration suppressing agent, it is possible to effectively prevent metal ions derived from a metal layer (metal wiring) from being migrated into a photosensitive resin composition layer.

As the migration suppressing agent, there is no particular limitation, and compounds having a heterocyclic ring (a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a pyrazine ring, a piperidine ring, a piperazine ring, a morpholine ring, a 2H-pyran ring and a 6H-pyran ring, a triazine ring), compounds having thioureas and a mercapto group, hindered phenol-based compounds, salicylic acid derivative-based compounds, and hydrazide derivative-based compounds are mentioned. In particular, triazole-baed compounds such as triazole and benzotriazole, and tetrazole-based compounds such as tetrazole and benzotetrazole can be preferably used.

In addition, an ion trapping agent that captures an anion such as a halogen ion can also be used.

As other migration suppressing agents, the rust inhibitors described in paragraph 0094 of JP2013-015701A, the compounds described in paragraphs 0073 to 0076 of JP2009-283711A, the compounds described in paragraph 0052 of JP2011-059656A, and the compounds described in paragraphs 0114, 0116, and 0118 of JP2012-194520A, and the like can be used.

As specific examples of the migration suppressing agent, 1H-1,2,3-triazole and 1H-tetrazole can be mentioned.

In a case where the photosensitive resin composition has the migration suppressing agent, a content of the migration suppressing agent is preferably 0.01% to 5.0% by mass, more preferably 0.05% to 2.0% by mass, and even more preferably 0.1% to 1.0% by mass, with respect to a total solid content of the photosensitive resin composition.

For the migration suppressing agent, only one type may be used, or two or more types may be used. In a case where two or more types of migration suppressing agents are used, a total thereof is preferably within the above-mentioned range.

### <<polymerization inhibitor>>

The composition of the present invention preferably contains a polymerization inhibitor.

As the polymerization inhibitor, for example, hydroquinone, p-methoxyphenol, di-tert-butyl-p-cresol, pyrogallol, p-tert-butylcatechol, p-benzoquinone, diphenyl-p-benzoquinone, 4,4'thiobis(3-methyl-6-tert-butylphenol), 2,2'methylenebis(4-methyl-6-tert-butylphenol), N-nitroso-N-phenylhydroxyamine aluminum salt, phenothiazine, N-nitrosodiphenylamine, N-phenyl naphthylamine, ethylenediamine tetraacetic acid, 1,2-cyclohexanediamine tetraacetic acid, glycol ether diamine tetraacetic acid, 2,6-di-tert-butyl-4-methyl phenol, 5-nitroso-8-hydroxyquinoline, 1-nitroso-2-naphtoyl, 2-nitroso-1-naphtoyl, 2-nitroso-5-(N-ethyl-N-sulfopropylamino)phenol, N-nitroso-N-(1-naphthyl)hydroxyamine ammonium salt, bis(4-hydroxy-3,5-tert-butyl)phenylmethane, and the like are suitably used. In addition, the polymerization inhibitors described in paragraph 0060 of JP2015-127817A and the compounds described in paragraphs 0031 to 0046 of WO2015/125469A can also be used.

In addition, the following compounds can be used (Me is a methyl group).

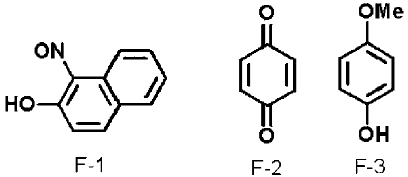

In a case where the composition of the present invention has a polymerization inhibitor, a content of the polymerization inhibitor is preferably 0.01% to 5% by mass with respect to a total solid content of the composition of the present invention.

For the polymerization inhibitor, only one type may be used, or two or more types may be used. In a case where two or more types of polymerization inhibitors are used, a total thereof is preferably within the above-mentioned range.

### <<Metal adhesiveness improving agent>>

The composition of the present invention preferably contains a metal adhesiveness improving agent for improving adhesiveness to a metal material used for electrodes, wirings, and the like. As the metal adhesiveness improving agent, a silane coupling agent and the like are mentioned.

As examples of the silane coupling agent, the compounds described in paragraphs 0062 to 0073 of JP2014-191002A, the compounds described in paragraphs 0063 to 0071 of WO2011/080992A1, the compounds described in paragraphs 0060 to 0061 of JP2014-191252A, the compounds described in paragraphs 0045 to 0052 of JP2014-041264A, and the compounds described in paragraph 0055 of WO2014/097594A are mentioned. In addition, it is also preferable to use two or more types of the different silane coupling agents as described in paragraphs 0050 to 0058 of JP2011-128358A. In addition, as the silane coupling agent, the following compounds are also preferably used. In the formulas, Et represents an ethyl group.

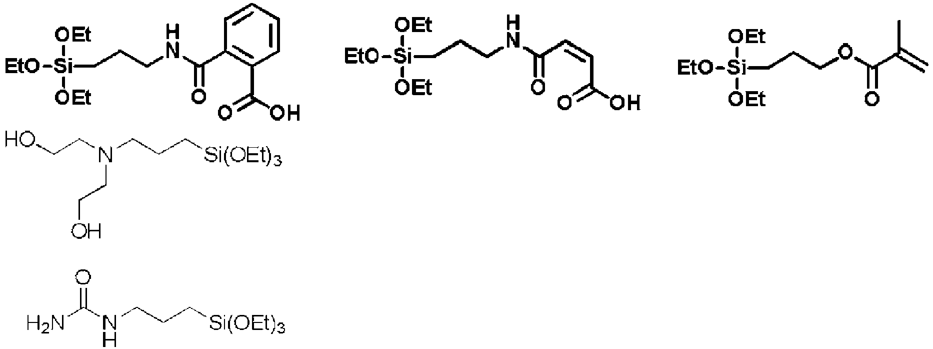

In addition, as the metal adhesiveness improving agent, the compounds described in paragraphs 0046 to 0049 of JP2014-186186A, and the sulfide-based compounds described in paragraphs 0032 to 0043 of JP2013-072935A can also be used.

A content of the metal adhesiveness improving agent is preferably 0.1 to 30 parts by mass, and more preferably 0.5 to 15 parts by mass, with respect to 100 parts by mass of the heterocyclic ring-containing polymer precursor. In a case where the content is 0.1 parts by mass or higher, good adhesiveness between a cured film and a metal layer after a curing step is exhibited. In a case where the content is 30 parts by mass or lower, the cured film after the curing step exhibits good heat resistance and mechanical properties. For the metal adhesiveness improving agent, only one type may be used, or two or more types may be used. In a case where two or more types are used, a total thereof is preferably within the above-mentioned range.

### <<Other additives>>

Various additives, for example, a thermal-acid generator, a sensitizing dye, a chain transfer agent, a surfactant, a higher fatty acid derivative, an inorganic particle, a curing agent, a curing catalyst, a filler, an antioxidant, an ultraviolet absorbent, and an aggregation inhibitor can be blended, if necessary, with the composition of the present invention to the extent that an effect of the present invention is not impaired. In a case where these additives are blended, a total blending amount thereof is preferably 3% by mass or lower of the solid content of the composition.

### (Thermal-acid generator)

The composition of the present invention may contain a thermal-acid generator. The thermal-acid generator generates an acid upon heating, and promotes cyclization of the heterocyclic ring-containing polymer precursor, so that mechanical properties of a cured film are further improved. As the thermal-acid generator, the compounds described in paragraph 0059 of JP2013-167742A are mentioned.

A content of the thermal-acid generator is preferably 0.01 parts by mass or higher, and more preferably 0.1 parts by mass or higher, with respect to 100 parts by mass of the heterocyclic ring-containing polymer precursor. In a case where the thermal-acid generator is contained in an amount of 0.01 parts by mass or higher, crosslinking reaction and cyclization of the heterocyclic ring-containing polymer precursor are promoted, so that mechanical properties and chemical resistance of the cured film can be further improved. In addition, the content of the thermal-acid generator is preferably 20 parts by mass or lower, more preferably 15 parts by mass or lower, and particularly preferably 10 parts by mass or lower, from the viewpoint of electrical insulation of the cured film.

For the thermal-acid generator, only one type may be used, or two or more types may be used. In a case where two or more types are used, a total amount is preferably within the above-mentioned range.

### (Sensitizing dye)

The composition of the present invention may contain a sensitizing dye. The sensitizing dye absorbs a specific actinic radiation and becomes an electronically excited state. The sensitizing dye in the electronically excited state is brought into contact with a thermal-base generator, a thermal-radical polymerization initiator, a radical polymerization initiator, or the like, to cause actions such as electron transfer, energy transfer, and heat generation. As a result, the thermal-base generator, the thermal-radical polymerization initiator, or the radical polymerization initiator undergoes a chemical change and decomposes, so that radicals, acids, or bases are generated. For details of the sensitizing dye, reference can be made to the description in paragraphs 0161 to 0163 of JP2016-02735 7A.

In a case where the composition of the present invention contains the sensitizing dye, a content of the sensitizing dye is preferably 0.01 to 20% by mass, more preferably 0.1 to 15% by mass, and even more preferably 0.5 to 10% by mass, with respect to a total solid content of the composition of the present invention. For the sensitizing dye, one type may be used alone, or two or more types may be used in combination.

### (Chain transfer agent)

The composition of the present invention may contain a chain transfer agent. The chain transfer agent is defined, for example, in Polymer Dictionary, 3rd Edition, pp. 683 to 684 (edited by The Society of Polymer Science, 2005). As the chain transfer agent, for example, a group of compounds having SH, PH, SiH, or GeH in a molecule is used. These can donate a hydrogen to a low active radical to generate a radical, or can be oxidized and then deprotonated to generate a radical. In particular, thiol compounds (for example, 2-mercaptobenzimidazoles, 2-mercaptobenzothiazoles, 2-mercaptobenzoxazoles, 3-mercaptotriazoles, and 5-mercaptotetrazoles) can be preferably used.

In a case where the composition of the present invention has the chain transfer agent, a content of the chain transfer agent is preferably 0.01 to 20 parts by mass, more preferably 1 to 10 parts by mass, and even more preferably 1 to 5 parts by mass, with respect to 100 parts by mass of a total solid content of the composition of the present invention. For the chain transfer agent, only one type may be used, or two or more types may be used. In a case where two or more types of chain transfer agents are used, a total thereof is preferably within the above-mentioned range.

### (Surfactant)

From the viewpoint of further improving coatability, various types of surfactants may be added to the composition of the present invention. As the surfactant, various types of surfactants such as a fluorine-based surfactant, a nonionic surfactant, a cationic surfactant, an anionic surfactant, and a silicone-based surfactant can be used. In addition, the following surfactants are preferably used.

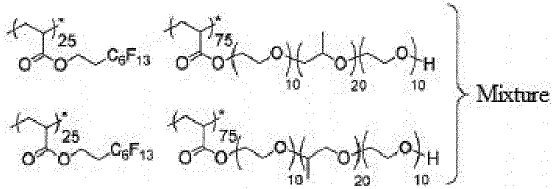

In a case where the composition of the present invention has the surfactant, a content of the surfactant is preferably 0.001% to 2.0% by mass, and more preferably 0.005% to 1.0% by mass, with respect to a total solid content of the composition of the present invention. For the surfactant, only one type may be used, or two or more types may be used. In a case where two or more types of surfactants are used, a total thereof is preferably within the above-mentioned range.

### (Higher fatty acid derivative)

In the composition of the present invention, in order to prevent polymerization inhibition due to oxygen, a higher fatty acid derivative such as behenic acid or behenic acid amide is added and is caused to be localized on a surface of the composition in the course of drying after coating.

In a case where the composition of the present invention has the higher fatty acid derivative, a content of the higher fatty acid derivative is preferably 0.1% to 10% by mass with respect to a total solid content of the composition of the present invention. For the higher fatty acid derivative, only one type may be used, or two or more types may be used. In a case where two or more higher fatty acid derivatives are used, a total thereof is preferably within the above-mentioned range.

### <<Restriction on other substances to be contained>>

A water content of the composition of the present invention is preferably less than 5% by mass, more preferably less than 1% by mass, and particularly preferably less than 0.6% by mass, from the viewpoint of properties of a coated surface.

A metal content of the composition of the present invention is preferably less than 5 parts per million (ppm) by mass, more preferably less than 1 ppm by mass, and particularly preferably less than 0.5 ppm by mass, from the viewpoint of insulating properties. As the metal, sodium, potassium, magnesium, calcium, iron, chromium, nickel, and the like are mentioned. In a case where a plurality of metals are contained, a total of these metals is preferably within the above-mentioned range.

In addition, as a method for decreasing metal impurities which are unintentionally contained in the composition of the present invention, a method of selecting raw materials having a small metal content as raw materials constituting the composition of the present invention, a method of carrying out filtration using a filter on raw materials constituting the composition of the present invention, a method of carrying out distillation under conditions where contamination is suppressed as much as possible by lining an inside of an apparatus with polytetrafluoroethylene or the like, and the like can be mentioned.

In the composition of the present invention, a content of halogen atoms is preferably less than 500 ppm by mass, more preferably less than 300 ppm by mass, and particularly preferably less than 200 ppm by mass, from the viewpoint of wiring corrosiveness. Among these, in a case of being present in a halogen ion state, the content is preferably less than 5 ppm by mass, more preferably less than 1 ppm by mass, and particularly preferably less than 0.5 ppm by mass. As the halogen atom, a chlorine atom and a bromine atom are mentioned. It is preferable that each of the chlorine atom and the bromine atom, or a total of the chlorine ion and the bromine ion is within the above-mentioned range.

As a storage container for the composition of the present invention, storage containers known in the related art can be used. In addition, as the storage container, for the purpose of suppressing incorporation of impurities into raw materials and the composition, a multilayer bottle in which an inner wall of a container is composed of six types of six layers of resin, and a bottle with 6 types of resin being made as a seven-layer structure are preferably used. As such a container, for example, the container described in JP2015-123351A is mentioned.

### <Preparation of composition>

The composition of the present invention can be prepared by mixing the above-mentioned respective components. A mixing method is not particularly limited, and mixing can be carried out by methods known in the related art.

In addition, for the purpose of removing foreign substances such as dust and fine particles in the composition, it is preferable to carry out filtration using a filter. A filter pore size is preferably 1 µm or lower, more preferably 0.5 µm or lower, and even more preferably 0.1 µm or lower. A material of the filter is preferably polytetrafluoroethylene, polyethylene, or nylon. As the filter, a filter which has been previously washed with an organic solvent may be used. In a filtration step using a filter, a plurality of type of filters may be connected in series or in parallel and used. In a case where a plurality of types of filters are used, filters having different pore sizes and/or different materials may be used in combination. In addition, various materials may be filtered a plurality of times. In a case of being filtered a plurality of times, circulation filtration may be used. In addition, filtration may be carried out under pressure. In a case of where filtration is carried out under pressure, the pressure is preferably 0.05 MPa to 0.3 MPa.

In addition to filtration using a filter, impurity removal treatment using an adsorbing material may be carried out. The filtration using a filter and the impurity removal treatment using an adsorbing material may be combined. As the adsorbing material, a known adsorbing material can be used. For example, an inorganic adsorbing material such as silica gel and zeolite, and an organic adsorbing material such as activated carbon are mentioned.

### <Cured film, laminate, semiconductor device, method for producing cured film, method for producing laminate, and method for producing semiconductor device>

Next, the cured film, the laminate, the semiconductor device, the method for producing a cured film, the method for producing a laminate, and the method for manufacturing a semiconductor device of the present invention will be described.

The cured film of the present invention is obtained by curing the composition of the present invention. A film thickness of the cured film of the present invention can be, for example, 1 µm or higher, and can be 5 µm or higher. In addition, an upper limit value thereof can be 100 µm or lower, and can be 30 µm or lower.

A Tg of the cured film of the present invention is preferably 240°C or higher, more preferably 250°C or higher, even more preferably 260°C or higher, and still more preferably 270°C or higher. An upper limit value of the Tg of the cured film of the present invention is not particularly specified, and, for example, the Tg at 600°C or lower, or even 450°C or lower is a sufficiently practical level. In particular, the present invention is highly valuable in that it is possible to provide a photosensitive resin composition capable of achieving the above-mentioned Tg. The Tg in the present invention is measured in accordance with descriptions of examples as described later.

Two or more layers of the cured film of the present invention may be laminated to form a laminate. A laminate having two or more layers of the cured film of the present invention preferably has a metal layer between the cured films. Such a metal layer is preferably used as a metal wiring such as a re-distribution layer. The metal layer preferably contains copper.

As a field to which the cured film of the present invention can be applied, an insulating film of a semiconductor device, an interlayer insulating film for a re-distribution layer, and the like are mentioned. In particular, due to good resolution properties, the cured film of the present invention can be preferably used for an interlayer insulating film for a re-distribution layer in a three-dimensional mounting device.

In addition, the cured film in the present invention can also be used for photoresist for electronics, galvanic (electrolytic) resist, etching resist, solder top resist, and the like.

In addition, the cured film in the present invention can also be used for production of board surfaces such as an offset board surface or a screen board surface, for etching of molded parts, for production of protective lacquers and dielectric layers in electronics, in particular, microelectronics, and the like.

The method for producing a cured film of the present invention includes using the composition of the present invention. Preferably, a method for producing a cured film which has a photosensitive resin composition layer forming step of applying the photosensitive resin composition of the present invention to a substrate to form a layered shape, an exposing step of exposing the photosensitive resin composition layer, and a step of subjecting the exposed photosensitive resin composition layer (resin layer) to a development treatment is mentioned. More preferably, the photosensitive resin composition of the present invention is preferably used in a case where the development is a negative tone development treatment. In addition, in the production method of the present invention, after the development treatment step, the developed photosensitive resin composition layer is preferably heated to a temperature of 50°C or higher, more preferably 80°C or higher, even more preferably 100°C or higher, and still more preferably 150°C or higher, and further still more preferably 180°C or higher. An upper limit of the heating temperature is preferably 450°C or lower, more preferably 400°C or lower, even more preferably 380°C or lower, still more preferably 300°C or lower, further still more preferably 280°C or lower, yet further still more preferably 250°C or lower, yet further still more preferably 240°C or lower, yet further still more preferably 230°C or lower, yet further still more preferably 220°C or lower, yet further still more preferably 210°C or lower, yet further still more preferably 205°C or lower, and yet further still more preferably 200°C or lower.

Since the cured film of the present invention allows ring closure to be made with a high ring closure rate even at a low temperature, the heating temperature can be decreased, and damage to a semiconductor element or the like can be decreased. In particular, in the present invention, it is possible to obtain a photosensitive resin composition which is capable of achieving a ring closure rate of 80% or higher, and furthermore 90% or higher, in a case of being heated in the above-mentioned temperature range (for example, at 200°C). The ring closure rate in the present invention is measured in accordance with the descriptions of examples as described later.

The method for producing a laminate of the present invention includes a method for producing a cured film of the present invention. The method of producing a laminate preferably includes forming a cured film in accordance with the method of producing a cured film of the present invention, and then further performing the photosensitive resin composition layer forming step, the exposure step, and the development treatment step, in this order. In particular, it is preferable that the photosensitive resin composition layer forming step, the exposure step, and the development treatment step are further carried out, in this order, 2 to 5 times (that is, 3 to 6 times in total). By laminating the cured film in this manner, a laminate can be obtained. In the present invention, in particular, it is preferable to provide a metal layer on a portion which has been developed and removed, after the cured film is provided and developed.

The present invention also discloses a semiconductor device including the cured film or laminate of the present invention. Hereinafter, an embodiment of a semiconductor device in which the composition of the present invention is used for an interlayer insulating film for a re-distribution layer will be described.

A semiconductor device 100 shown in Fig. 1 is a so-called three-dimensional mounting device, and a laminate 101 in which a plurality of semiconductor elements (semiconductor chips) 101a to 101d are laminated is disposed on a wiring substrate 120. In this embodiment, a case where the number of laminated semiconductor elements (semiconductor chips) is 4-layer will be mainly described. However, the number of laminated semiconductor elements (semiconductor chips) is not particularly limited, and may be, for example, 2-layer, 8-layer, 16-layer, 32-layer, or the like. In addition, the number may be 1-layer.

Each of the plurality of semiconductor elements 101a to 101d is made of a semiconductor wafer such as a silicon substrate. An uppermost semiconductor element 101a does not have a through electrode, and an electrode pad (not shown) is formed on one surface thereof. The semiconductor elements 101b to 101d have through electrodes 102b to 102d, and connection pads (not shown) which are integrally provided on the through electrodes are provided on both surfaces of each semiconductor element.

The laminate 101 has a structure in which a semiconductor element 101a having no through electrode and semiconductor elements 101b to 101d having through electrodes 102b to 102d are flip-chip connected. That is, an electrode pad of the semiconductor element 101a having no through electrode, and a connection pad on a semiconductor element 101a side of the semiconductor element 101b having the through electrode 102b which is adjacent to the semiconductor element 101a are connected by a metal bump 103a such as solder bump. A connection pad on the other side of the semiconductor element 101b having the through electrode 102b, and a connection pad on a semiconductor element 101b side of the semiconductor element 101c having the through electrode 102c which is adjacent to the semiconductor element 101b are connected by a metal bump 103b such as a solder bump. Similarly, a connection pad on the other side of the semiconductor element 101c having the through electrode 102c, and a connection pad on a semiconductor element 101c side of the semiconductor element 101d having the through electrode 102d which is adjacent to the semiconductor element 101c are connected by a metal bump 103c such as a solder bump.

An underfill layer 110 is formed in each gap between the semiconductor elements 101a to 101d, and the respective semiconductor elements 101a to 101d are laminated via the underfill layer 110 interposed therebetween.

The laminate 101 is laminated on the wiring substrate 120. As the wiring substrate 120, for example, a multilayer wiring substrate obtained by using an insulating substrate such as a resin substrate, a ceramic substrate, and a glass substrate as a base material is used. As the wiring substrate 120 to which the resin substrate is applied, a multilayer copper-clad laminated board (multilayer printed wiring board) and the like are mentioned.

On one surface of the wiring substrate 120, a surface electrode 120a is provided.

An insulating film 115 on which a re-distribution layer 105 is formed is disposed between the wiring substrate 120 and the laminate 101, and the wiring substrate 120 and the laminate 101 are electrically connected via the re-distribution layer 105. The insulating film 115 is formed using the composition of the present invention.

That is, one end of the re-distribution layer 105 is connected, via a metal bump 103d such as a solder bump, to an electrode pad formed on a surface of the semiconductor element 101d on a re-distribution layer 105 side. In addition, the other end of the re-distribution layer 105 is connected, via a metal bump 103e such as a solder bump, to the surface electrode 120a of the wiring substrate.

An underfill layer 110a is formed between the insulating film 115 and the laminate 101. In addition, an underfill layer 110b is formed between the insulating film 115 and the wiring substrate 120.

In addition to the above, the cured film of the present invention can be widely adopted for various applications using polyimide.

In addition, since polyimide is resistant to heat, the cured film and the like in the present invention can be suitably used in plastic substrates for display devices such as liquid crystal display, organic EL display, and electronic paper as well as in applications for interlayer insulating films, automobile parts, heat-resistant paints, coating agents, and films.

### Examples

Hereinafter, the present invention will be described more specifically with reference to examples. Materials, amounts used, proportions, treatment details, treatment procedures, and the like shown in the following examples can be appropriately changed without departing from the gist of the present invention. Accordingly, a scope of the present invention is not limited to the following specific examples. "Parts" and "%" are on a mass basis unless otherwise stated.

### <Synthesis Example 1>

### [Synthesis of polyimide precursor (A-1: polyimide precursor having no radically polymerizable group) from pyromellitic acid dianhydride, 4,4'-diaminodiphenyl ether, and benzyl alcohol]

14.06 g (64.5 mmol) of pyromellitic acid dianhydride (dried at 140°C for 12 hours) and 14.22 g (131.58 mmol) of benzyl alcohol were suspended in 50 mL of N-methylpyrrolidone, and dried with a molecular sieve. The suspension was heated at 100°C for 3 hours. A transparent solution was obtained several minutes after heating. The reaction mixture was cooled to room temperature and 21.43 g (270.9 mmol) of pyridine and 90 mL of N-methylpyrrolidone were added. Subsequently, the reaction mixture was cooled to -10°C, and 16.12 g (135.5 mmol) of SOCl₂ was added over 10 minutes while maintaining the temperature at -10±4°C. A viscosity was increased while adding SOCl₂. After dilution with 50 mL of N-methylpyrrolidone, the reaction mixture was stirred at room temperature for 2 hours. Subsequently, a solution obtained by dissolving 11.08 g (58.7 mmol) of 4,4'-diaminodiphenyl ether in 100 mL of N-methylpyrrolidone was added dropwise to the reaction mixture at 20°C to 23°C over 20 minutes. Subsequently, the reaction mixture was stirred at room temperature overnight. Subsequently, 5 L of water was put to cause a polyimide precursor to be sedimented, and the water-polyimide precursor mixture was stirred at a speed of 5,000 rpm for 15 minutes. The polyimide precursor was filtered off, stirred again in 4 L of water for 30 minutes and filtered again. Subsequently, the obtained polyimide precursor was dried under reduced pressure at 45°C for 3 days to obtain the following polyimide precursor (A-1). As a result of carrying out GPC measurement on the obtained polyimide precursor (A-1), a weight-average molecular weight (Mw) thereof as polystyrene equivalent value was 22,000.

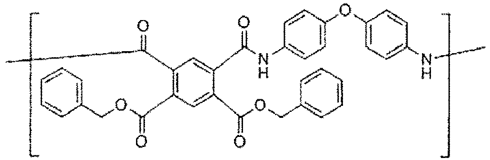

### <Synthesis Example 2>

### [Synthesis of polyimide precursor (A-2: polyimide precursor having radically polymerizable group) from pyromellitic acid dianhydride, 4,4'-diaminodiphenyl ether, and 2-hydroxyethyl methacrylate]

14.06 g (64.5 mmol) of pyromellitic acid dianhydride (dried at 140°C for 12 hours), 18.6 g (129 mmol) 2-hydroxyethyl methacrylate, 0.05 g of hydroquinone, 10.7 g of pyridine, and 140 g of diglyme (diethylene glycol dimethyl ether) were mixed and stirred at a temperature of 60°C for 18 hours to prepare diester of pyromellitic acid and 2-hydroxyethyl methacrylate. Subsequently, the obtained diester was chlorinated with SOCl₂ and then converted to a polyimide precursor with 4,4'-diaminodiphenyl ether in the same manner as in Synthesis Example 1, so that the polyimide precursor (A-2) was obtained in the same manner as in Synthesis Example 1. As a result of carrying out GPC measurement on the obtained polyimide precursor (A-2), a weight-average molecular weight (Mw) thereof as polystyrene equivalent value was 20,000.

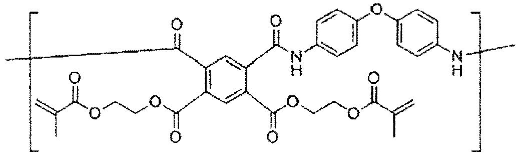

### <Synthesis Example 3>

### [Synthesis of polyimide precursor (A-3: polyimide precursor having radically polymerizable group) from 4,4'-oxydiphthalic acid dianhydride, 4,4'-diaminodiphenyl ether, and 2-hydroxyethyl methacrylate]

20.0 g (64.5 mmol) of 4,4'-oxydiphthalic acid dianhydride (dried at 140°C for 12 hours), 18.6 g (129 mmol) of 2-hydroxyethyl methacrylate, 0.05 g of hydroquinone, 10.7 g of pyridine, and 140 g of diglyme were mixed and stirred at 60°C for 18 hours to prepare diester of 4,4'-oxydiphthalic acid and 2-hydroxyethyl methacrylate. Subsequently, the obtained diester was chlorinated with SOCl₂ and then converted to a polyimide precursor with 4,4'-diaminodiphenyl ether in the same manner as in Synthesis Example 1, so that the polyimide precursor (A-3) was obtained in the same manner as in Synthesis Example 1. As a result of carrying out GPC measurement on the obtained polyimide precursor (A-3), a weight-average molecular weight (Mw) thereof as polystyrene equivalent value was 22,000.

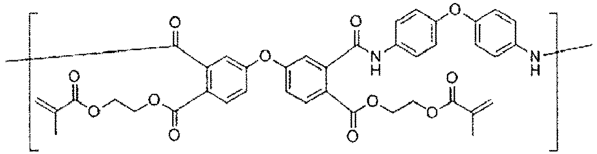

### <Synthesis Example 4>

### [Synthesis of polyimide precursor (A-4: polyimide precursor having carboxyl group) from 4,4'-oxydiphthalic acid dianhydride and 4,4'-diaminodiphenyl ether]

20.0 g (64.5 mmol) of 4,4'-oxydiphthalic acid dianhydride (dried at 140°C for 12 hours) was dissolved in 180 mL of N-methyl-2-pyrrolidone (NMP). Furthermore, 21.43 g (270.9 mmol) of pyridine was added thereto, the reaction solution was cooled to -10°C, a solution obtained by dissolving 11.08 g (58.7 mmol) of 4,4'-diaminodiphenyl ether in 100 mL of NMP was added dropwise over 30 minutes while maintaining the temperature at -10±4°C, and then the reaction mixture was stirred at room temperature overnight. Subsequently, 5 L of water was put to cause the polyimide precursor to be sedimented, and the water-polyimide precursor mixture was stirred at a speed of 5,000 rpm for 15 minutes. The polyimide precursor was filtered off, stirred again in 4 L of water for 30 minutes, and filtered again. Subsequently, the obtained polyimide precursor was dried under reduced pressure at 45°C for 3 days to obtain the polyimide precursor (A-4). As a result of GPC measurement on the obtained polyimide precursor (A-4), a weight-average molecular weight (Mw) thereof as polystyrene equivalent value was 17,000.

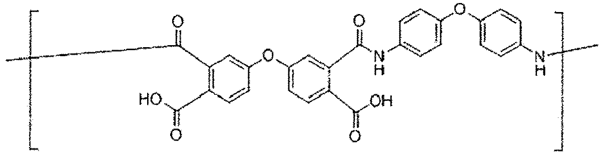

### <Synthesis Example 5>

### [Synthesis of polyimide precursor (A-5: polyimide precursor having radically polymerizable group) from 4,4'-oxydiphthalic acid dianhydride, orthotrizine, and 2-hydroxyethyl methacrylate]

20.0 g (64.5 mmol) of 4,4'-oxydiphthalic acid dianhydride (dried at 140°C for 12 hours), 18.6 g (129 mmol) 2-hydroxyethyl methacrylate, 0.05 g of hydroquinone, 10.7 g of pyridine, and 140 g of diglyme were mixed and stirred at 60°C for 18 hours to prepare diester of 4,4'-oxydiphthalic acid and 2-hydroxyethyl methacrylate. Subsequently, the obtained diester was chlorinated with SOCh, and then converted to a polyimide precursor with 4,4'-diamino-2,2'-dimethylbiphenyl in the same manner as in Synthesis Example 1, so that the polyimide precursor (A-5) was obtained in the same manner as in Synthesis Example 1. As a result of carrying out GPC measurement on the obtained polyimide precursor (A-5), a weight-average molecular weight (Mw) thereof as polystyrene equivalent value was 23,000.

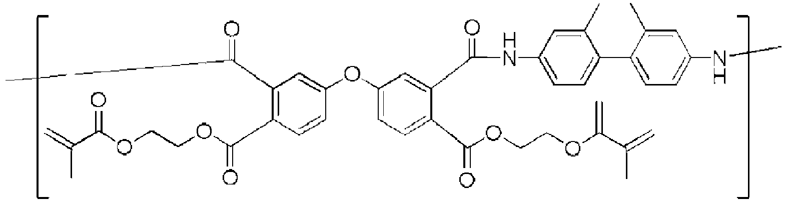

### <Synthesis Example 6>

### [Synthesis of polybenzoxazole precursor (A-6: polybenzoxazole precursor having no radically polymerizable group) from suberic acid dichloride and 2,2'-bis(3-amino-4-hydroxyphenyl)hexafluoropropane]

To 100 mL of N-methyl-2-pyrrolidone, 13.92 g of 2,2'-bis(3-amino-4-hydroxyphenyl)hexafluoropropane was added and dissolved by stirring. Then, 8.00 g of suberic acid dichloride was added dropwise over 10 minutes while maintaining the temperature at 0°C to 5°C, and stirring was continued for 60 minutes. Subsequently, 6 L of water was put to cause the polybenzoxazole precursor to be sediment, and the water-polybenzoxazole precursor mixture was stirred at a speed of 5,000 rpm for 15 minutes. The polybenzoxazole precursor was filtered off, 6 L of water was put, stirred again for 30 minutes, and filtered again. Subsequently, the obtained polybenzoxazole precursor was dried under reduced pressure at 45°C for 3 days.

As a result of GPC measurement on this polybenzoxazole precursor (A-6), a weight-average molecular weight (Mw) thereof as polystyrene equivalent value was 11,500.

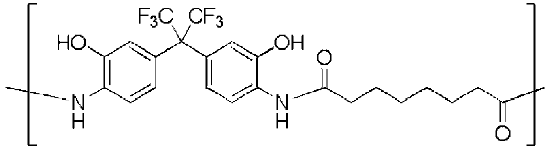

### <Examples and comparative examples>

Components as described below were mixed to prepare a photosensitive resin composition as a uniform solution.

### <<Composition of photosensitive resin composition>>

(A) Heterocyclic ring-containing polymer precursors or substitutes therefor (resin component) as described in Tables 1 to 4: Parts by mass as shown in Tables 1 to 4
(B) Thermal-base generators as described in Tables 1, 2, and 4: Parts by mass as shown in Tables 1, 2, and 4
(C) Organotitanium compounds or organozirconium compounds, or substitutes therefor as described in Tables 1 to 3: Parts by mass as shown in Tables 1 to 3
(D) Radically polymerizable compounds as described in Tables 1 to 4: Parts by mass as shown in Tables 1 to 4
(E) Photo-radical polymerization initiators as described in Tables 1 to 4: Parts by mass as shown in Tables 1 to 4
(F) Polymerization inhibitors as described in Tables 1 to 4: Parts by mass as shown in Tables 1 to 4
(G) Migration suppressing agents as described in Tables 1 to 4: Parts by mass as shown in Tables 1 to 4
(H) Metal adhesiveness improving agents as described in Tables 1 to 4: Parts by mass as shown in Tables 1 to 4
(J) Solvents as described in Tables 1 to 4: Parts by mass as shown in Tables 1 to 4

Abbreviations described in the tables are as follows.

### (A) Resin component

### Resins (polyimide precursors) synthesized in Synthesis Examples 1 to 6

Polymer (RA-1) for comparative examples: Polymethyl methacrylate (Mw: 15,000, manufactured by Aldrich)
Polymer (RA-2) for comparative examples: Matrimid 5218 (polyimide, manufactured by HUNTSMAN)

### (B) Base generator

B-1: The following compound (thermal-base generator) 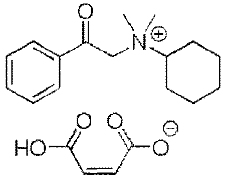
B-2: The following compound (thermal-base generator) 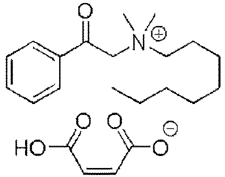
B-3: The following compound (thermal-base generator) 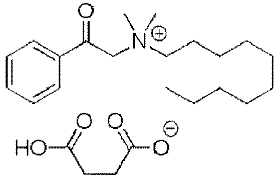
B-4: The following compound (thermal-base generator) 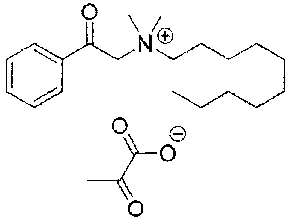
B-5: The following compound (thermal-base generator) 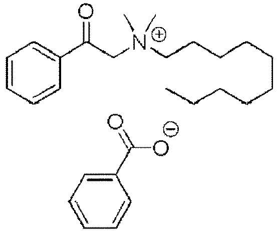
RB-1: The following compound (photo-base generator) 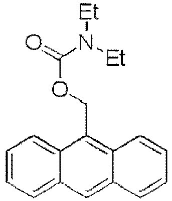
RB-2: The following compound (photo-base generator)

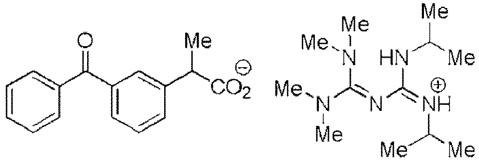

### (C) Organotitanium compound or the like

C-1: Tetraisopropoxytitanium (manufactured by Matsumoto Fine Chemical Co., Ltd.)
C-2: Tetrakis(2-ethylhexyloxy)titanium (manufactured by Matsumoto Fine Chemical Co., Ltd.)
C-3: Diisopropoxybis(ethylacetoacetate)titanium (manufactured by Matsumoto Fine Chemical Co., Ltd.)
C-4: Diisopropoxybis(acetylacetonato)titanium (manufactured by Matsumoto Fine Chemical Co., Ltd.)
C-5: The following compound. C-5 is also a compound having a radical polymerization initiating ability. 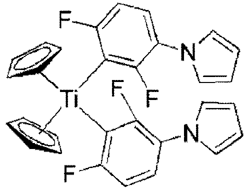
C-6: The following compound 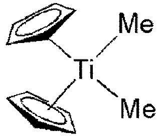
C-7: The following compound 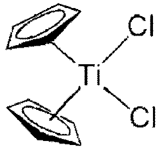
C-8: The following compound 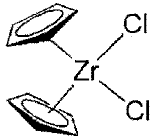
C-9: The following compound 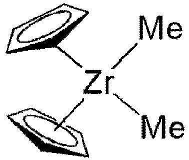
C-10: The following compound 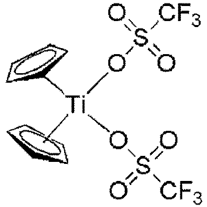
C-11: The following compound

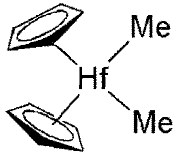

### [Metal compound for comparative examples]

RC-1: Ferrocene (manufactured by Tokyo Chemical Industry Co., Ltd.) (D) Radically polymerizable compound
D-1: SR-209 (manufactured by Sartomer)
D-2: A-DPH (Shin-Nakamura Chemical Co., Ltd.)
D-3: A-TMMT (Shin-Nakamura Chemical Co., Ltd.)

### (E) Photo-radical polymerization initiator

E-1: IRGACURE OXE 01 (manufactured by BASF)
E-2: IRGACURE 369 (manufactured by BASF)
E-3: IRGACURE OXE 02 (manufactured by BASF)

### (F) Polymerization inhibitor

F-1: 2,6-Di-tert-butyl-4-methylphenol (manufactured by Tokyo Chemical Industry Co., Ltd.)
F-2: Parabenzoquinone (manufactured by Tokyo Chemical Industry Co., Ltd.)
F-3: Paramethoxyphenol (manufactured by Tokyo Chemical Industry Co., Ltd.)

### (G) Migration suppressing agent

G-1: The following compound
G-2: The following compound
G-3: The following compound
G-4: The following compound

### (H) Metal adhesiveness improving agent

H-1: The following compound
H-2: The following compound
H-3: The following compound

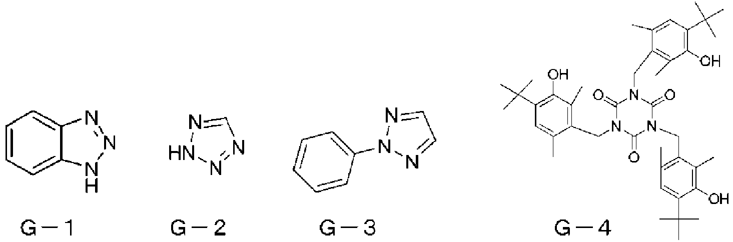

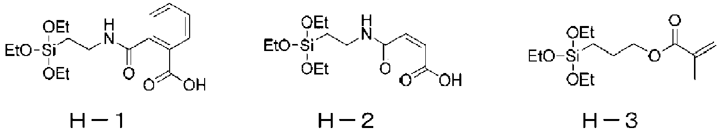

### (J) Solvent

J-1: γ-Butyrolactone (manufactured by SANWAYUKA INDUSTRY CORPORATION)
J-2: Dimethyl sulfoxide (manufactured by Wako Pure Chemical Industries, Ltd.)
J-3: N-methyl-2-pyrrolidone (manufactured by Ashland)

### <Evaluation>

### <<Exposure latitude>>

Each of the photosensitive resin compositions was filtered under a pressure of 0.3 MPa through a filter having a pore width of 0.8 µm and then spin-coated on a silicon wafer. A silicon wafer to which the photosensitive resin composition was applied was dried on a hot plate at 100°C for 5 minutes to form a uniform photosensitive resin composition layer having a film thickness of 10 µm on the silicon wafer. The photosensitive resin composition layer on the silicon wafer was exposed using a stepper (Nikon NSR 2005 i9C). Exposure was carried out with i-ray such that the exposure was carried out using a line-and-space photomask with an interval of 1 µm ranging from 5 µm to 25 µm, with the respective exposure energies of 200, 300, 400, 500, 600, 700, and 800 mJ/cm² at a wavelength of 365 nm, to obtain resin layers.

Each of the resin layers was negative-tone developed with cyclopentanone for 60 seconds. A smaller line width of the obtained resin layer (pattern) indicates a larger difference in solubility in the developer between a portion which had been irradiated with light and a portion which had not been irradiated with light, which is a preferable result. In addition, a case where small changes in the line width are exhibited with respect to changes in the exposure energy indicates wide exposure latitude, which is a preferable result. A measurement limit is 5 µm.
A: Equal to or greater than 5 µm and equal to or less than 8 µm.
B: Greater than 8 µm and equal to or less than 10 µm.
C: Equal to or greater than 10 µm and equal to or less than 15 µm.
D: Greater than 15 µm and equal to or less than 20 µm.
E: Greater than 20 µm.
F: A pattern having a line width having edge sharpness could not be obtained.

### <<Ring closure rate>>

Each of the photosensitive resin compositions was filtered under a pressure of 0.3 MPa through a filter having a pore width of 0.8 µm and then spin-coated on a silicon wafer. A silicon wafer to which the photosensitive resin composition was applied was dried on a hot plate at 100°C for 5 minutes to form a uniform photosensitive resin composition layer having a film thickness of 10 µm on the silicon wafer. The photosensitive resin composition layer on the silicon wafer was exposed using a stepper (Nikon NSR 2005 i9C). Exposure was carried out with i-ray such that the exposure was carried out with an exposure energy of 400 mJ/cm² at a wavelength of 365 nm, and negative tone development was further carried out with cyclopentanone for 60 seconds to obtain a resin layer. After heating this resin layer under a nitrogen atmosphere at 200°C for 3 hours, the resin layer was scraped and subjected to infrared spectroscopic measurement (IR measurement). Ring closure rates were calculated from the respective peak changes at 1778, 1600, 1475, 1380, and 1088 cm⁻¹, and evaluation was performed on the following standard.
A: Equal to or greater than 90%
B: Equal to or greater than 80% and less than 90%
C: Equal to or greater than 70% and less than 80%
D: Equal to or greater than 50% and less than 70%
E: Less than 50%

### <<Glass transition temperature (Tg)>>

Each of the photosensitive resin compositions was filtered under a pressure of 0.3 MPa through a filter having a pore width of 0.8 µm and then spin-coated on a silicon wafer. A silicon wafer to which the photosensitive resin composition was applied was dried on a hot plate at 100°C for 5 minutes to form a uniform photosensitive resin composition layer having a film thickness of 10 µm on the silicon wafer. The entire surface of the photosensitive resin composition layer on the silicon wafer was exposed using a stepper (Nikon NSR 2005 i9C) with an exposure energy of 400 mJ/cm², to obtain a resin layer. Furthermore, after heating the resin layer at 200°C for 3 hours, the resin layer was immersed in a hydrofluoric acid aqueous solution to peel the resin layer off from the silicon wafer. A Tg of the peeled resin layer was measured using a viscoelasticity measuring device, Rheosol-E 4000 (manufactured by UBM). Specifically, the Tg of the resin layer was measured as a temperature at which a loss tangent (tanδ) measured with the viscoelasticity measuring device under constant temperature elevation conditions was maximized. In the examples, the Tg was measured by elevating a temperature of the resin layer from 0°C to 350°C at a temperature elevation rate of 5°C/min and causing strain at a strain angle of 0.1° to be imparted to the resin layer at a cycle of 100 Hz, and evaluation was performed on the following standard.
A: Equal to or higher than 270°C
B: Equal to or higher than 260°C and lower than 270°C
C: Equal to or higher than 250°C and lower than 260°C
D: Equal to or higher than 240°C and lower than 250°C
E: Equal to or higher than 230°C and lower than 240°C
F: Equal to or higher than 220°C and lower than 230°C
G: Lower than 220°C

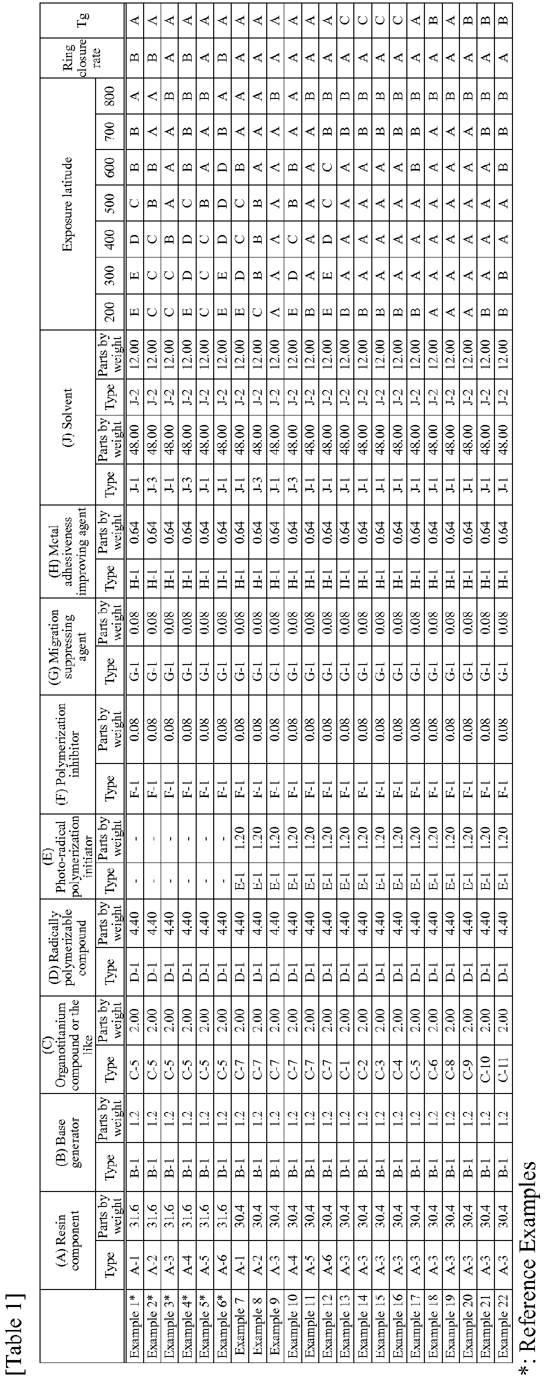

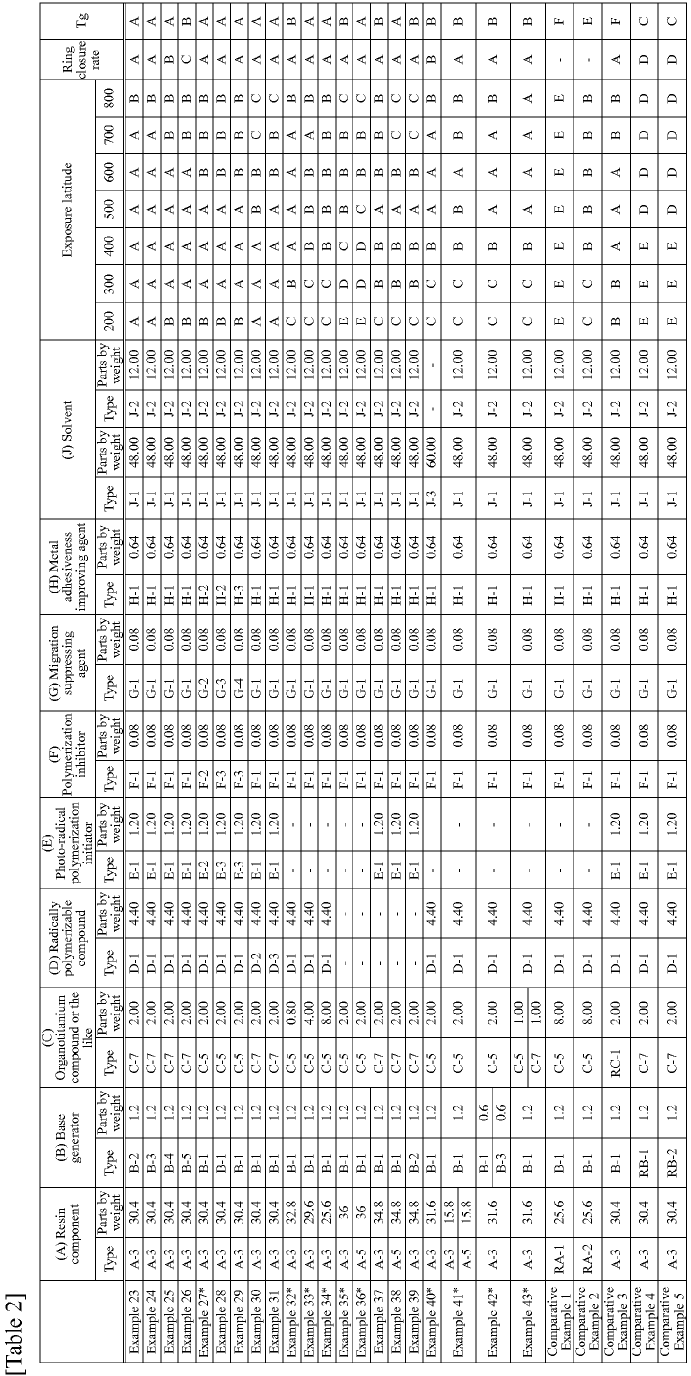

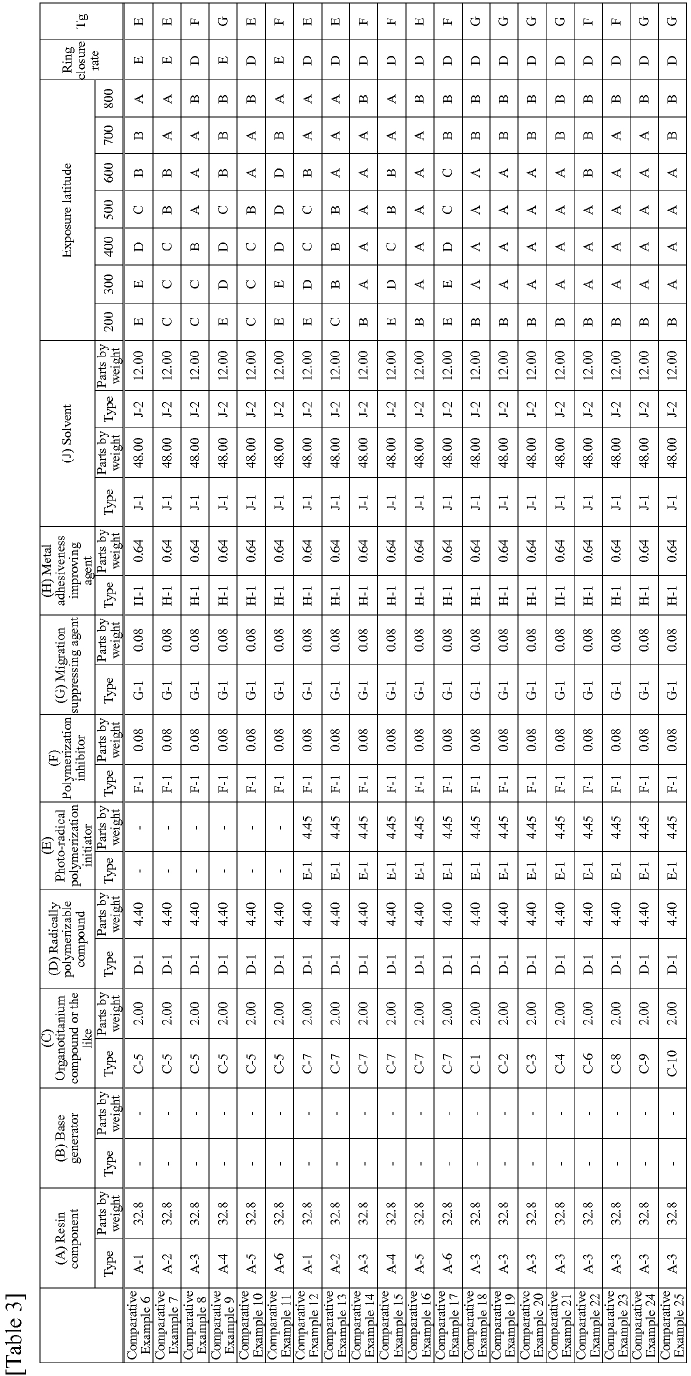

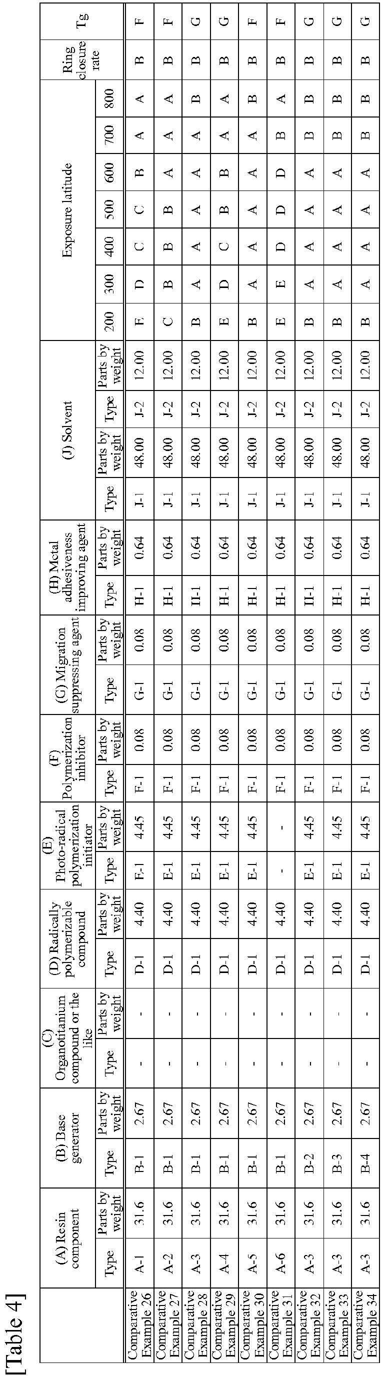

In Tables 1 to 4, a numerical value of exposure latitude indicates an exposure energy (unit: mJ/cm²).

As is apparent from Tables 1 and 2, the photosensitive resin compositions (Examples 1 to 43) of the present invention had a high ring closure rate at 200°C and a high Tg. Furthermore, the photosensitive resin compositions (Examples 1 to 43) of the present invention were also excellent in exposure latitude.

On the contrary, as is apparent from Tables 2 to 4, in a case where polymethyl methacrylate was used as the heterocyclic ring-containing polymer, ring closure was not possible (Comparative Example 1). In addition, in a case where a polyimide resin (Comparative Example 2) was used as the heterocyclic ring-containing polymer, a low Tg was also exhibited. Furthermore, in a case where, as a substitute for the organotitanium compound or the like (organic compound containing a Group 4 element), ferrocene having a structure similar thereto was blended (Comparative Example 3), a high ring closure rate was exhibited, but a low Tg was exhibited.

In addition, in a case where a photo-base generator was used instead of the thermal-base generator (Comparative Examples 4 and 5), a low ring closure rate was exhibited. Furthermore, low exposure latitude was also exhibited.

Furthermore, in a case where no thermal-base generator is contained (Comparative Examples 6 to 25), a low ring closure rate was exhibited, and a low Tg was also exhibited. On the other hand, in a case where no organotitanium compound or the like was contained (Comparative Examples 26 to 34), a high ring closure rate was exhibited, but a low Tg was exhibited.

### <Example 100>

The photosensitive resin composition of Example 1 was filtered under a pressure of 0.3 MPa through a filter having a pore width of 0.8 µm and then spin-coated (3500 rpm, 30 seconds) on a substrate having a thin copper layer on a surface thereof. The photosensitive resin composition which had been applied to the substrate was dried at 100°C for 5 minutes and then exposed using an aligner (Karl Suss MA 150). Exposure was carried out with a high-pressure mercury lamp, and an exposure energy at a wavelength of 365 nm was measured. After exposure, an image was developed with cyclopentanone for 75 seconds. Subsequently, heating was performed at 180°C for 20 minutes. In this way, an interlayer insulating film for a re-distribution layer was formed.

This interlayer insulating film for a re-distribution layer was excellent in insulating properties.

In addition, this interlayer insulating film for a re-distribution layer was used to produce a semiconductor device. As a result, it was confirmed that the semiconductor device operates without problems.

### Explanation of References

- 100:: semiconductor device
- 101a to 101d:: semiconductor element
- 101:: laminate
- 102b to 102d:: through electrode
- 103a to 103e:: metal bump
- 105:: re-distribution layer
- 110, 110a, 110b:: underfill layer
- 115:: insulating film
- 120:: wiring substrate
- 120a:: surface electrode

## Claims

1. A photosensitive resin composition, comprising:
a heterocyclic ring-containing polymer precursor;
a thermal-base generator;
an organic compound containing a Group 4 element; and
an oxime compound as a photo-radical polymerization initiator.

2. The photosensitive resin composition according to claim 1,
wherein the organic compound is an organic compound containing at least one selected from a titanium atom, a zirconium atom, and a hafnium atom,
preferably the organic compound is an organic compound containing at least one selected from a titanium atom and a zirconium atom.

3. The photosensitive resin composition according to claim 1 or 2,
wherein the heterocyclic ring-containing polymer precursor is a polyimide precursor or a polybenzoxazole precursor,
preferably the heterocyclic ring-containing polymer precursor is a polyimide precursor.

4. The photosensitive resin composition according to claim 1 or 2,
wherein the heterocyclic ring-containing polymer precursor contains a repeating unit represented by Formula (2), 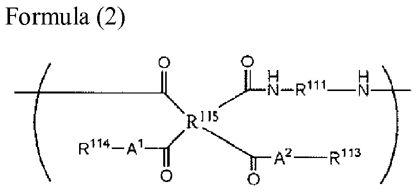 In Formula (2), A¹ and A² each independently represent an oxygen atom or NH, R¹¹¹ represents a divalent organic group, R¹¹⁵ represents a tetravalent organic group, and R¹¹³ and R¹¹⁴ each independently represent a hydrogen atom or a monovalent organic group.

5. The photosensitive resin composition according to claim 4,
wherein at least one of R¹¹³ or R¹¹⁴ in Formula (2) contains a radically polymerizable group.

6. The photosensitive resin composition according to claim 4 or 5,
wherein R¹¹⁵ in Formula (2) is a tetravalent organic group containing an aromatic ring.

7. The photosensitive resin composition according to any one of claims 4 to 6,
wherein R¹¹¹ in Formula (2) is represented by -Ar-L-Ar-, where Ar's each independently represent an aromatic group, and L is an aliphatic hydrocarbon group having 1 to 10 carbon atoms which may be substituted with a fluorine atom, -O-, -CO-, -S-, -SO₂-, or -NHCO-, or a group composed of a combination of two or more thereof.

8. The photosensitive resin composition according to any one of claims 4 to 7,
wherein R¹¹¹ in Formula (2) is a group represented by Formula (51) or Formula (61), 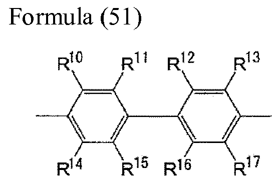 in Formula (51), R¹⁰ to R¹⁷ each independently represent a hydrogen atom, a fluorine atom, or a monovalent organic group, and at least one of R¹⁰ to R¹⁷ represents a fluorine atom, a methyl group, a fluoromethyl group, a difluoromethyl group, or a trifluoromethyl group, 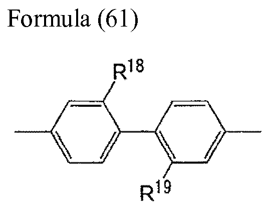 in Formula (61), R¹⁸ and R¹⁹ each independently represent a fluorine atom, a fluoromethyl group, a difluoromethyl group, or a trifluoromethyl group.

9. The photosensitive resin composition according to any one of claims 1 to 8,
wherein the thermal-base generator has an ammonium structure represented by Formula (101) or Formula (102), 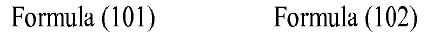 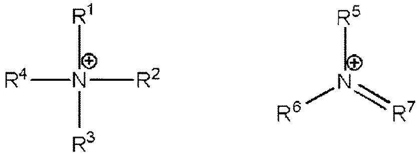 in Formulas (101) and (102), R¹ to R⁶ each independently represent a hydrogen atom or a hydrocarbon group, and R⁷ represents a hydrocarbon group; and R¹ and R², R³ and R⁴, R⁵ and R⁶, or R⁵ and R⁷ in Formulas (101) and (102) may be bonded to each other to form a ring.

10. The photosensitive resin composition according to any one of claims 1 to 9,
wherein the organic compound is selected from a titanocene compound, a tetraalkoxytitanium compound, a titanium acylate compound, a titanium chelate compound, a zirconocene compound, and a hafnocene compound,
preferably the organic compound is selected from a titanocene compound, a zirconocene compound, and a hafnocene compound,
more preferably the organic compound is selected from a titanocene compound, and a zirconocene compound.

11. The photosensitive resin composition according to any one of claims 1 to 10, further comprising at least one compound selected from the group consisting of a radically polymerizable compound and a solvent.

12. Use of the photosensitive resin composition according to any one of claims 1 to 11 for negative tone development.

13. Use of the photosensitive resin composition according to any one of claims 1 to 11 for forming an interlayer insulating film for a re-distribution layer.

14. A cured film obtained by curing the photosensitive resin composition according to any one of claims 1 to 11.

15. A laminate which has two or more layers of the cured film according to claim 14.

16. The laminate according to claim 15, which has a metal layer between the cured films.

17. A method for producing a cured film, comprising:
using the photosensitive resin composition according to any one of claims 1 to 11.

18. The method for producing a cured film according to claim 17, comprising:
applying the photosensitive resin composition to a substrate to form a layered shape,
exposing the photosensitive resin composition layer, and
subjecting the exposed photosensitive resin composition layer to a development treatment.

19. The method for producing a cured film according to claim 18,
wherein the development treatment is a negative tone development treatment.

20. The method for producing a cured film according to claim 18 or 19, further comprising heating the developed photosensitive resin composition layer at a temperature of 50°C to 450°C, preferably 50°C to 250°C, after the development treatment.

21. The method for producing a cured film according to any one of claims 17 to 20,
wherein the cured film has a film thickness of 1 to 30 µm.

22. A method for producing a laminate, comprising:
forming a cured film in accordance with the method for producing a cured film according to any one of claims 18 to 21; and then
further performing the successive steps of applying the photosensitive resin composition to the substrate to form the layered shape, exposing the photosensitive resin composition layer and subjecting the exposed photosensitive resin composition in this order, 2 to 5 times.

23. A semiconductor device, comprising:
the cured film according to claim 14, or the laminate according to claim 15 or 16.

## Patentansprüche

1. Photosensitive Harzzusammensetzung, umfassend:
einen Vorläufer eines Polymers mit einem heterocyclischen Ring;
einen thermischen Basenerzeuger;
eine organische Verbindung, die ein Element der Gruppe 4 enthält; und
eine Oximverbindung als einen photoradikalischen Polymerisationsinitiator.

2. Photosensitive Harzzusammensetzung gemäß Anspruch 1,
wobei die organische Verbindung eine organische Verbindung ist, die mindestens eines enthält, das aus einem Titanatom, einem Zirconiumatom und einem Hafniumatom ausgewählt ist,
wobei die organische Verbindung vorzugsweise eine organische Verbindung ist, die mindestens eines enthält, das aus einem Titanatom und einem Zirconiumatom ausgewählt ist.

3. Photosensitive Harzzusammensetzung gemäß Anspruch 1 oder 2,
wobei der Vorläufer eines Polymers mit einem heterocyclischen Ring ein Polyimidvorläufer oder ein Polybenzoxazolvorläufer ist,
wobei der Vorläufer eines Polymers mit einem heterocyclischen Ring vorzugsweise ein Polyimidvorläufer ist.

4. Photosensitive Harzzusammensetzung gemäß Anspruch 1 oder 2,
wobei der Vorläufer eines Polymers mit einem heterocyclischen Ring eine Wiederholungseinheit der Formel (2) enthält, 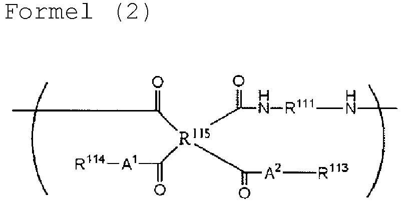 wobei, in der Formel (2), A¹ und A² jeweils unabhängig voneinander für ein Sauerstoffatom oder NH stehen, R¹¹¹ für eine zweiwertige organische Gruppe steht, R¹¹⁵ für eine vierwertige organische Gruppe steht, und R¹¹³ und R¹¹⁴ jeweils unabhängig voneinander für ein Wasserstoffatom oder eine einwertige organische Gruppe stehen.

5. Photosensitive Harzzusammensetzung gemäß Anspruch 4,
wobei mindestens eines von R¹¹³ oder R¹¹⁴ in der Formel (2) eine radikalisch polymerisierbare Gruppe enthält.

6. Photosensitive Harzzusammensetzung gemäß Anspruch 4 oder 5,
wobei R¹¹⁵ in der Formel (2) für eine vierwertige organische Gruppe mit einem aromatischen Ring steht.

7. Photosensitive Harzzusammensetzung gemäß einem der Ansprüche 4 bis 6,
wobei R¹¹¹ in der Formel (2) für -Ar-L-Ar- steht, wobei die Reste Ar jeweils unabhängig voneinander für eine aromatische Gruppe stehen, und L für eine aliphatische Kohlenwasserstoffgruppe mit 1 bis 10 Kohlenstoffatomen, die mit einem Fluoratom, -O-, -CO-, -S-, -SO₂- oder -NHCO-substituiert sein kann, oder eine Gruppe, die aus einer Kombination von zwei oder mehreren davon zusammengesetzt ist, steht.

8. Photosensitive Harzzusammensetzung gemäß einem der Ansprüche 4 bis 7,
wobei R¹¹¹ in der Formel (2) für eine Gruppe der Formel (51) oder der Formel (61) steht, 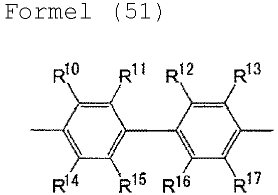 wobei, in der Formel (51), R¹⁰ bis R¹⁷ jeweils unabhängig voneinander für ein Wasserstoffatom, ein Fluoratom oder eine einwertige organische Gruppe stehen, und mindestens eines von R¹⁰ bis R¹⁷ für ein Fluoratom, eine Methylgruppe, eine Fluormethylgruppe, eine Difluormethylgruppe oder eine Trifluormethylgruppe steht, 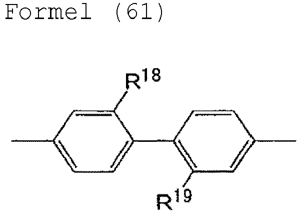 wobei, in der Formel (61), R¹⁸ und R¹⁹ jeweils unabhängig voneinander für ein Fluoratom, eine Fluormethylgruppe, eine Difluormethylgruppe oder eine Trifluormethylgruppe stehen.

9. Photosensitive Harzzusammensetzung gemäß einem der Ansprüche 1 bis 8,
wobei der thermische Basenerzeuger eine Ammoniumstruktur der Formel (101) oder der Formel (102) aufweist, 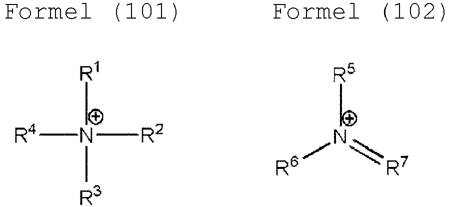 wobei, in den Formeln (101) und (102), R¹ bis R⁶ jeweils unabhängig voneinander für ein Wasserstoffatom oder eine Kohlenwasserstoffgruppe stehen, und R⁷ für eine Kohlenwasserstoffgruppe steht; und R¹ und R², R³ und R⁴, R⁵ und R⁶, oder R⁵ und R⁷ in den Formeln (101) und (102) unter Bildung eines Rings aneinander gebunden sein können.

10. Photosensitive Harzzusammensetzung gemäß einem der Ansprüche 1 bis 9,
wobei die organische Verbindung aus einer Titanocenverbindung, einer Tetraalkoxytitanverbindung, einer Titanacylatverbindung, einer Titanchelatverbindung, einer Zirconocenverbindung und einer Hafnocenverbindung ausgewählt ist,
wobei die organische Verbindung vorzugsweise aus einer Titanocenverbindung, einer Zirconocenverbindung und einer Hafnocenverbindung ausgewählt ist,
wobei die organische Verbindung stärker bevorzugt aus einer Titanocenverbindung und einer Zirconocenverbindung ausgewählt ist.

11. Photosensitive Harzzusammensetzung gemäß einem der Ansprüche 1 bis 10, die ferner mindestens eine Verbindung umfasst, die aus der Gruppe, die aus einer radikalisch polymerisierbaren Verbindung und einem Lösungsmittel besteht, ausgewählt ist.

12. Verwendung der photosensitiven Harzzusammensetzung gemäß einem der Ansprüche 1 bis 11 für die Negativentwicklung.

13. Verwendung der photosensitiven Harzzusammensetzung gemäß einem der Ansprüche 1 bis 11 zur Bildung einer isolierenden Zwischenschichtfolie für eine Umverteilungsschicht.

14. Gehärtete Folie, erhalten durch Härten der photosensitiven Harzzusammensetzung gemäß einem der Ansprüche 1 bis 11.

15. Laminat, das zwei oder mehrere Schichten der gehärteten Folie gemäß Anspruch 14 aufweist.

16. Laminat gemäß Anspruch 15, das eine Metallschicht zwischen den gehärteten Folien aufweist.

17. Verfahren zur Herstellung einer gehärteten Folie, umfassend:
Verwenden der photosensitiven Harzzusammensetzung gemäß einem der Ansprüche 1 bis 11.

18. Verfahren zur Herstellung einer gehärteten Folie gemäß Anspruch 17, umfassend:
Auftragen der photosensitiven Harzzusammensetzung auf ein Substrat, um eine Schichtform zu bilden,
Belichten der photosensitiven Harzzusammensetzungsschicht, und
Aussetzen der belichteten photosensitiven Harzzusammensetzungsschicht einer Entwicklungsbehandlung.

19. Verfahren zur Herstellung einer gehärteten Folie gemäß Anspruch 18,
wobei die Entwicklungsbehandlung eine Negativentwicklungsbehandlung ist.

20. Verfahren zur Herstellung einer gehärteten Folie gemäß Anspruch 18 oder 19, ferner umfassend das Erwärmen der entwickelten photosensitiven Harzzusammensetzungsschicht bei einer Temperatur von 50°C bis 450°C, vorzugsweise 50°C bis 250°C, nach der Entwicklungsbehandlung.

21. Verfahren zur Herstellung einer gehärteten Folie gemäß einem der Ansprüche 17 bis 20,
wobei die gehärtete Folie eine Foliendicke von 1 bis 30 µm aufweist.

22. Verfahren zur Herstellung eines Laminats, umfassend:
Bilden einer gehärteten Folie gemäß dem Verfahren zur Herstellung einer gehärteten Folie gemäß einem der Ansprüche 18 bis 21; und anschließend
weiteres Ausführen der aufeinanderfolgenden Schritte des Auftragens der photosensitiven Harzzusammensetzung auf das Substrat, um die Schichtform zu bilden, des Belichtens der photosensitiven Harzzusammensetzungsschicht und des Aussetzens der belichteten photosensitiven Harzzusammensetzung in dieser Reihenfolge, 2- bis 5-mal.

23. Halbleitervorrichtung, umfassend:
die gehärtete Folie gemäß Anspruch 14 oder das Laminat gemäß Anspruch 15 oder 16.

## Revendications

1. Composition de résine photosensible, comprenant :
un précurseur de polymère contenant un cycle hétérocyclique ;
un générateur de base thermique ;
un composé organique contenant un élément du Groupe 4 ; et
un composé oxime en tant qu'amorceur de photopolymérisation radicalaire.

2. Composition de résine photosensible selon la revendication 1,
dans laquelle le composé organique est un composé organique contenant au moins un sélectionné parmi un atome de titane, un atome de zirconium et un atome d'hafnium,
de préférence le composé organique est un composé organique contenant au moins un sélectionné parmi un atome de titane et un atome de zirconium.

3. Composition de résine photosensible selon la revendication 1 ou 2,
dans laquelle le précurseur de polymère contenant un cycle hétérocyclique est un précurseur de polyimide ou un précurseur de polybenzoxazole,
de préférence le précurseur de polymère contenant un cycle hétérocyclique est un précurseur de polyimide.

4. Composition de résine photosensible selon la revendication 1 ou 2,
dans laquelle le précurseur de polymère contenant un cycle hétérocyclique contient une unité répétitive représentée par la Formule (2), 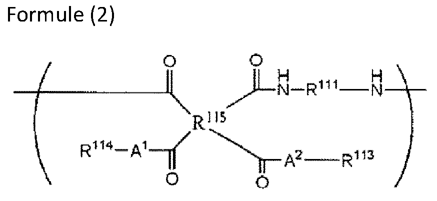 dans la Formule (2), A¹ et A² représentent chacun indépendamment un atome d'oxygène ou NH, R¹¹¹ représente un groupe organique divalent, R¹¹⁵ représente un groupe organique tétravalent, et R¹¹³ et R¹¹⁴ représentent chacun indépendamment un atome d'hydrogène ou un groupe organique monovalent.

5. Composition de résine photosensible selon la revendication 4,
dans laquelle au moins un de R¹¹³ ou R¹¹⁴ dans la Formule (2) contient un groupe radicalement polymérisable.

6. Composition de résine photosensible selon la revendication 4 ou 5,
dans laquelle R¹¹⁵ dans la Formule (2) est un groupe organique tétravalent contenant un cycle aromatique.

7. Composition de résine photosensible selon l'une quelconque des revendications 4 à 6,
dans laquelle R¹¹¹ dans la Formule (2) est représenté par -Ar-L-Ar-, où les Ar représentent chacun indépendamment un groupe aromatique, et L est un groupe hydrocarboné aliphatique présentant de 1 à 10 atomes de carbone qui peuvent être substitués par un atome de fluor, -O-, -CO-, -S-, -SO₂-, ou -NHCO-, ou un groupe composé d'une combinaison de deux ou plus de ceux-ci.

8. Composition de résine photosensible selon l'une quelconque des revendications 4 à 7,
dans laquelle R¹¹¹ dans la Formule (2) est un groupe représenté par la Formule (51) ou la Formule (61), 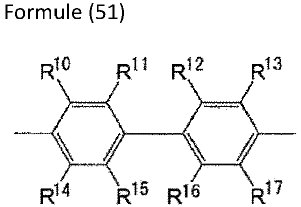 dans la Formule (51), R¹⁰ à R¹⁷ représentent chacun indépendamment un atome d'hydrogène, un atome de fluor, ou un groupe organique monovalent, et au moins un de R¹⁰ à R¹⁷ représente un atome de fluor, un groupe méthyle, un groupe fluorométhyle, un groupe difluorométhyle, ou un groupe trifluorométhyle, 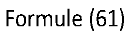 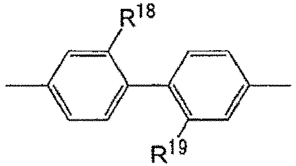 dans la Formule (61), R¹⁸ et R¹⁹ représentent chacun indépendamment un atome de fluor, un groupe fluorométhyle, un groupe difluorométhyle, ou un groupe trifluorométhyle.

9. Composition de résine photosensible selon l'une quelconque des revendications 1 à 8,
dans laquelle le générateur de base thermique présente une structure d'ammonium représentée par la Formule (101) ou la Formule (102), 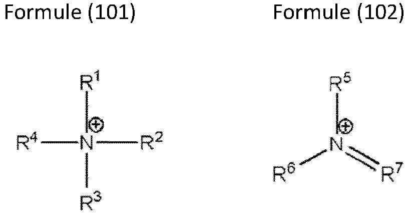 dans les Formules (101) et (102), R¹ à R⁶ représentent chacun indépendamment un atome d'hydrogène ou un groupe hydrocarboné, et R⁷ représente un groupe hydrocarboné ; et R¹ et R², R³ et R⁴, R⁵ et R⁶, ou R⁵ et R⁷ dans les Formules (101) et (102) peuvent être liés l'un à l'autre pour former un cycle.

10. Composition de résine photosensible selon l'une quelconque des revendications 1 à 9,
dans laquelle le composé organique est sélectionné parmi un composé de titanocène, un composé de tétraalcoxytitane, un composé d'acylate de titane, un composé de chélate de titane, un composé de zirconocène, et un composé d'hafnocène,
de préférence le composé organique est sélectionné parmi un composé de titanocène, un composé de zirconocène, et un composé d'hafnocène,
plus préférentiellement le composé organique est sélectionné parmi un composé de titanocène et un composé de zirconocène.

11. Composition de résine photosensible selon l'une quelconque des revendications 1 à 10, comprenant en outre au moins un composé sélectionné à partir du groupe consistant en un composé radicalement polymérisable et un solvant.

12. Utilisation de la composition de résine photosensible selon l'une quelconque des revendications 1 à 11 pour un développement de ton négatif.

13. Utilisation de la composition de résine photosensible selon l'une quelconque des revendications 1 à 11 pour former un film isolant intercouche pour une couche de redistribution.

14. Film durci obtenu en durcissant la composition de résine photosensible selon l'une quelconque des revendications 1 à 11.

15. Stratifié qui présente deux couches ou plus du film durci selon la revendication 14.

16. Stratifié selon la revendication 15, qui présente une couche métallique entre les films durcis.

17. Procédé de production d'un film durci, comprenant l'étape consistant à :
utiliser la composition de résine photosensible selon l'une quelconque des revendications 1 à 11.

18. Procédé de production d'un film durci selon la revendication 17, comprenant les étapes consistant à :
appliquer la composition de résine photosensible sur un substrat pour former une forme en couches,
exposer la couche de composition de résine photosensible, et
soumettre la couche de composition de résine photosensible exposée à un traitement de développement.

19. Procédé de production d'un film durci selon la revendication 18,
dans lequel le traitement de développement est un traitement de développement de ton négatif.

20. Procédé de production d'un film durci selon la revendication 18 ou 19, comprenant en outre l'étape consistant à chauffer la couche de composition de résine photosensible développée à une température de 50 °C à 450 °C, de préférence de 50 °C à 250 °C, après le traitement de développement.

21. Procédé de production d'un film durci selon l'une quelconque des revendications 17 à 20,
dans lequel le film durci présente une épaisseur de film de 1 à 30 µm.

22. Procédé de production d'un stratifié, comprenant les étapes consistant à :
former un film durci conformément au procédé de production d'un film durci selon l'une quelconque des revendications 18 à 21 ; et ensuite
effectuer en outre les étapes successives consistant à appliquer la composition de résine photosensible sur le substrat pour former la forme en couches, exposer la couche de composition de résine photosensible et soumettre la composition de résine photosensible exposée dans cet ordre, de 2 à 5 fois.

23. Dispositif à semiconducteur, comprenant
le film durci selon la revendication 14, ou le stratifié selon la revendication 15 ou 16.
